(19) Europäisches Patentamt
European Patent Office
Office européen des brevets

(11) **EP 3 739 530 B1**

(12) **EUROPEAN PATENT SPECIFICATION**

(45) Date of publication and mention
of the grant of the patent:
**23.04.2025 Bulletin 2025/17**

(21) Application number: **18905663.3**

(22) Date of filing: **29.09.2018**

(51) International Patent Classification (IPC):
**G06Q 10/08** (2024.01)     **G06Q 10/04** (2023.01)
**G06Q 10/047** (2023.01)

(52) Cooperative Patent Classification (CPC):
**G06Q 10/047; G06Q 10/04; G06Q 10/08**

(86) International application number:
**PCT/CN2018/108534**

(87) International publication number:
**WO 2019/153759 (15.08.2019 Gazette 2019/33)**

(54) **METHOD FOR DETERMINING TRANSPORTATION SCHEME, AND METHOD AND DEVICE FOR TRAINING FAST LOADING MODEL**

VERFAHREN ZUR BESTIMMUNG EINES TRANSPORTSCHEMAS SOWIE VERFAHREN UND
VORRICHTUNG ZUM TRAINIEREN EINES SCHNELLLADEMODELLS

PROCÉDÉ DE DÉTERMINATION D'UN SCHÉMA DE TRANSPORT, ET PROCÉDÉ ET DISPOSITIF
D'APPRENTISSAGE D'UN MODÈLE DE CHARGEMENT RAPIDE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.02.2018  CN 201810118531**

(43) Date of publication of application:
**18.11.2020  Bulletin 2020/47**

(73) Proprietor: **HUAWEI TECHNOLOGIES CO., LTD.
Shenzhen, Guangdong 518129 (CN)**

(72) Inventors:
• **CHEN, Haoyang**
 **Shenzhen, Guangdong 518129 (CN)**
• **LEE, Kai Yan**
 **Shenzhen, Guangdong 518129 (CN)**
• **YUAN, Mingxuan**
 **Shenzhen, Guangdong 518129 (CN)**
• **ZENG, Jia**
 **Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(56) References cited:
**CN-A- 103 473 617     CN-A- 104 866 911
KR-A- 20160 119 633     US-A1- 2014 180 954**

## Description

### TECHNICAL FIELD

This application relates to the logistics field, and in particular, to a method for determining a transportation scheme, a method for training a fast loading model, and a device.

### BACKGROUND

With development of economy, transportation industries are seeking increasingly high efficiency and accuracy, and containers are especially primary vessels for transportation. As a quantity of pick-up points and an amount of goods that need to be transported increase, a transportation route needs to be planned to improve transportation efficiency.

In an existing solution, a route scheme is obtained by using an ant colony optimization algorithm, and then a goods loading scheme for the route scheme, namely, a loading manner of goods in a container, is obtained through three-dimensional loading simulation. However, in the three-dimensional loading simulation, goods cannot be processed in parallel, a large quantity of operations are required, and a large amount of time is consumed. Particularly, when a goods volume is comparatively large, a larger amount of time is consumed. Consequently, efficiency of obtaining a goods loading scheme and outputting an actual loading rate is reduced, and efficiency of obtaining a target transportation scheme is affected.

US 2014/180954 A1 discloses a method, a system, and a computer program product for shipping route selection and transportation planning systems. The computer-implemented method commences upon receiving a set of candidate transportation carrier descriptions, individual ones of the set of candidate transportation carrier descriptions having one or more shipping mode options and having one or more shipping unit options. Then, the method evaluates combinations of using multiple transportation carriers that provide any of the one or more shipping mode options with compatible shipping unit options to determine a combination cost for each of the combinations. Based on the combination costs, the method selects an equipment option that corresponds to the lowest combination cost. Low-cost itineraries can be formed by calculating the cost of a particular itinerary by summing combination costs of constituent legs.

### SUMMARY

Embodiments of this application provide a computer-implemented method for determining a transportation scheme and a transportation scheme determining apparatus that are used for goods transportation, to fast obtain a target transportation scheme, reduce transportation costs, and improve transportation efficiency especially when a transportation volume is large and a situation is complex.

In view of this, a first aspect of this application provides a computer-implemented method for determining a transportation scheme, and the method may include:

first obtaining at least one route scheme and a first goods allocation scheme set corresponding to each of the at least one route scheme, where each of the at least one route scheme is a transportation route planned for transporting to-be-transported goods, one route scheme may include at least one transportation route, the first goods allocation scheme set corresponding to each of the at least one route scheme includes at least one goods allocation scheme, and each goods allocation scheme in the first goods allocation scheme set corresponding to each of the at least one route scheme is a scheme for allocating the to-be-transported goods for the corresponding route scheme; determining, by using a fast loading model, an actual loading rate of each goods allocation scheme in the first goods allocation scheme set corresponding to each of the at least one route scheme, where the fast loading model is obtained by training offline simulation data offline, the offline simulation data includes a historical loading scheme calculated by using a three-dimensional loading algorithm, and the actual loading rate is a proportion of goods loaded into a container in the container in a goods allocation scheme; and integrating and evaluating, based on the actual loading rate, each of the at least one route scheme and each goods allocation scheme in the first goods allocation scheme set corresponding to each of the at least one route scheme, to determine a target transportation scheme, where the target transportation scheme includes a target route scheme and a target goods allocation scheme corresponding to the target route scheme, wherein the obtaining at least one route scheme and a first goods allocation scheme set corresponding to each of the at least one route scheme includes: obtaining a target freight bill, wherein the target freight bill includes transportation node information and to-be-transported goods information, the transportation node information includes a freight starting point, a freight ending point, and M pickup points, and the to-be-transported goods information includes information about to-be-transported goods distributed at the M pickup points, wherein M is a positive integer; determining the at least one route scheme based on the transportation node information, wherein each of the at least one route scheme includes at least one transportation route, each of the at least one transportation route includes a freight starting point, a freight ending point, and N of the M pickup points, and each of the at least one route scheme covers the M pickup points, wherein N is a positive integer and

$N \leq M$; and allocating the to-be-transported goods for each transportation route in each of the at least one route scheme, to obtain each goods allocation scheme in the first goods allocation scheme set corresponding to each of the at least one route scheme, wherein the determining the at least one route scheme based on the transportation node information includes: if an amount of historical route data is greater than a first threshold, initializing transfer hyperparameters of the M pickup points based on the historical route data, to obtain a hyperparameter matrix; determining a transfer probability distribution of the M pickup points based on the hyperparameter matrix, wherein the transfer probability distribution includes a transfer probability of a container in a transportation route between the freight starting point and the M pickup points, between the freight ending point and the M pickup points, or between the M pickup points; and determining each transportation route in each of the at least one route scheme based on the transfer probability distribution, to obtain the at least one route scheme.

In this embodiment of this application, after the at least one route scheme and the first goods allocation scheme set corresponding to each of the at least one route scheme are determined, the actual loading rate of each goods allocation scheme in the first goods allocation scheme set corresponding to each route scheme can be determined by using the fast loading model that is obtained by training the offline simulation data offline, actual loading rates of all goods allocation schemes corresponding to each route scheme can be fast obtained, duration of obtaining the actual loading rates of all the goods allocation schemes corresponding to each route scheme can be reduced, and efficiency of determining the target transportation scheme is improved. The fast loading model is obtained by performing offline simulation training on the offline simulation data, the offline simulation data includes data obtained through a three-dimensional loading operation, and accuracy of the obtained actual loading rate can be improved.

After the target freight bill is obtained, route planning and goods allocation are performed based on information provided in the target freight bill. When the route scheme is determined, the route planning can be directly performed based on the transportation node, to reduce duration for route searching, and improve efficiency of the route planning. After the route planning is performed, goods allocation is then performed based on the planned route scheme, to obtain a goods allocation set for each route scheme. Subsequently, each route scheme and each goods allocation scheme in the goods allocation scheme set corresponding to the route scheme are integrated and evaluated, to obtain the target transportation scheme, so that overall efficiency of obtaining the target transportation scheme can be improved.

The route planning may be performed by using historical route data, and the route planning specifically includes: initializing the transfer hyperparameters of the M pickup points by using the historical route data, and then determining the transfer probability distribution of the pickup points based on the transfer hyperparameters. The probability distribution is a transfer probability of a container in each transportation route in the route scheme between a pickup point and a port. It should be understood that, a larger quantity of times that a jump occurs in the historical route data indicates a higher probability corresponding to the jump. Each transportation route in each of the at least one route scheme can be determined based on the obtained transfer probability distribution of the pickup point, efficiency of obtaining the at least one route scheme can be further improved, and the transfer hyperparameters of the pickup points are calculated by using the historical route data, so that the obtained route scheme can be more accurate.

With reference to the first aspect of this application, in a first implementation of the first aspect of this application, the method may further include:

if the amount of historical route data is not greater than the first threshold, initializing the transfer hyperparameters of the M pickup points by using a heuristic algorithm, to obtain the hyperparameter matrix.

When the amount of the historical route data is insufficient, the transfer hyperparameters of the pickup points may not be initialized by using the historical route data, and a heuristic algorithm may be selected to initialize the transfer hyperparameters of the pickup points, thereby adding a manner of determining the hyperparameters of the pickup points.

With reference to the first implementation of the first aspect of this application, in a second implementation of the first aspect of this application, the allocating the to-be-transported goods for each transportation route in each of the at least one route scheme, to obtain each goods allocation scheme in the first goods allocation scheme set corresponding to each of the at least one route scheme may include:

clustering goods that is obtained from the target freight bill and that is at each of the M pickup points based on a clustering condition, to obtain a clustering result, where the clustering condition may include a length, a width, a height, and a weight of the goods, and in addition, the clustering condition may further include a material, a pressure coefficient, a minimum area, or the like; and performing sampling calculation on the clustering result by using a first goods allocation hyperparameter of each of the M pickup points, to obtain a first goods allocation manner set of each of the M pickup points, where the first goods allocation hyperparameter of each of the M pickup points is a hyperparameter for allocating the goods at each of the M pickup points, and each goods allocation manner in the first goods allocation manner set of each of the M pickup points is a manner of allocating goods distributed at a pickup point for a corresponding route scheme, where the first goods allocation hyperparameter may be an even distribution hyperparameter, or may be obtained by updating a previous goods allocation scheme during repeated goods allocation; and separately selecting a goods allocation manner from the first goods allocation manner set of each of the M pickup points, and combining the goods allocation manner with a route scheme, to obtain each goods allocation scheme in the first goods allocation scheme set corresponding to each of the at least one route scheme.

In this implementation of this application, when goods at a pickup point is allocated, clustering may be performed with reference to features of the goods distributed at the pickup point, namely, features including a length, a width, a height, or a weight. Precise clustering may be used, or fuzzy clustering may be used, and adjustment may be made specifically based on an actual requirement, so that the goods at the pickup points can be fast classified, and the goods is fast allocated to obtain each goods allocation scheme in the goods allocation scheme set corresponding to each of the at least one route scheme.

With reference to any one of the previous implementations of the first aspect of this application, in a third implementation of the first aspect of this application, the determining, by using a fast loading model, an actual loading rate of each goods allocation scheme in the first goods allocation set corresponding to each of the at least one route scheme may include:

obtaining a first feature vector of each goods allocation scheme in the first goods allocation scheme set corresponding to each of the at least one route scheme, where the first feature vector is used to indicate a feature value of to-be-transported goods in a goods allocation scheme, for example, a vector formed by a length, a width, a height, a weight, or the like of the goods in each goods allocation scheme; and inputting the first feature vector of each goods allocation scheme in the first goods allocation scheme corresponding to each of the at least one route scheme into the fast loading model, to obtain the actual loading rate of each goods allocation scheme in the first goods allocation scheme set corresponding to each of the at least one route scheme, where the actual loading rate includes a volume actual loading rate and a weight actual loading rate, the volume actual loading rate includes a proportion of a volume of goods allocated in each transportation route in a load volume of a container in each of the at least one route scheme, and the weight actual loading rate includes a proportion of a weight of goods allocated in each transportation route in a load weight of a container in each of the at least one route scheme.

In this implementation of this application, the first feature vector of each goods allocation scheme in the first goods allocation scheme set corresponding to each of the obtained at least one route scheme is obtained, the first feature vector is a feature value that indicates a goods allocation scheme in the first goods allocation scheme set corresponding to each of the at least one route scheme, the first feature vector of each goods allocation scheme in the first goods allocation scheme set corresponding to each of the at least one route scheme is input to the fast loading model, the actual loading rate of each goods allocation scheme in the first goods allocation scheme set corresponding to each of the at least one route scheme may be obtained, and the actual loading rate may include the volume actual loading rate and the weight actual loading rate. Therefore, the first feature vector of each goods allocation scheme may be input to the fast loading model, and the actual loading rate of each goods allocation scheme in the first goods allocation scheme set corresponding to each of the at least one route scheme can be fast obtained, thereby improving efficiency of obtaining the actual loading rate of each goods allocation scheme.

With reference to any one of the previous implementations of the first aspect of this application, in a fourth implementation of the first aspect of this application, the obtaining a first feature vector of each goods allocation scheme in the first goods allocation scheme set corresponding to each of the at least one route scheme may include:

obtaining a second feature vector of each piece of the to-be-transported goods, where the second feature vector of each piece of the to-be-transported goods includes a length, a width, a height, and a weight of the corresponding goods; calculating, based on the second feature vector of each piece of the to-be-transported goods, a third feature vector of goods distributed at each of the M pickup points, for each goods allocation scheme in the first goods allocation scheme corresponding to each of the at least one route scheme, where the third feature vector of each goods allocation scheme in the first goods allocation scheme corresponding to each of the at least one route scheme includes an average value and a covariance of second feature vectors of all pieces of the to-be-transported goods; and performing weighted combination on the third feature vector of each goods allocation scheme in the first goods allocation scheme corresponding to each of the at least one route scheme, to obtain the corresponding first feature vector in each goods allocation scheme in the first goods allocation scheme set corresponding to each of the at least one route scheme.

In this implementation of this application, a specific step of obtaining the first feature vector of each goods allocation scheme in the first goods allocation scheme set corresponding to each of the at least one route scheme may be: first obtaining the second feature vector of each piece of the to-be-transported goods; calculating, based on the second feature vector of each piece of goods, the third feature vector of each goods allocation scheme in the first goods allocation scheme corresponding to each of the at least one route scheme at the M pickup points; performing weighting calculation on the third feature vector; and finally obtaining the first feature vector of each goods allocation scheme in the first goods allocation scheme set corresponding to each of the at least one route scheme.

With reference to any one of the previous implementations of the first aspect of this application, in a fifth implementation of the first aspect of this application, the integrating and evaluating, based on the actual loading rate, each of the at least one route scheme and each goods allocation scheme in the first goods allocation scheme set corresponding to each of the at least one route scheme, to determine a target transportation scheme may include:
calculating scores of all obtained goods allocation schemes by using a preset evaluation function and the actual loading rate; if all the goods allocation schemes include one or more goods allocation schemes scored higher than a second threshold, determining the target goods allocation scheme in the one or more goods allocation schemes scored higher than the second threshold, and using a route scheme corresponding to the target goods allocation scheme as the target route scheme; and determining the target transportation scheme based on the target goods allocation scheme and the target route scheme.

In this implementation of this application, the preset evaluation function and the actual loading rate may be used to calculate the scores of all the obtained goods allocation schemes to obtain a score of each goods allocation scheme. In all the goods allocation schemes, if there is no goods allocation scheme scored higher than the second threshold, the target goods allocation scheme is determined in goods allocation schemes scored not lower than the second threshold. If there is one goods allocation scheme scored higher than the second threshold, the goods allocation scheme is determined as the target goods allocation scheme. If there are two goods allocation schemes scored higher than the second threshold, one of the at least two goods allocation schemes scored higher than the second threshold may be randomly determined as the target goods allocation scheme or a goods allocation scheme scored the highest may be determined as the target goods allocation scheme, and a route scheme corresponding to the target goods allocation scheme is determined as the target route scheme, to obtain the target transportation scheme. In this implementation of this application, each goods allocation scheme is scored to determine the target goods allocation scheme, and an optimal target transportation scheme can be obtained.

With reference to any one of the previous implementations of the first aspect of this application, in a sixth implementation of the first aspect of this application, the evaluation function includes:

$$f(\vec{R}, \vec{r_V}, \vec{r_W}) = \sum_{i=1}^{m} \alpha \, | \, r_{Vi} - \overline{r_V} - r_{Wi} + \overline{r_W} \, | - \beta(r_{Vi} + r_{Wi}) + \gamma Cost(R_i)$$,

where $\vec{R}$ is a route scheme vector, $m$ is a quantity of containers, $\vec{r_V}$ is a volume actual loading rate vector of the $m$ containers, $\vec{r_W}$ is a weight actual loading rate vector of the $m$ containers; $\alpha$, $\beta$, and $\gamma$ are weight parameters, $r_{Vi}$ is a volume actual loading rate of an $i$th container, $r_{Wi}$ is a weight actual loading rate of an $i$th container, $\overline{r_V}$ is an average volume actual loading rate of the $m$ containers, and $\overline{r_W}$ is an average weight actual loading rate of the $m$ containers.

In this implementation of this application, an evaluation function for evaluating a goods allocation scheme and a route scheme is added, so that an optimal target transportation scheme can be obtained by using the evaluation function.

With reference to any one of the previous implementations of the first aspect of this application, in a seventh implementation of the first aspect of this application, the method further includes:

if all the goods allocation schemes do not include the goods allocation scheme scored higher than the second threshold, performing sampling calculation on the clustering result by using a second goods allocation hyperparameter of each of the M pickup points, to obtain a second goods allocation manner set of each of the M pickup points, where each goods allocation manner in the second goods allocation manner set of each of the M pickup points is a manner of allocating goods distributed at a pickup point for a corresponding route scheme, and the second goods allocation hyperparameter of each of the M pickup points is obtained by updating the first goods allocation hyperparameter of each of the M pickup points based on each goods allocation scheme in the first goods allocation scheme set corresponding to each of the at least one route scheme; separately selecting a goods allocation manner from the second goods allocation manner set of each of the M pickup points, and combining the goods allocation manners, to obtain each goods allocation scheme in the second goods allocation scheme set corresponding to each of the at least one route scheme, where each goods allocation scheme in the second goods allocation scheme set corresponding to each of the at least one route scheme is a scheme of allocating the to-be-transported goods for a corresponding route scheme; and calculating a score of each goods allocation scheme in the second goods allocation scheme set for each of the at least one route scheme by using the evaluation function and the actual loading rate of each goods allocation scheme in the second goods allocation scheme set for each of the at least one route scheme, where the actual loading rate of each goods allocation scheme in the second goods allocation scheme set for each of the at least one route scheme is obtained by using the fast loading model.

In this implementation of this application, if all the allocation schemes do not include a goods allocation scheme scored higher than the second threshold, the first goods allocation hyperparameter of each pickup point may be updated by using each goods allocation scheme in the first goods allocation scheme set, to obtain the second goods allocation hyperparameter of each pickup point; and then the goods at each pickup point is reallocated based on the second goods allocation hyperparameter, to obtain each goods allocation scheme in the second goods allocation scheme set for each route scheme, and subsequently, each goods allocation scheme in the second goods allocation scheme set is continued to be further integrated and evaluated, until a stopping condition is met. For example, the goods allocation scheme scored higher than the second threshold is obtained, or a quantity of times of iteration reaches a preset quantity. Therefore, in this implementation of this application, repeated allocation and integration and evaluation are performed by using a goods allocation scheme, so that a better target goods allocation scheme and target route scheme can be obtained.

It should be understood that when repeated allocation is performed by using the goods allocation scheme, a route scheme may further be re-planned, or goods may be directly reallocated by using the at least one route scheme.

With reference to any one of the previous implementations of the first aspect of this application, in an eighth implementation of the first aspect of this application, after the integrating and evaluating, based on the actual loading rate, each of the at least one route scheme and a goods allocation scheme in each of the at least one route scheme, to determine a target transportation scheme, the method further includes:

determining a type of a container in each transportation route in the target route scheme based on the target goods allocation scheme and the target route scheme; and generating a loading scheme based on the type of the container in each transportation route in the target route scheme and the three-dimensional loading algorithm, where the loading scheme is a loading manner of the to-be-transported goods in the container in each transportation route in the target route scheme.

In this implementation of this application, after the target transportation scheme is determined, the type of the container may further be determined, adjustment may be made based on the actual loading rate, and the type of the container more matching the actual loading rate is determined, to reduce transportation costs. In addition, after the type of the container is determined, a loading scheme may further be generated by using the three-dimensional loading algorithm, and the loading manner of the goods in the container is determined, so that efficiency of loading the goods can be improved.

With reference to any one of the previous implementations of the first aspect of this application, in a ninth implementation of the first aspect of this application, before the integrating and evaluating, based on the actual loading rate, each of the at least one route scheme and each goods allocation scheme in the first goods allocation scheme set corresponding to each of the at least one route scheme, to determine a target transportation scheme, the method may further include:

if determining, based on the actual loading rate, that L of the M pickup points further include remaining goods not allocated to the container, determining a remaining goods route scheme and a remaining goods allocation scheme for the remaining goods, where L≤M, and L is a positive integer; and
the integrating and evaluating, based on the actual loading rate, each of the at least one route scheme and each goods allocation scheme in the first goods allocation scheme set corresponding to each of the at least one route scheme, to determine a target transportation scheme may include:
integrating and evaluating, based on the actual loading rate, each goods allocation scheme in the first goods allocation scheme set corresponding to each of the at least one route scheme, and the remaining goods route scheme and the remaining goods allocation scheme, to determine the target transportation scheme.

In this implementation of this application, it may be calculated, based on the actual loading rate, whether the to-be-transported goods further includes the remaining goods not allocated to the container, and if there is goods that cannot be loaded into the container, route planning and goods allocation may be performed on the remaining goods, to obtain the route scheme and the goods allocation scheme of the remaining goods; and the route scheme and the goods allocation scheme of the remaining goods, and the target route scheme and the target goods allocation scheme are used as the target transportation scheme, to obtain a complete transportation scheme of the to-be-transported goods.

A second aspect of this application provides a transportation scheme determining apparatus, including:

an obtaining module, configured to obtain at least one route scheme and a first goods allocation scheme set corresponding to each of the at least one route scheme, where each of the at least one route scheme is a transportation route planned for transporting to-be-transported goods, the first goods allocation scheme set corresponding to each of the at least one route scheme includes at least one goods allocation scheme, and each goods allocation scheme in the first goods allocation scheme set corresponding to each of the at least one route scheme is a scheme for allocating the to-be-transported goods for the corresponding route scheme;
a fast loading module, configured to determine, by using a fast loading model, an actual loading rate of each goods allocation scheme in the first goods allocation scheme set corresponding to each of the at least one route scheme, where the fast loading model is obtained by training offline simulation data offline, the offline simulation data includes a historical loading scheme calculated by using a three-dimensional loading algorithm, and the actual loading rate is a proportion of goods loaded into a container in the container in a goods allocation scheme; and
an evaluation module, configured to integrate and evaluate, based on the actual loading rate, each of the at least one route scheme and each goods allocation scheme in the first goods allocation scheme set corresponding to each of the at least one route scheme, to determine a target transportation scheme, where the target transportation scheme includes a target route scheme and a target goods allocation scheme corresponding to the target route scheme, wherein the obtaining module includes: an obtaining submodule, configured to obtain a target freight bill, wherein the target freight bill includes transportation node information and to-be-transported goods information, the transportation node information includes a freight starting point, a freight ending point, and M pickup points, and the to-be-transported goods information includes information about to-be-transported goods distributed at the M pickup points, wherein M is a positive integer; a route planning submodule, configured to determine the at least one route scheme based on the transportation node information, wherein each of the at least one route scheme includes at least one transportation route, each of the at least one transportation route includes a freight starting point, a freight ending point, and N of the M pickup points, and each of the at least one route scheme covers the M pickup points, wherein N is a positive integer and $N \leq M$; and a goods allocation submodule, configured to allocate the to-be-transported goods for each transportation route in each of the at least one route scheme, to obtain each goods allocation scheme in the first goods allocation scheme set corresponding to each of the at least one route scheme, wherein the route planning submodule is specifically configured to: if an amount of historical route data is greater than a first threshold, initialize transfer hyperparameters of the M pickup points based on the historical route data, to obtain a hyperparameter matrix; determine a transfer probability distribution of the M pickup points based on the hyperparameter matrix, wherein the transfer probability distribution includes a transfer probability of a container in a transportation route between the freight starting point and the M pickup points, between the freight ending point and the M pickup points, or between the M pickup points; and determine each transportation route in each of the at least one route scheme based on the transfer probability distribution, to obtain the at least one route scheme.

With reference to the second aspect of this application, in a first implementation of the second aspect of this application, the determining apparatus further includes:

an initialization module, configured to: if the amount of historical route data is not greater than the first threshold, initialize the transfer hyperparameters of the M pickup points by using a heuristic algorithm, to obtain the hyperparameter matrix.

With reference to the first implementation of the second aspect of this application, in a second implementation of the second aspect of this application, the goods allocation submodule is specifically configured to:

cluster goods at each of the M pickup points based on a clustering condition, to obtain a clustering result, where the clustering condition includes a length, a width, a height, and a weight of the goods;

perform sampling calculation on the clustering result by using a first goods allocation hyperparameter of each of the M pickup points, to obtain a first goods allocation manner set of each of the M pickup points, where the first goods allocation hyperparameter of each of the M pickup points is a hyperparameter for allocating the goods at each of the M pickup points, and each goods allocation manner in the first goods allocation manner set of each of the M pickup points is a manner of allocating goods distributed at a pickup point for a corresponding route scheme; and

separately select a goods allocation manner from the first goods allocation manner set of each of the M pickup points, and combine the goods allocation manner with a route scheme, to obtain each goods allocation scheme in the first goods allocation scheme set corresponding to each of the at least one route scheme.

With reference to any one of the previous implementations of the second aspect of this application, in a third implementation of the second aspect of this application, the fast loading module is specifically configured to:

obtain a first feature vector of each goods allocation scheme in the first goods allocation scheme set corresponding to each of the at least one route scheme, where the first feature vector is used to indicate a feature value of to-be-transported goods in a goods allocation scheme; and

input the first feature vector of each goods allocation scheme in the first goods allocation scheme corresponding to each of the at least one route scheme into the fast loading model, to obtain the actual loading rate of each goods allocation scheme in the first goods allocation scheme set corresponding to each of the at least one route scheme, where the actual loading rate includes a volume actual loading rate and a weight actual loading rate, the volume actual loading rate includes a proportion of a volume of goods allocated in each transportation route in a load volume of a container in each of the at least one route scheme, and the weight actual loading rate includes a proportion of a weight of goods allocated in each transportation route in a load weight of a container in each of the at least one route scheme.

With reference to any one of the previous implementations of the second aspect of this application, in a fourth implementation of the second aspect of this application, the fast loading module is specifically configured to:

obtain a second feature vector of each piece of the to-be-transported goods, where the second feature vector of each piece of the to-be-transported goods includes a length, a width, a height, and a weight of the corresponding goods;

calculate, based on the second feature vector of each piece of the to-be-transported goods, a third feature vector of goods distributed at each of the M pickup points, for each goods allocation scheme in the first goods allocation scheme corresponding to each of the at least one route scheme, where the third feature vector of each goods allocation scheme in the first goods allocation scheme corresponding to each of the at least one route scheme includes an average value and a covariance of second feature vectors of all pieces of the to-be-transported goods; and perform weighted combination on the third feature vector of each goods allocation scheme in the first goods allocation scheme corresponding to each of the at least one route scheme, to obtain the corresponding first feature vector in each goods allocation scheme in the first goods allocation scheme set corresponding to each of the at least one route scheme.

With reference to any one of the previous implementations of the second aspect of this application, in a fifth implementation of the second aspect of this application, the evaluation module is specifically configured to:

calculate scores of all obtained goods allocation schemes by using a preset evaluation function and the actual loading rate;
if all the goods allocation schemes include one or more goods allocation schemes scored higher than a second threshold, determine the target goods allocation scheme in the one or more goods allocation schemes scored higher than the second threshold, and use a route scheme corresponding to the target goods allocation scheme as the target route scheme; and
determine the target transportation scheme based on the target goods allocation scheme and the target route scheme.

With reference to any one of the previous implementations of the second aspect of this application, in a sixth implementation of the second aspect of this application, the evaluation function includes:

$$f(\vec{R}, \vec{r_V}, \vec{r_W}) = \sum_{i=1}^{m} \alpha \, | \, r_{Vi} - \overline{r_V} - r_{Wi} + \overline{r_W} \, | - \beta(r_{Vi} + r_{Wi}) + \gamma Cost(R_i)$$

, where $\vec{R}$ is a route scheme vector, $m$ is a quantity of containers, $\vec{r_V}$ is a volume actual loading rate vector of the $m$ containers, $\vec{r_W}$ is a weight actual loading rate vector of the $m$ containers; $\alpha, \beta$, and $\gamma$ are weight parameters, $r_{Vi}$ is a volume actual loading rate of an $i$th container, $r_{Wi}$ is a weight actual loading rate of an $i$th container, $\overline{r_V}$ is an average volume actual loading rate of the $m$ containers, and $\overline{r_W}$ is an average weight actual loading rate of the $m$ containers.

With reference to any one of the previous implementations of the second aspect of this application, in a seventh implementation of the second aspect of this application, the evaluation module is further configured to:

if all the goods allocation schemes do not include the goods allocation scheme scored higher than the second threshold, perform sampling calculation on the clustering result by using a second goods allocation hyperparameter of each of the M pickup points, to obtain a second goods allocation manner set of each of the M pickup points, where each goods allocation manner in the second goods allocation manner set of each of the M pickup points is a manner of allocating goods distributed at a pickup point for a corresponding route scheme, and the second goods allocation hyperparameter of each of the M pickup points is obtained by updating the first goods allocation hyperparameter of each of the M pickup points based on each goods allocation scheme in the first goods allocation scheme set corresponding to each of the at least one route scheme;
separately select a goods allocation manner from the second goods allocation manner set of each of the M pickup points, and combine the goods allocation manners, to obtain each goods allocation scheme in the second goods allocation scheme set corresponding to each of the at least one route scheme, where each goods allocation scheme in the second goods allocation scheme set corresponding to each of the at least one route scheme is a scheme of allocating the to-be-transported goods for a corresponding route scheme; and
calculate a score of each goods allocation scheme in the second goods allocation scheme set for each of the at least one route scheme by using the evaluation function and the actual loading rate of each goods allocation scheme in the second goods allocation scheme set for each of the at least one route scheme, where the actual loading rate of each goods allocation scheme in the second goods allocation scheme set for each of the at least one route scheme is obtained by using the fast loading model.

With reference to any one of the previous implementations of the second aspect of this application, in the eighth implementation of the second aspect of this application, the determining apparatus further includes:

a post-processing module, configured to: after each of the at least one route scheme and the goods allocation scheme for each of the at least one route scheme are integrated and evaluated based on the actual loading rate to determine the target transportation scheme, determine a type of a container in each transportation route in the target route scheme based on the target goods allocation scheme and the target route scheme; and
a three-dimensional loading module, configured to generate a loading scheme based on the type that is of the container in each transportation route in the target route scheme and that is determined by the post-processing module, and the three-dimensional loading algorithm, where the loading scheme is a loading manner of the to-be-transported goods in the container in each transportation route in the target route scheme.

With reference to any one of the previous implementations of the second aspect of this application, in the ninth implementation of the second aspect of this application, the determining apparatus may further include:

a determining module, configured to: before each of the at least one route scheme and each goods allocation scheme in the first goods allocation scheme set corresponding to each of the at least one route scheme are integrated and evaluated based on the actual loading rate to determine the target transportation scheme, if determining, based on the actual loading rate, that L of the M pickup points further include remaining goods not allocated to the container, determine a remaining goods route scheme and a remaining goods allocation scheme for the remaining goods, where L≤M, and L is a positive integer, where
the evaluation module is further configured to integrate and evaluate, based on the actual loading rate, each goods allocation scheme in the first goods allocation scheme set corresponding to each of the at least one route scheme, and the remaining goods route scheme and the remaining goods allocation scheme, to determine the target transportation scheme.

It can be learned from the foregoing technical solutions that the embodiments of this application have the following advantages:

When the target transportation scheme is determined, the actual loading rate of the goods allocation scheme corresponding to each route scheme can be obtained by using the fast loading model, and then, the target transportation scheme is determined based on the actual loading rate. The fast loading model is obtained by training the offline simulation data offline, the offline simulation data is a historical loading scheme obtained through three-dimensional calculation, the actual loading rate of the goods allocation scheme can be fast obtained by using the fast loading model, a loading manner can be obtained without a need of performing the three-dimensional operation, and the actual loading rate can be directly calculated, so that the actual loading rate of the goods allocation scheme can be fast obtained, and duration required for obtaining the actual loading rate can be reduced, thereby improving efficiency of obtaining the target transportation scheme.

## BRIEF DESCRIPTION OF DRAWINGS

FIG. 1 is a schematic diagram of an application scenario of a method for determining a transportation scheme according to an embodiment of this application;
FIG. 2 is a schematic diagram of an embodiment of a method for determining a transportation scheme according to an embodiment of this application;
FIG. 3 is a schematic diagram of another embodiment of a method for determining a transportation scheme according to an embodiment of this application;
FIG. 4 is a schematic diagram of another embodiment of a method for determining a transportation scheme according to an embodiment of this application;
FIG. 5 is a schematic diagram of another embodiment of a method for determining a transportation scheme according to an embodiment of this application;
FIG. 6 is a schematic diagram of another embodiment of a method for determining a transportation scheme according to an embodiment of this application;
FIG. 7 is a schematic diagram of another embodiment of a method for determining a transportation scheme according to an embodiment of this application;
FIG. 8 is a schematic diagram of another embodiment of a method for determining a transportation scheme according to an embodiment of this application;
FIG. 9 is a schematic diagram of another embodiment of a method for determining a transportation scheme according to an embodiment of this application;
FIG. 10 is a schematic diagram of another embodiment of a method for determining a transportation scheme according to an embodiment of this application;
FIG. 11 is a schematic diagram of another embodiment of a method for determining a transportation scheme according to an embodiment of this application;
FIG. 12 is a schematic diagram of another embodiment of a method for determining a transportation scheme according to an embodiment of this application;
FIG. 13 is a schematic diagram of another embodiment of a method for determining a transportation scheme according to an embodiment of this application;

FIG. 14 is a schematic diagram of an embodiment of training a predictive model according to an embodiment of this application;

FIG. 15 is a schematic diagram of another embodiment of a method for determining a transportation scheme according to an embodiment of this application;

FIG. 16 is a schematic diagram of an embodiment of three-dimensional loading simulation according to an embodiment of this application;

FIG. 17 is a schematic diagram of an embodiment of a determining apparatus according to an embodiment of this application;

FIG. 18 is a schematic diagram of an embodiment of a training apparatus according to an embodiment of this application;

FIG. 19 is a schematic diagram of another embodiment of a determining apparatus according to an embodiment of this application; and

FIG. 20 is a schematic diagram of another embodiment of a training apparatus according to an embodiment of this application.

## DESCRIPTION OF EMBODIMENTS

Embodiments of this application provide a method for determining a transportation scheme, a method for training a fast loading model, and a device that are used for goods transportation, to fast obtain a target transportation scheme, reduce transportation costs, and improve transportation efficiency especially when a transportation volume is large and a situation is complex.

With development of logistics industry, goods transportation is widely used in industry and life, and container loading simulation is a core problem in the logistics field. In this case, high efficiency and accuracy need to be achieved for the container loading simulation. High efficiency means that a quick response can be made, and a loading result can be output in a short time by using input data. Therefore, a logistics resource can be preferentially preempted, a delivery time can be shortened, and timely transportation and delivery of goods can be ensured. Accuracy means that an output loading result is valid, so that utilization of a container can be improved, and transportation costs can be reduced.

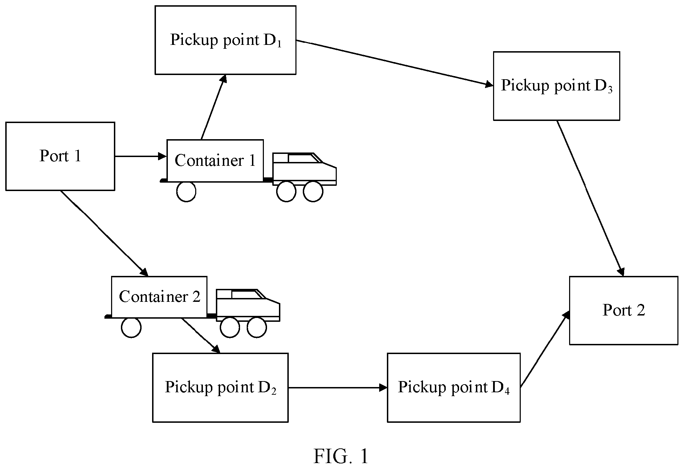

A scenario applied to the embodiments of this application may be shown in FIG. 1. In the embodiments of this application, only two ports, four pickup points, and two containers are used as an example. In actual application, quantities of ports, pickup points, and containers may be adjusted according to an actual requirement, and details are not limited herein. A target freight bill is determined first. The target freight bill includes to-be-transported goods, pickup points, and ports. The to-be-transported goods is distributed at a pickup point $D_1$, a pickup point $D_2$, a pickup point $D_3$, and a pickup point $D_4$. Containers are required to transport the to-be-transported goods to a port 2, and the containers are located at a port 1. Then, a quantity of the containers and a route of each container, and a goods allocation scheme and a loading scheme of each container on the way to the pickup points are then determined. The method for determining a transportation scheme provided in the embodiments of this application can be used to fast generate an optimal transportation route and loading scheme of a container, and an actual loading rate of the container and transportation efficiency can be improved. In an actual scenario, the container may be transported by a freight car, and one container may be transported by one freight car.

For example, in the target freight bill, it is required that goods at $D_1$, $D_2$, $D_3$, and $D_4$ is transported to the port 2, and it can be determined that a route scheme is that: a container 1 departs from the port 1, passes through $D_1$ and $D_3$, transports goods of $D_1$ and $D_3$, and then arrives at the port 2. After calculation, a volume actual loading rate of the container 1 is 95%, and a weight actual loading rate is 96%. A container 2 departs from the port 1, passes through $D_2$ and $D_4$, transports goods of $D_2$ and $D_4$, and then arrives at the port 2. After calculation, a volume actual loading rate of the container 2 is 97%, and a weight actual loading rate is 98%. Therefore, an optimal route for goods transportation can be obtained by using the method for determining a transportation scheme provided in the embodiments of this application, and the volume actual loading rate and the weight actual loading rate of the container are improved.

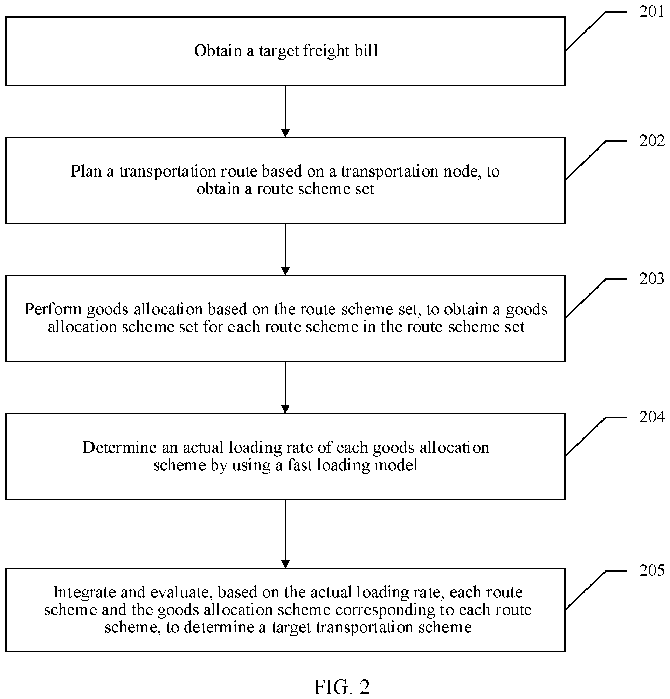

A procedure of the method for determining a transportation scheme provided in the embodiments of this application is described below. Referring to FIG. 2, a schematic diagram of an embodiment of the method for determining a transportation scheme provided in the embodiments of this application includes the following steps.

201. Obtain a target freight bill.

The target freight bill is a freight bill of to-be-transported goods, the target freight bill includes a transportation node and to-be-transported goods information, and the transportation node includes a port and M pickup points. The port may include a freight starting point and a freight ending point for transporting the to-be-transported goods, and the freight starting point and the freight ending point may be a same port, or may be different ports. The to-be-transported goods is distributed at various pickup points of the M pickup points. There may be one or more ports, and there may be one or more M pickup points. Details are not limited herein. In actual application, the freight bill of the to-be-transported goods may be input by a user, or may be generated by an actual transportation system.

202. Plan a transportation route based on a transportation node, to obtain a route scheme set.

After the target freight bill is obtained, the freight starting point and the freight ending point for transportation, and the pickup points at which the to-be-transported goods is distributed may be determined by using the target freight bill, the transportation route may be planned based on historical route data to obtain at least one route scheme, each of the at least one route scheme may include at least one transportation route, that is, a plurality of transportation routes form a complete route scheme, the at least one route scheme forms a route scheme set, and the route scheme set includes the at least one route scheme. One transportation route may correspond to one container. If a plurality of containers are required for completing transportation of the to-be-transported goods, transportation routes of the plurality of containers can be determined, and if goods at one pickup point cannot be transported by using one container, the plurality of containers may be used for transportation. Therefore, one pickup point may be passed through by a plurality of containers. For example, a requirement in the target freight bill is to transport goods of pickup points $D_1$, $D_2$, $D_3$, and $D_4$ to a port 2. A container departs from a port 1, a transfer hyperparameter of a pickup point may be initialized, then, a pickup point transfer probability may be obtained by using the transfer hyperparameter of the pickup point, a transfer probability between pickup points, or between a port and a pickup point is determined, and a plurality of transportation routes may be obtained based on the pickup point transfer probability and include at least one transportation route from the port 1 to $D_1$, $D_2$, $D_3$, and $D_4$, and to the port 2, or at least one route scheme from the port 1 to $D_2$, $D_1$, $D_4$, and $D_3$, to the port 2 and the like. The at least one transportation route may form at least one route scheme, and the at least one route scheme forms a route scheme set.

Specifically, the target freight bill includes the transportation node and the information about to-be-transported goods distributed at the M pickup points. The transportation node includes ports and the M pickup points. M is a positive integer, and the port includes the freight starting point and the freight ending point. The freight starting point and the freight ending point may be a same port, or may be different ports. Route planning is performed based on the transportation node, to obtain the route scheme set. The route scheme set includes the at least one route scheme, and each of the at least one route scheme includes at least one transportation route. Using a route scheme as an example, the route scheme includes at least one transportation route, all transportation routes in the route scheme cover the M pickup points, and one transportation route in the route scheme may cover L of the M pickup points, where $L \leq M$.

In actual application, a planned route may be adjusted based on the historical route data or a preset weight. For example, a transfer probability between a port and a pickup point or between pickup points may be obtained based on a historical route scheme, that is, a transfer probability between pickup points may alternatively be initialized through random distribution or even distribution, and then, each transportation route in each route scheme in a route scheme set is generated based on the transfer probability between the pickup points. Compared with a scheme in the prior art in which a route scheme is obtained through searching by using a rule, in this embodiment of this application, each route scheme in the route scheme set can be fast generated based on the transfer probability between the pickup points, thereby improving efficiency of obtaining the route scheme.

Each route scheme in the route scheme set may further need to be compared in detail, to determine a most suitable route scheme. Conditions of determining the most suitable route scheme may include a route length, an actual loading rate of a container in a route scheme, or a difference between a volume actual loading rate and a weight actual loading rate of a container in a route scheme. A shorter route indicates a better route scheme. A greater actual loading rate of the container in the route scheme indicates a better route scheme. A smaller difference between the volume actual loading rate and the weight actual loading rate of the container in the route scheme indicates a better route scheme.

203. Perform goods allocation based on the route scheme set, to obtain a goods allocation scheme set for each route scheme in the route scheme set.

The route scheme set includes the at least one route scheme, and therefore, goods allocation needs to be further performed for each of the at least one route scheme. That goods allocation is performed for each transportation route in each route scheme in the route scheme set means that the to-be-transported goods is allocated to a container corresponding to each transportation route in each route scheme, to obtain the goods allocation scheme set for each of the at least one route scheme, namely, the first goods allocation scheme set.

Specifically, during the goods allocation, since there are different types of goods, and distribution probabilities of the different types of goods may vary, the goods allocation cannot be simply performed by using a distribution algorithm, and the goods allocation needs to be defined by calculating actual probability distributions of the different types of goods. In this embodiment of this application, before the goods allocation is performed, goods of each pickup point may be clustered first, and then for a same type of goods, a probability distribution is used to determine an allocation manner. A reference condition of clustering may be a length, a width, a height, a weight, a minimum contact area, a material, a bearing coefficient, or the like of the goods. To improve efficiency, the clustering may be performed by using some conditions. For example, the clustering may be performed by using the length, the width, the height, and the weight. The clustering may include precise clustering and fuzzy clustering. In this embodiment of this application, for example, clustering is performed by using the length, the width, the height, and the weight. The precise clustering may be classifying four pieces of goods having completely same features into one category. The clustering is a small granularity-based clustering manner, and a clustering speed is high. The clustering is performed in this way, and accuracy of goods allocation can be improved. When a quantity of categories of goods generated through the precise clustering is excessively large, evaluation and operation costs of one scheme, that is, one route scheme are increased, and the increase in the evaluation and operation costs includes an increase in operation time, a decrease in operation efficiency, and the like. Therefore, when the quantity of categories obtained through the precise clustering is greater than a preset threshold, a clustering operation may alternatively be performed by using clustering algorithms such as K-means clustering, a Gaussian mixture model, or a hierarchical clustering method. Therefore, for goods at each pickup point, a distribution of each category can be obtained by using a clustering algorithm, and each goods allocation scheme in the goods allocation scheme set corresponding to each of the at least one route scheme is obtained based on the distribution of each category.

204. Determine an actual loading rate of each goods allocation scheme by using a fast loading model.

After the goods allocation scheme of each of the at least one route scheme is determined, the actual loading rate of each of the at least one route scheme may be determined by using the fast loading model, and the actual loading rate may include a volume actual loading rate and a weight actual loading rate. The fast loading model is obtained through offline training by using the offline simulation data, and the offline simulation data may be a historical loading scheme calculated through three-dimensional loading. The volume actual loading rate is a proportion of goods allocated to a container in a load volume of the container, and the weight actual loading rate is a proportion of goods allocated to a container in a load weight of the container.

In actual application, a feature may be extracted from the historical loading scheme, the offline simulation data is converted into training data in a preset format, then a predictive model is trained by using the training data, and the predictive model may be used to predict a loading scheme of the to-be-transported goods, to output the actual loading rate. Compared with the prior art in which three-dimensional loading is used for online calculation, the fast loading model in this embodiment of this application can fast output the actual loading rate of each of the at least one route scheme, thereby improving efficiency of obtaining the target transportation scheme.

205. Integrate and evaluate, based on the actual loading rate, each route scheme and the goods allocation scheme corresponding to each route scheme, to determine a target transportation scheme.

After the goods allocation scheme of each route scheme in the goods allocation scheme set is obtained, each of the at least one route scheme and a corresponding goods allocation scheme need to be comparatively evaluated, to select a target route scheme, that is, the target route scheme in each of the at least one route scheme. A specific evaluation manner may be that: the shorter distance of a route scheme, the better; the higher actual loading rate of a container, the better; and the smaller difference between a volume actual loading rate and a weight actual loading rate of a container, the better. Based on different conditions including a length of the route scheme, the actual loading rate of the container, and the difference between the volume actual loading rate and the weight actual loading rate of the container, the target route scheme and a corresponding target goods allocation scheme, that is, the target transportation scheme, can be determined through collaborative evaluation. The target transportation scheme may include an optimal or second optimal transportation scheme corresponding to the target freight bill.

In actual application, iterative route planning, goods allocation, fast loading, and integration and evaluation may be performed on the route scheme in the route solution set. After a stopping condition is met, for example, after a quantity of iteration times reaches a threshold, or after an optimal route scheme and goods allocation scheme are obtained, the target transportation scheme is output.

In this embodiment of this application, after a target freight bill is obtained, route planning is performed based on the target freight bill, and a route scheme set can be obtained. The route scheme set includes at least one route scheme, each of the at least one route scheme includes at least one transportation route, that is, the at least one transportation route forms a complete route scheme, and goods allocation is performed for each transportation route in each route scheme in the route scheme set, to obtain a goods allocation scheme for each of the at least one route scheme. Compared with the prior art in which a large quantity of times of route searching are performed by using a Tabu search method, in this embodiment of this application, a quantity of times of route searching can be reduced, and efficiency of obtaining a route scheme can be improved. Subsequently, an actual loading rate of each route scheme in the goods allocation scheme set is fast output by using a fast loading model, where the actual loading rate includes a volume actual loading rate and a weight actual loading rate, and then integration and evaluation are performed on the goods allocation scheme and each of the at least one route scheme in the route scheme set, to obtain a target route scheme and a target goods allocation scheme corresponding to the target route scheme. The target route scheme and the target goods allocation scheme form a target transportation scheme. The fast loading model is obtained training the offline simulation data, and the offline simulation data includes a historical loading scheme calculated through three-dimensional loading. Compared with the prior art in which a loading scheme is obtained in an online operation through three-dimensional loading, in this embodiment of this application, the actual loading rate can be fast output, and each of the at least one route scheme and the corresponding goods allocation scheme are integrated and evaluated based on the actual loading rate, to obtain the target transportation scheme, so that efficiency of obtaining the target route scheme and the target goods allocation scheme, that is, determining the target transportation scheme can be improved.

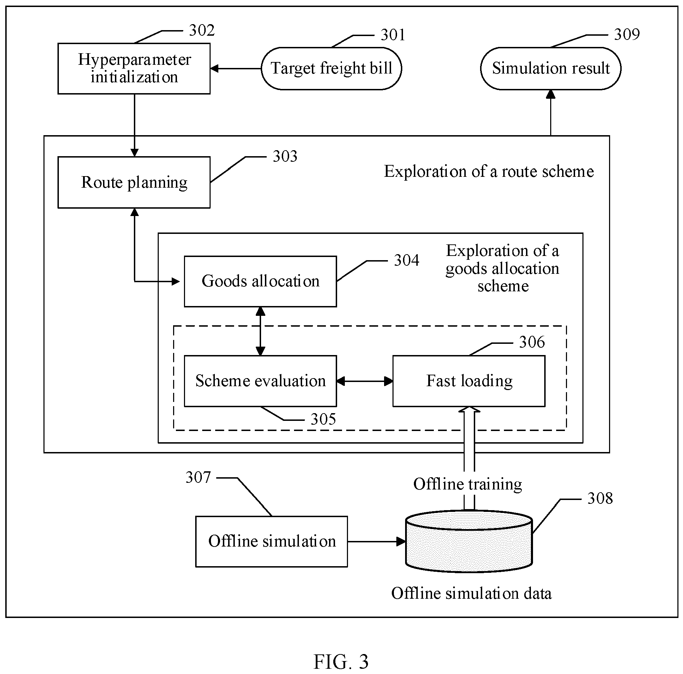

The foregoing describes the procedure of the method for determining a transportation scheme in the embodiments of this application, and the following describes more detail the method for determining a transportation scheme in the embodiments of this application. FIG. 3 is a schematic diagram of another embodiment of the method for determining a transportation scheme in the embodiments of this application.

A procedure of the method for determining a transportation scheme may be: After a target freight bill is received 301, a hyperparameter is initialized 302, and a transfer hyperparameter of a pickup point is initialized; after the transfer hyperparameter of the pickup point is initialized, a pickup point transfer probability distribution can be obtained based on the transfer hyperparameter of the pickup point, and route planning 303 is performed based on the pickup point transfer probability distribution, to obtain a route scheme set; then, goods allocation 304 is performed for each route scheme in the route scheme set, to obtain a goods allocation scheme set for each route scheme in the route scheme set; then, fast loading 306 is performed, fast goods loading is performed for the route scheme and the goods allocation scheme to output an actual loading rate, and scheme evaluation 305 is performed, to integrate and evaluate the route scheme and the goods allocation scheme; and the route scheme set and the goods allocation scheme are further integrated and evaluated to obtain the target route scheme and the corresponding target goods allocation scheme, that is, a simulation result 309. The fast loading model in the fast loading step is obtained by training the offline simulation data 308 offline that is obtained through offline simulation 307. In actual application, step 303 to step 306 may be repeatedly performed, to repeatedly explore a route scheme and explore a goods allocation scheme until a stopping condition is met, to obtain the target route scheme and the corresponding target goods allocation scheme. Alternatively, one route scheme in the route scheme set and a corresponding goods allocation scheme may be directly used as the target route scheme and the corresponding target goods allocation scheme. Adjustment may be specifically made based on an actual design requirement, and details are not limited herein.

The following specifically describes the steps in this embodiment of this application.

301. Target freight bill.

First, a target freight bill is obtained 301, and a transportation node and to-be-transported goods may be learned of from the target freight bill. The transportation node includes a port and a pickup point, and the to-be-transported goods is distributed at each pickup point. The port may include a freight starting point and a freight ending point, the freight starting point and the freight ending point may be a same port, or may be different ports. For example, the target freight bill may indicate that a port 1 is the freight starting point, and to-be-transported goods distributed at a pickup point 1 and a pickup point 2 are to be transported to a port 2.

302. Hyperparameter initialization.

Subsequently, a transfer hyperparameter of a pickup point is initialized, a pickup point transfer probability distribution is obtained based on the initialized transfer hyperparameter of the pickup point, and the pickup point transfer probability distribution includes a transfer probability of a container from a port to a pickup point or between pickup points, for example, a transfer probability from a pickup point $D_1$ to a pickup point $D_2$.

In actual application, a specific procedure of the Bayesian estimation algorithm may be as follows: A prior distribution is first allocated to a to-be-estimated estimator, then a posterior distribution is calculated based on the Bayesian formula with reference to experimental data, and then an estimated value of the to-be-estimated estimator is obtained based on the posterior distribution. Therefore, in the method for determining a goods allocation scheme in this embodiment of this application, the transfer hyperparameter of the pickup point may be calculated by using the Bayesian estimation algorithm. The prior distribution may be obtained based on historical data or user experience. In an actual service system, a large amount of historical route data is accumulated, a large quantity of samples of to-be-estimated estimators may be extracted from the historical route data, and the hyperparameter is estimated by using these samples. The historical route data may be used as prior data. In addition, in actual application, the prior data may be adjusted based on experience of an actual scheduler. However, when the quantity of the samples of the to-be-estimated estimators obtained from the historical route data is lower than a preset threshold, the hyperparameter cannot be estimated, and a heuristic algorithm may be used for estimation. The following separately describes in detail the Bayesian estimation algorithm and the heuristic algorithm that can be used in this embodiment of this application.

1. Bayesian estimation algorithm.

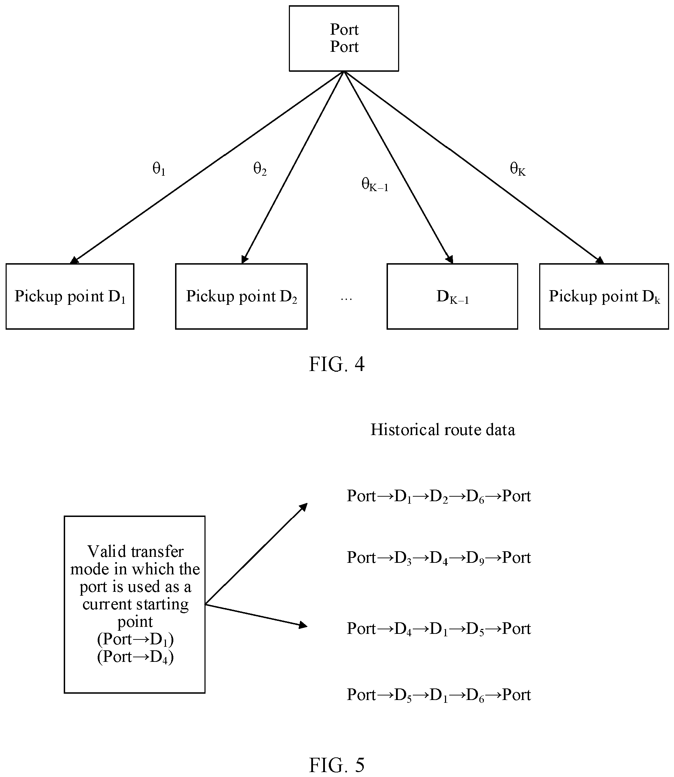

A prior distribution may be generated by sampling a polynomial distribution, a binomial distribution, or the like. For example, when the target freight bill includes k pickup points $D_1$, $D_2$, $D_3$, ..., and $D_k$ and a port, a transfer probability from the port to the pickup points is a polynomial distribution: a parameter $\theta=(\theta_1,\theta_2,...,\theta_k)$, and the transfer probability from the port to the pickup points is shown in FIG. 4. Transfer from a port to a pickup point or between two pickup points represents a transfer mode in which a starting point is a current starting point, and an ending point is a current jump point. If the current jump point is a pickup point required in the target freight bill, and is different from the current starting point, such a transfer mode is a valid transfer mode, that is, it is determined, based on the pickup point in the target freight bill, that the transfer mode is a valid transfer mode. If the preset parameter $\theta$ follows the Dirichlet($\alpha$) distribution, and $\alpha$ is a hyperparameter, the posterior distribution also follows the Dirichlet distribution. The prior distribution and the posterior distribution only differ in the hyperparameter. Therefore, calculation of the posterior distribution may be simplified, and in this embodiment of this application, it may be considered that $\theta$ follows the Dirichlet($\alpha$) distribution.

Each piece of historical route data may indicate a historical transportation route. For example, there is a piece of historical route data: $Port \to D_1 \to D_3 \to D_6 \to Port$, which indicates that a transportation route is: departing from a port, successively passing through $D_1$, $D_3$, and $D_6$, and then returning to the port. A specific initialization procedure may include the following steps: first, selecting a pickup point or a port in the target freight bill as the current starting point, sifting out the historical route data, and if there are k pickup points in the freight bill, determining (k+1) pieces of historical route data. For example, if a port is selected as the current starting point, use of any pickup point in the freight bill as the current jump point can form a valid transfer mode, and there needs to be at least one corresponding valid transfer mode in the historical route data sifted out. For example, in the target freight bill, if a route from a port to $D_1$ is selected, at least one route in the historical route data sifted out includes a route from the port to $D_1$. As shown in FIG. 5, assuming that the target freight bill includes a port and two pickup points $D_1$ and $D_4$, historical routes that are of transferring from the port to $D_1$ or transferring from the port to $D_4$ and that are included in the historical route data are used as the valid transfer mode.

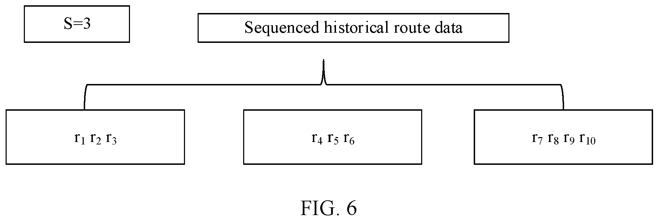

The historical route data sifted out is arranged in a preset order, and S pieces of historical route data are sequentially selected based on a preset window size. As shown in FIG. 6, it may be preset that S=3, and then each window has three historical routes, and if a quantity of the last historical routes is less than 3, the historical routes may be grouped into a previous window. If a quantity of historical routes in a current window is less than a preset first threshold $N_{min}$, calculation may be performed by using the heuristic algorithm. A case in which a quantity of historical routes in a window is not less than the first threshold $N_{min}$ is first described herein, and a case in which a quantity of historical routes in a window is less than the first threshold is separately described, that is, the heuristic algorithm is separately described.

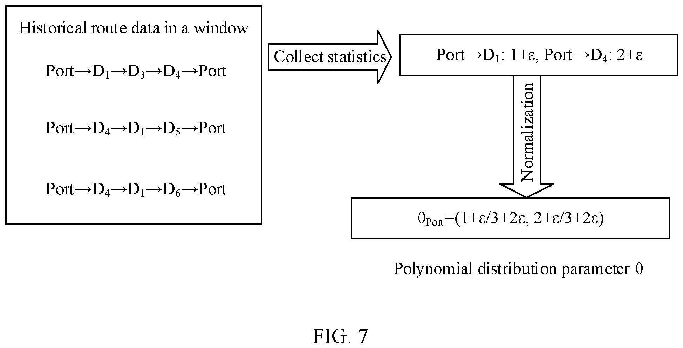

Statistics on a quantity of times that a valid transfer mode occurs is separately collected in historical route data of each window, and based on this, a parameter of a corresponding polynomial distribution is calculated. Assuming that there are $t$ windows, where $t \geq N_{min}$, $t$ samples of $\theta$ can be obtained. A specific counting process may be shown in FIG. 7. Route data in one window is selected, and statistics on historical route data of the window is collected. For example, if a current starting point is a port, and a current jump point is $D_1$, statistics on a quantity of historical routes from the port to $D_1$ is collected. After statistics on a quantity of times of transferring from the port to the pickup point or between the pickup points is collected, normalization calculation is performed to obtain the parameter $\theta$ of the polynomial distribution.

After statistics on historical route data of all windows are collected, maximum likelihood estimation is performed based on the obtained $t$ samples of $\theta$, to calculate an estimated value of the hyperparameter $\alpha$.

2. Heuristic algorithm.

If a quantity of historical routes in a current window is less than a preset threshold $N_{min}$, a hyperparameter may be calculated by using the heuristic algorithm. If there are k pickup points in the target freight bill, using one pickup point $D_i$ thereof as an example, a total volume of goods is $V_i$, a total weight is $W_i$, a maximum loading volume of a container is $V$, and a maximum weight is $W$.

A specific algorithm procedure of the heuristic algorithm may include the following steps.

First, a minimum quantity of cars required for loading all goods of the pickup point $D_i$ is calculated. Herein, one car is considered as one container, where min\_$car$=$Max(V_i/V, W_i/W)$. After the minimum quantity of cars min\_$car$ is calculated, the minimum quantity of cars is rounded up.

Then, an energy coefficient $P_{Di}$ of the pickup point $D_i$ is calculated, and the energy coefficient is a hyperparameter

$$P_{Di} = \frac{\min\_car}{\min\_car\_ceiled}$$

of a polynomial distribution corresponding to the pickup point, where $, (0 < P_{Di} \leq 1)$.

If there is no bonded warehouse, where the bonded warehouse is a warehouse from which goods can be transported out after taxes are paid, and is only accessible to an empty container, the hyperparameter of the polynomial distribution corresponding to the pickup point $D_i$ is:

$$\alpha_{Di} = \left( P_{D_1}, \ldots, P_{D(i+1)}, \ldots, P_{Dk}, P_{Di} \right).$$

A hyperparameter of a polynomial distribution corresponding to a port is:

$$\alpha_{Port} = \left( P_{D_1}, P_{D2}, \ldots, \ldots, P_{DK} \right).$$

In an actual scenario, a bonded warehouse may also exist at a pickup point. If the bonded warehouse exists at the pickup point, assuming that the bonded warehouse is $D_i$, the hyperparameter of the polynomial distribution corresponding to the port is set to: $\alpha_{Port}$ = ($\varepsilon_{(1)}$, ..., $\varepsilon_{(i-1)}$, 1, $\varepsilon_{(i+1)}$), the hyperparameter corresponding to the pickup point $D_i$ is 1, hyperparameters of other pickup points may be set to $\varepsilon$, and $\varepsilon$ corresponding to the other pickup points may be set to a very small number, for example, 0.00001 or 0.0000001.

In actual application, a large amount of high-quality historical route data is accumulated, and a valid data basis may be provided for hyperparameter initialization. In the method for determining a transportation scheme provided in this embodiment of this application, hyperparameter initialization may be performed by using the historical route data, a more accurate route scheme may be obtained by using the historical route data, and in addition, efficiency of obtaining a route scheme subsequently can be improved.

303. Route planning.

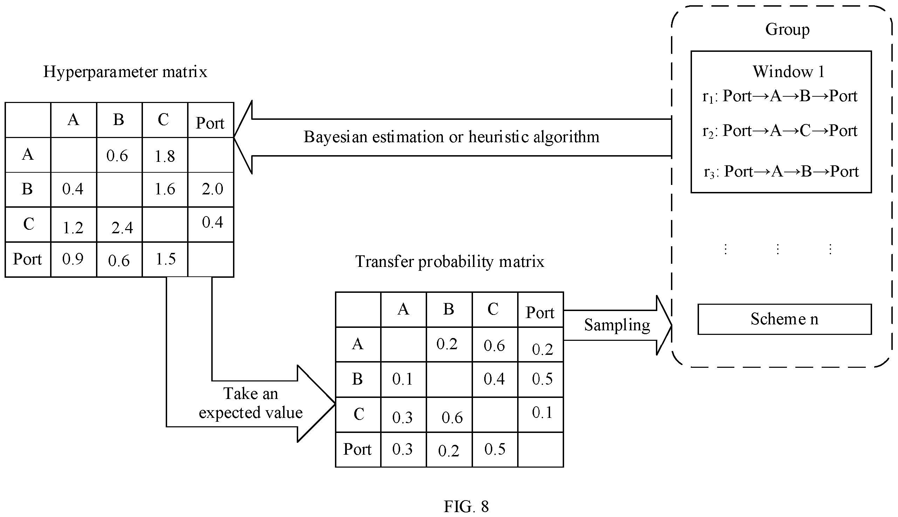

After the transfer hyperparameter of the pickup point is initialized, route planning is performed. A transportation route needs to be planned to determine a route scheme and a quantity of containers for transportation. After the hyperparameter is initialized, a pickup point transfer hyperparameter matrix may be obtained. A pickup point transfer probability matrix may be generated by using the pickup point transfer hyperparameter matrix, and the pickup point transfer probability matrix includes a probability distribution of transferring between a port and a pickup point, or between pickup points. A transfer probability is a transfer probability from one port to one pickup point or from one pickup point to another pickup point, and may be obtained based on the historical route data. For example, as shown in FIG. 8, it may be learned from the figure that a transfer probability from a pickup point A to a pickup point B is 0.2, a transfer probability from the pickup point A to a pickup point C is 0.6, and so on. After the hyperparameter matrix is calculated by using the Bayesian estimation algorithm or the heuristic algorithm, in this embodiment of this application, an estimated value of the transfer probability matrix may be obtained by selecting an expected value by using the Dirichlet distribution, and the transfer probability matrix is obtained by selecting the expected value. In actual application, if a route needs to be preferentially selected, a weight of a transfer probability of this route may be increased, and the weight of the transfer probability of this route may be increased by setting the transfer probability.

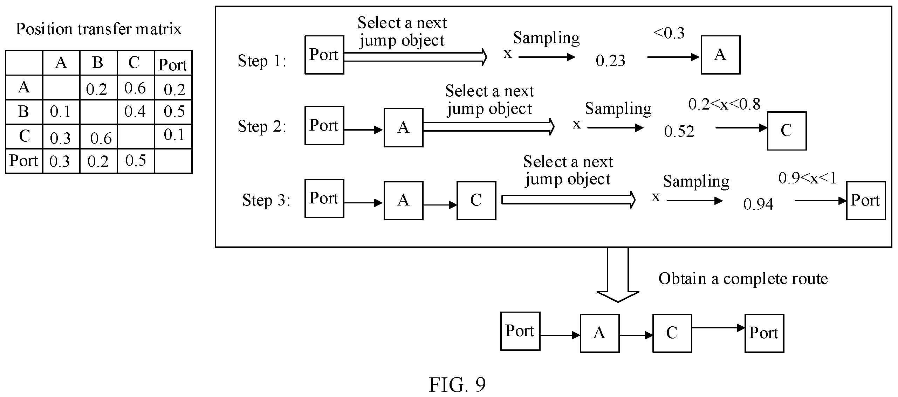

After the transfer probability matrix is obtained, a route scheme set, that is, a route scheme group, is generated through sampling. An example of obtaining a route scheme through sampling is shown in FIG. 9. The transfer probability between a port and a pickup point or between pickup points can be obtained by using the transfer probability matrix, and then, the route scheme set is determined by using the transfer probability matrix. For example, a current starting point is a port, step 1 is first performed, that is, a next jump point is selected from the port, and a transfer probability obtained through sampling calculation is 0.23, the port is determined as a pickup point A, a subsequent pickup point determining manner is similar to a manner of determining the pickup point A, and step 2 and step 3 are performed to sequentially determine a pickup point C and the port, and the obtained route scheme is Port → Pickup point A → Pickup point C → Port.

A probability $P_i$ of selecting each route scheme may be calculated, $i$ indicates an $i^{th}$ scheme, namely, a route scheme, each of the at least one route scheme may be evaluated by using the evaluation function, and a specific formula for calculating a probability of a scheme is:

$$P_i = \frac{e^{-f(i)}}{\sum_{j=0}^{n} e^{-f(j)}}.$$

$j$ represents a $j^{th}$ scheme, $n$ represents a total quantity of schemes, $f(i)$ is a score of a scheme, and the scheme score function is an evaluation function in a scheme evaluation step. Details are to be described in step 305 of scheme evaluation step, and are not described herein. Therefore, it can be learned from the formula for calculating a scheme probability that, a probability of selecting a route scheme is related to evaluation of the route scheme, and higher evaluation of the route scheme indicates a greater probability of selecting the route. It may be understood as that, higher evaluation of the route scheme indicates that the route scheme is better.

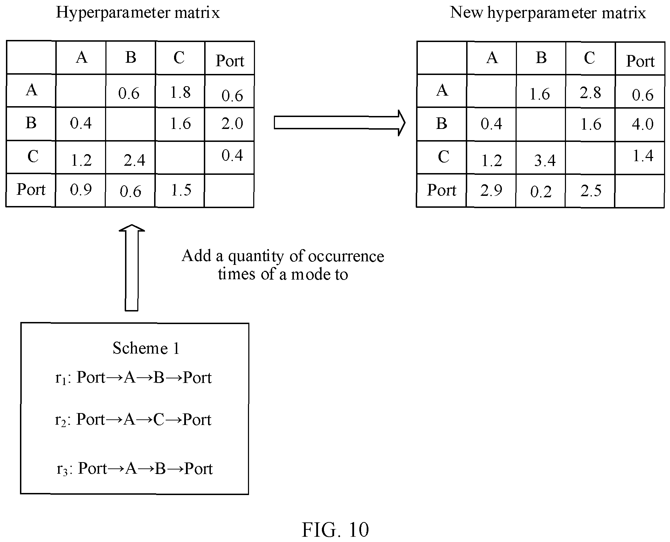

m schemes are selected based on the calculated probability of selecting each of the at least one route scheme, to update the route scheme set. In addition, the hyperparameter matrix in addition to the route scheme set may further be updated, to improve efficiency of subsequently calculating the hyperparameter, and if evaluation of a planned route is not high, the route planning may continue to be performed by using the updated hyperparameter matrix, to obtain a more accurate route scheme. The m selected schemes are used for Bayesian estimation to update the hyperparameter matrix, and a specific example of updating the hyperparameter matrix is shown in FIG. 10. For example, if a transfer mode of Pickup point A → Pickup point B in the m schemes has occurred once, a value of transferring from the pickup point A to the pickup point B in the corresponding hyperparameter matrix is increased by 1. If an original value is 0.6, an increased value is 1.6, and other transferring calculation are deduced by analogy. After the hyperparameter matrix is updated, if there is no suitable route scheme in the selected m schemes that are integrated and evaluated, the pickup point transfer probability matrix may continue to be obtained by using the hyperparameter matrix, and then the route planning is performed again.

For example, after the hyperparameter is initialized, the pickup point transfer probability matrix is obtained based on the initialized transfer hyperparameter of the pickup point, and a first route scheme set is determined based on the pickup point transfer probability matrix. The first route scheme set includes at least one route scheme, goods allocation is performed based on each route scheme in the first route scheme set, and each goods allocation scheme in the goods allocation scheme set for each route scheme in the first route scheme set is obtained. Subsequently, each route scheme in the first route scheme set and the goods allocation scheme corresponding to each route scheme in the first route scheme set are integrated and evaluated. If no suitable target transportation scheme is obtained based on a result of the integration and evaluation, the transfer hyperparameter of the pickup point may be updated based on each route scheme in the first route scheme set, and the updated pickup point transfer probability matrix is obtained by using the updated transfer hyperparameter of the pickup point. The transportation route is re-planned based on the updated pickup point transfer probability matrix, to obtain a second route scheme set. The second route scheme set includes at least one route scheme, and then goods allocation and integration and evaluation are performed on each route scheme in the second route scheme set, to obtain the target transportation scheme.

304. Goods allocation.

After the route planning is performed, and each route scheme in the route scheme set is obtained, goods allocation may be performed for each transportation route in each route scheme in the route scheme set, and the goods allocation is performed for each transportation route in each route scheme in the route scheme set, to obtain goods loaded into a container in each transportation route.

One route scheme set may be considered as a group, and each scheme in the group represents one route scheme. After a scheme is generated, each transportation route in the route scheme has been acknowledged. Therefore, a quantity of required containers, and a route of each container have been determined. In actual application, it may be considered that a container is in a one-to-one correspondence with a transportation route, and a container is in a one-to-one correspondence with a freight car. In this case, goods loaded into a container further need to be allocated, to determine goods loaded into each container.

During the goods allocation, since there are different types of goods, for example, different lengths, different widths, different heights, or different weights, goods allocation at a pickup point cannot be described by using a simple distribution. In this embodiment of this application, goods may be clustered, and then the goods are allocated through clustering. A reference condition of clustering may be a length, a width, a height, a weight, a minimum contact area, a material, a bearing coefficient, or the like of the goods. To improve efficiency, the clustering may be performed by using some conditions. For example, the clustering may be performed by using the length, the width, the height, and the weight. The clustering may include precise clustering and fuzzy clustering. In this embodiment of this application, for example, the clustering is performed by using the length, the width, the height, and the weight. The precise clustering may be classifying four pieces of goods having completely same features into one category. The clustering is a small granularity-based clustering manner, and a clustering speed is high. The clustering is performed in this way, and accuracy of goods allocation can be improved. When a quantity of categories of goods generated through the precise clustering is excessively large, for example, a length of goods may be grouped into a plurality of categories, and a width may also be grouped into a plurality of categories, scheme calculation costs are increased. Therefore, when the quantity of categories obtained through the precise clustering is greater than a preset threshold, a clustering operation may alternatively be performed by using clustering algorithms such as K-means clustering, a Gaussian mixture model, or a hierarchical clustering method. In this embodiment of this application, goods are classified by using a clustering method, and the goods are allocated after the classification, so that accuracy of subsequently obtaining a goods loading scheme can be improved.

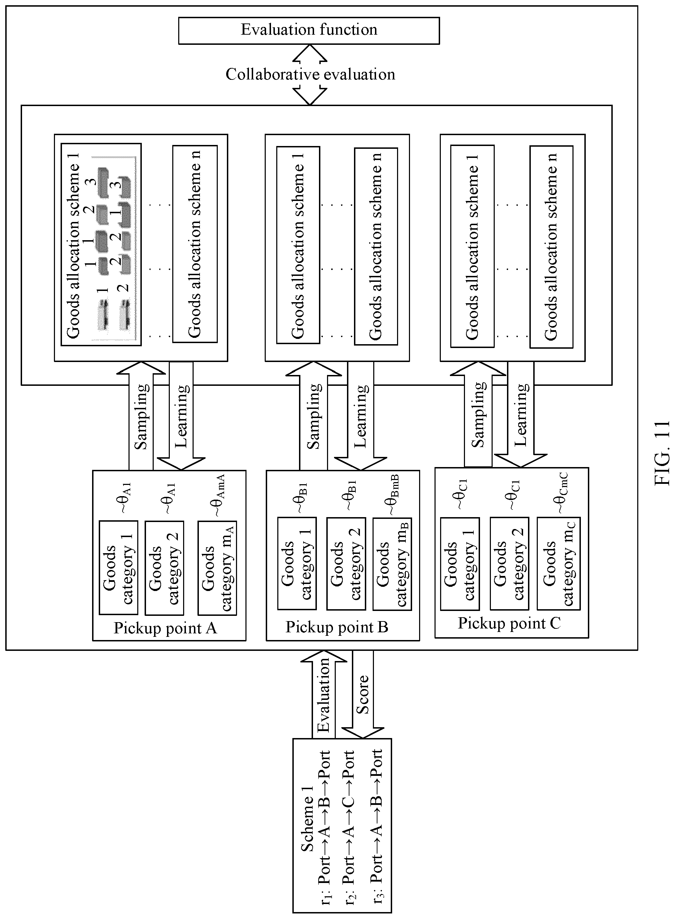

For example, a schematic diagram of goods allocation may be shown in FIG. 11. At each pickup point, there is goods waiting to be transported. For example, categories of to-be-transported goods at a pickup point A in FIG. 11 include a goods category 1, a goods category 2, or a goods category $m_A$, each respectively corresponding to a first goods allocation hyperparameter $\theta_{A1}$, $\theta_{A2}$, and $\theta_{AmA}$ of the pickup point. Then, goods allocation is performed on to-be-transported goods at each pickup point through sampling, and a category group representing a goods allocation manner set is generated for each pickup point. A scheme in the category group represents a goods allocation manner of the pickup point. For example, two containers pass through the pickup point A, In FIG. 11, a scheme in a group 1 represents a scheme of allocating goods of the pickup point A to the two containers, that is, represents an amount of each category of goods allocated to each container. One group can represent a goods allocation manner of only one pickup point, and cannot represent a complete goods allocation scheme. Therefore, goods allocation manners of all pickup points need to be combined, and after a complete scheme is formed, the scheme is evaluated, that is, collaborative evaluation is performed on the scheme, to determine a goods allocation scheme of each route scheme. For example, when a scheme in a group 1 is evaluated, a group 2 and a group 3 each need to provide a representative scheme, the scheme in the group 1 is first combined with the representative schemes in the group 2 and the group 3 to form a complete goods allocation scheme, and then evaluation steps are performed. A representative scheme may be randomly selected from a group, may be an optimal scheme in a group, or may be an optimal scheme determined after random selection is performed iteratively. Scheme evaluation may be performed, to be specific, an evaluation function in step 305 may be used to evaluate the goods allocation scheme. A score of each route scheme in the goods allocation scheme set is calculated by using the evaluation function, and the evaluation function is to be described in the following detailed description of step 305, and is not described herein.

For example, one route scheme is used as an example. After a first goods allocation scheme set is formed, and each goods allocation scheme in the first goods allocation scheme set is evaluated and scored, if the first goods allocation scheme does not include a goods allocation scheme scored higher than a second threshold, a first goods allocation hyperparameter of a pickup point may be updated by using the obtained first goods allocation scheme set, to obtain a second goods allocation hyperparameter of the pickup point. To-be-transported goods is re-allocated by using the second goods allocation hyperparameter to obtain a second goods allocation scheme set corresponding to the route scheme, and each goods allocation scheme in the second goods allocation scheme set is continued to be integrated and evaluated, to determine a target goods allocation scheme and a corresponding target route scheme. In actual application, goods allocation may be repeatedly performed until a stopping condition is met. For example, a quantity of iteration times reaches a preset quantity of times, or a quantity of goods allocation schemes whose scores of results of integration and evaluation are higher than the second threshold reaches a preset quantity. The goods allocation stops after the target goods allocation scheme is determined.

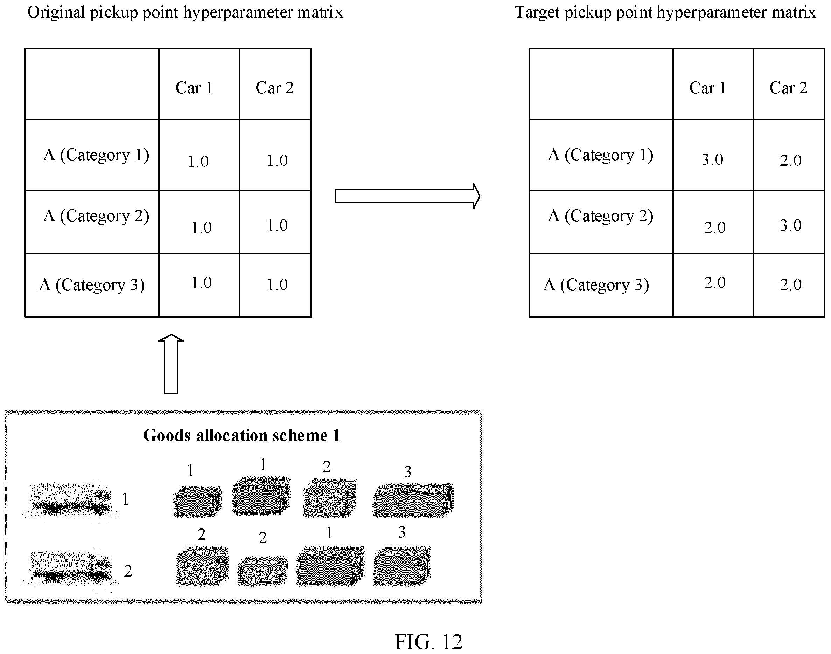

Specifically, to improve the efficiency of the method for determining a transportation scheme in this embodiment of this application, after a scheme score is obtained, an algorithm similar to that used in step 303 of route planning is used to calculate scheme selection probabilities, n schemes are selected based on the scheme selection probabilities, and original pickup point hyperparameter matrices of various pickup points are updated based on the n schemes, obtain a target pickup point hyperparameter matrix. After the goods allocation scheme of each pickup point is determined, a further learning process may be included, and the further learning process may be used to repeatedly allocate goods. A specific process of updating a goods allocation hyperparameter may be shown in FIG. 12. After the n goods allocation schemes are determined, and it is determined that goods can all be loaded into containers by using all the goods allocation schemes, update is performed by using the n goods allocation schemes. For example, in a goods allocation scheme, goods labeled by 1 is of a same category, goods labeled by 2 is of a same category, and goods labeled by 3 is of a same category, to be specific, a category 1. The category 1 is in a first container, to be specific, two pieces of goods are allocated to a car 1, hyperparameters of the corresponding car 1 and category 1 are increased by 2. If hyperparameters of the car 1 and the category 1 in an original pickup point hyperparameter matrix each are 1.0, the hyperparameters of the car 1 and the category 1 that are increased by 2 in a target pickup point hyperparameter matrix each are 3.0, and hyperparameters of other categories and containers are deduced by analogy.

305. Scheme evaluation.

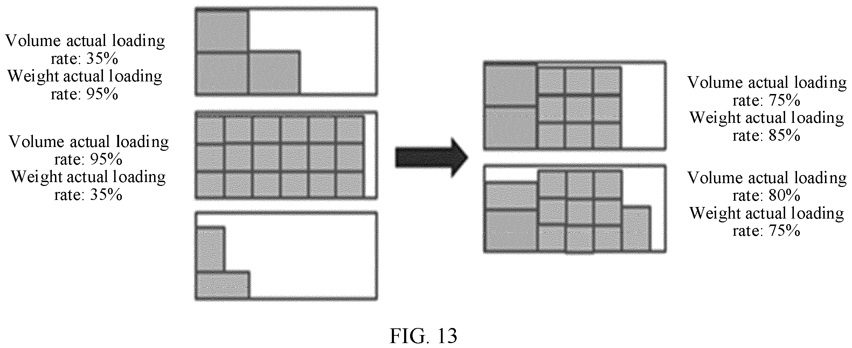

After the goods allocation is performed, and the goods allocation scheme is obtained, scheme evaluation is further required. The scheme evaluation is to integrate a route scheme and a goods allocation scheme, and evaluate the route scheme and the goods allocation scheme. An evaluation index includes: a route length in a route scheme, an actual loading rate of a container, and a difference between a volume actual loading rate and a weight actual loading rate of a container. A shorter route in a route scheme indicates a shorter car travelling route, that is, a shorter transportation route of a container, so that transportation costs can be reduced, and transportation efficiency can be improved. A higher actual loading rate of a container, that is, a larger amount of goods loaded into a container indicates a smaller quantity of containers required for loading same goods, so that the transportation costs can also be reduced and the transportation efficiency can be improved. The difference between the volume actual loading rate and the weight actual loading rate of the container cannot exceed a threshold. For example, as shown in FIG. 13, for goods of a same weight, when a volume actual loading rate of a container is 35% and a weight actual loading rate is 95%, a volume actual loading rate of another container is 95% and a weight actual loading rate is 35%, and an additional container loads remaining goods, three containers are required; when a volume actual loading rate of a container is 75% and a weight actual loading rate is 85%, and a volume actual loading rate of another container is 80% and a weight actual loading rate is 75%, only two containers are required. Therefore, the smaller the difference between the volume actual loading rate and the weight actual loading rate of the container, the more container resources can be saved. In actual application, the actual loading rate of the container may be obtained through fast loading, that is, step 306.

Containers with unbalanced actual loading rates may be obtained by observing loading records of containers in historical data. The volume actual loading rate and the weight actual loading rate are distributed at two corresponding sides of an average volume actual loading rate $\overline{r_V}$ and an average weight actual loading rate of all goods in the freight bill, that is, $(r_{Vi}-\overline{r_V})(r_{Wi}-\overline{r_W})<0$, where $\overline{r_V}$ is equal to a volume of all the goods on the freight bill/(a quantity of containers for loading * a volume of a container and $\overline{r_W}$ is equal to a weight of all the goods on the freight bill/(a quantity of containers for loading * a load weight of a container), $r_{Vi}$ is a volume actual loading rate of an $i^{th}$ container, and $r_{Wi}$ is a weight actual loading rate of an $i^{th}$ container.

Therefore, this embodiment of this application provides an evaluation function, to evaluate a route length and an actual loading rate of a container, and further compare a difference between a volume actual loading rate and a weight actual loading rate.

$$f(\vec{R},\vec{r_V},\vec{r_W}) = \sum_{i=1}^{m} \alpha \, | \, r_{Vi} - \overline{r_V} - r_{Wi} + \overline{r_W} \, | - \beta(r_{Vi} + r_{Wi}) + \gamma Cost(R_i)$$

The evaluation function is:      $\vec{R}$ is a route scheme vector, m containers are included, $\overrightarrow{r_V}$ is a volume actual loading rate vector of the m containers, $\overrightarrow{r_W}$ is a weight actual loading rate vector of the m containers; $\alpha$, $\beta$ and $\gamma$ are weight parameters, $r_{Vi}$ is a volume actual loading rate of an $i^{th}$ container, $r_{Wi}$ is a weight actual loading rate of an $i^{th}$ container, $\overline{r_V}$ is an average volume actual loading rate of the m containers, and $\overline{r_W}$ is an average weight actual loading rate of the m containers.

The evaluation function may be used to evaluate a route scheme, to sift out some invalid route schemes or low-evaluated route schemes, to update the route scheme set.

306. Fast loading.

When step 305 of scheme evaluation is performed, fast loading simulation may be performed on each route scheme in the route scheme set by using the fast loading model, to obtain an actual loading rate of each route scheme in the goods allocation scheme set corresponding to each route scheme. Based on the goods allocation scheme obtained through goods allocation, that is, a set of goods loaded into the container, the actual loading rate of the container is fast obtained. The fast loading model is obtained by training the offline simulation data 308, the offline simulation data includes a historical loading scheme obtained through three-dimensional loading, the offline simulation data may be obtained through offline simulation 307, and the step of the offline simulation 307 is similar to the step of determining the target transportation scheme in this embodiment of this application.

In actual application, in addition to conforming, by using the fast loading model, the actual loading rate that is of each goods allocation corresponding to each of the at least one route scheme and that is obtained by performing fast loading for each route scheme in the route scheme set, goods loaded into the container may further be estimated based on the actual loading rate, to obtain a feasible solution, that is, to determine whether each piece of goods can be loaded into the container. If there is remaining goods that cannot be loaded into the container, further goods allocation needs to be performed on the remaining goods, to obtain the target transportation scheme by using which the to-be-transported goods can be completely transported.

Therefore, step 304, step 305, and step 306 together form a step of exploring a goods allocation scheme. The step of exploring a goods allocation scheme and step 303 form a step of exploring a route scheme. After the target transportation scheme, that is, a target transportation route and a goods allocation scheme corresponding to the target transportation route are determined, the target transportation scheme is output, and the to-be-transported goods is transported by using the target transportation scheme.

In actual application, step 303 to step 306 may be repeated to obtain the target route scheme and the corresponding target goods allocation scheme, that is, the target transportation scheme, and the to-be-transported goods is transported by using the target route scheme and the corresponding target goods allocation scheme.

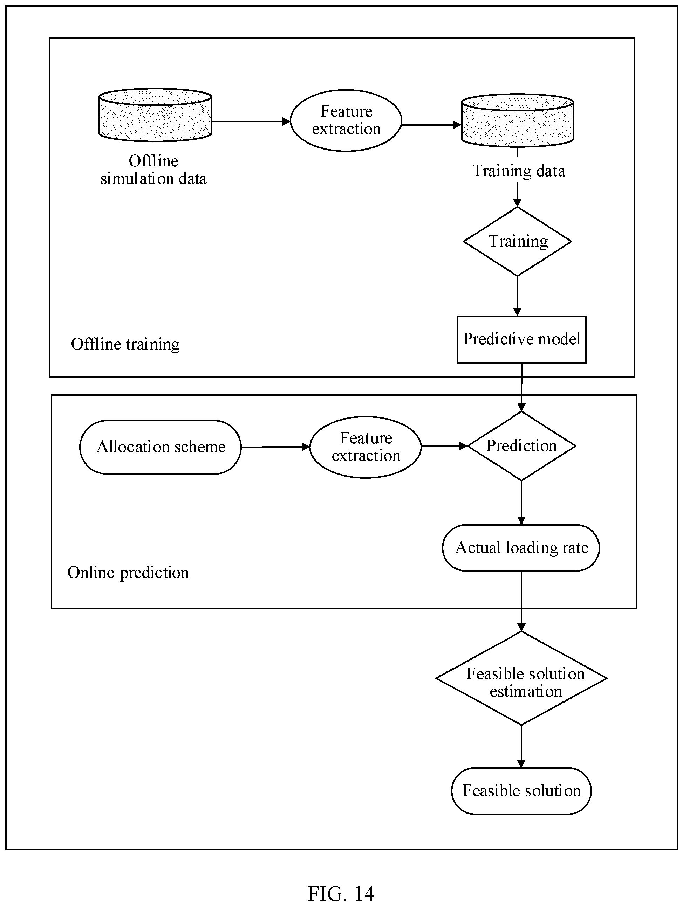

Specifically, a specific obtaining procedure of the fast loading model and the loading scheme may be shown in FIG. 14, and the procedure includes an offline training part and an online prediction part.

The offline training part is first described. Specifically, as shown in FIG. 14, a large amount of high-quality offline simulation data is obtained through offline simulation, a feature is extracted from the offline simulation data, that is, a goods allocation scheme of a container is converted into a group of feature vector, the offline simulation data is used to train a predictive model, and the predictive model is used to output a volume actual loading rate and a weight actual loading rate of input data. The predictive model may include: a linear regression model, a ridge regression model, an LASSO model, a support vector machine model, a random forest model, an XgBoost model, an artificial neural network model, or the like.

During the offline training and the online prediction, a feature needs to be extracted, feature extraction processes of the offline training and the online prediction are similar, and a difference lies in that for the offline training, a feature is extracted from the offline simulation data, and for the online prediction, a feature is extracted from a goods set allocated to a container, that is, from each goods allocation scheme. A specific feature extraction procedure includes: first extracting a feature of a single piece of goods, to obtain a feature vector of the single piece of goods, namely, a second feature vector, where the feature of the single piece of goods includes: a length, a width, a height, and a weight of the goods, and may further include a minimum contact area, a material, a bearing coefficient, and the like. The material and the bearing coefficient are category-based variables, that is, are related to a category of goods, and category dimensions are not high. Therefore, in this embodiment of this application, a one-hot encoding scheme may be used to represent the material and the bearing coefficient. For example, there are four materials, and if one piece of goods belongs to a material 1, the material is identified in a form of the one-hot encoding scheme as: (1, 0, 0, 0).

After the feature vector of the single piece of goods is obtained, a feature vector $\overrightarrow{P_i}$, namely, a third feature vector, of a goods set allocated at a pickup point is subsequently obtained. $\overrightarrow{P_i}$ may include an average value and a covariance of goods feature vectors, an amount of goods of different materials, and a quantized value $t_i$ of the pickup point.

Subsequently, weighted combination is performed on $\overrightarrow{P_i}$ of the container passing through various pickup points, to obtain a final feature vector, that is, a first feature vector $\overrightarrow{O}$ of each goods allocation scheme in the first goods allocation scheme set corresponding to each of the at least one route scheme:

$$\overrightarrow{O}=\sum_{i=1}^{n} r_i P_i$$

. $n$ represents a quantity of pickup

points, $r_i$ represents a quantized value of a sequence of a pickup point $i$ in a route scheme, and $r_i$ and $t_i$ are historical route-based data, and are obtained through analysis by using a corresponding analysis method.

During the offline training, each piece of historical loading scheme data in the offline simulation data is converted into training data in a preset format. The preset format may be (a feature vector, an actual loading rate), and then model training is performed, to obtain the fast loading model. Two models need to be trained, and the two models include a model for predicting a volume actual loading rate and a model for predicting a weight actual loading rate. That is, the fast loading model includes a model for predicting a volume actual loading rate and a model for predicting a weight actual loading rate.

During the online prediction, the goods sets allocated to the container are converted to feature vectors in a preset format, and then the feature vectors are input to the trained model, to obtain a corresponding output value.

In actual application, goods allocated to the container may not be loaded into the container, and when during hyperparameter update, only the part of goods loaded into the container can be considered, that is, a feasible solution, and an amount of loaded goods is used to update the hyperparameter. The goods allocation scheme determined during the goods allocation includes a set of goods loaded into the container. The model for predicting an actual loading rate can predict an actual loading rate of only the goods set, but cannot determine whether the goods in the goods set can be loaded into the container. Therefore, the set of goods that can be loaded into the container needs to be predicted based on the information about the actual loading rate, and in this embodiment of this application, linear programming can be used to resolve this problem.

For example, n pieces of goods are allocated to one container, a volume of an $i^{th}$ piece of goods is $v_i$, a weight is $w_i$, $p_i$ is a probability that an $i^{th}$ piece of goods can be loaded into the container, a volume actual loading rate output by the model for predicting an actual loading rate is $r_v$, a weight actual loading rate is $r_w$, predicted values of the volume and weight of the goods loaded into the container are respectively V and W, and linear programming may be defined as:

$$\min V + W - \sum_{i=1}^{n}(v_i + w_i)p_i \; ; \quad \sum_{i=1}^{n}v_i p_i \le V \text{, and} \quad \sum_{i=1}^{n}w_i p_i \le W \text{; and} \quad p_i \in [0, 1].$$

A set of $p_i$ can be obtained by solving the foregoing formula, goods in a goods set is sorted in a descending order of $p_i$, and goods is sequentially selected based on the sequence. Given that a total volume of removed goods exceeds V, or a total weight exceeds W, a provided goods set is an estimation of a feasible solution, that is, goods that can be loaded into the container.

In this embodiment of this application, after the feasible solution is obtained through online simulation, post-processing may further be performed. That is, after the target transportation scheme is determined, a suitable container type may further be determined to generate a final loading scheme. For example, an available container type may be 40HQ, and a volume and a weight of goods loaded into each container can be obtained through goods allocation exploration and route scheme exploration in FIG. 3. In this case, a volume and a load weight of an available type cannot be less than the volume and the weight of the goods. In actual application, after the container type is determined, a final loading scheme of the to-be-transported goods in the container may alternatively be determined through three-dimensional loading, so that all the goods is accurately loaded into the container, and efficiency of loading the goods during actual goods loading is improved. The container type may be a type of container into which goods can be successfully loaded and has lowest costs, to reduce the costs of the container.

If there is no remaining goods, that is, goods that cannot be loaded into the container, the determined suitable container type and the final loading scheme are a complete scheme. If there is remaining goods, that is, goods that cannot be loaded into the container, a virtual freight bill may be generated for the remaining goods, and exploration of the goods allocation scheme is repeated to obtain a transportation scheme of the remaining goods, to complete transportation of the remaining goods.

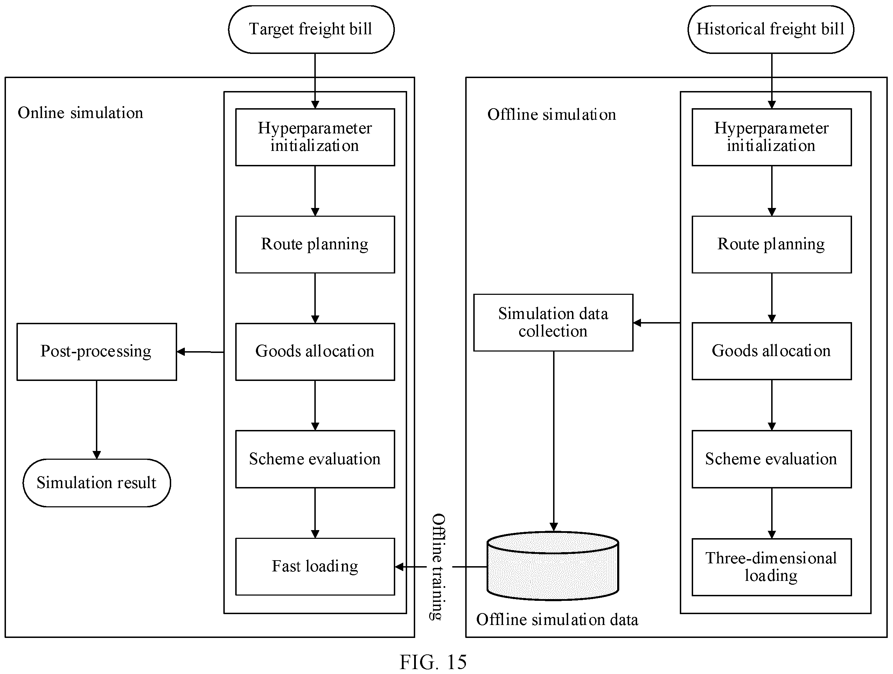

In this embodiment of this application, the offline simulation data for training the fast loading model may be obtained through the offline simulation. A specific process of the offline simulation is similar to that of the online simulation, and differences include that: during the offline simulation, a historical freight bill is used for simulation, and during the online simulation, a current freight bill is used for simulation; and during the offline simulation, three-dimensional loading is used to generate the loading scheme, and during the online simulation, the actual loading rate and the like is output by using the fast loading model obtained through offline training. For details, refer to FIG. 15. FIG. 15 is a schematic diagram of another embodiment of the method for determining a transportation scheme in this embodiment of this application.

In actual application, because intermediate data of the online simulation occupies much of a memory and cannot be stored, when the fast loading model is trained offline, the steps of route planning, goods allocation, and scheme evaluation need to be performed again on the historical freight bill. During the offline simulation, first, the historical freight bill is obtained. The historical freight bill includes historical pickup point information and information about historical to-be-transported goods. Then, the route planning is performed based on the historical freight bill, to obtain a historical route scheme corresponding to the historical freight bill. Goods allocation is performed based on the historical route scheme, to obtain a historical goods allocation scheme set corresponding to each historical route scheme. An actual loading rate of each goods allocation scheme in a historical goods allocation scheme set corresponding to the final route scheme, and a loading manner are obtained through a three-dimensional loading operation. Based on the actual loading rate of each goods allocation scheme, integration and evaluation are performed on each of the at least one historical route scheme and each goods allocation scheme in the corresponding historical goods allocation scheme set, to obtain a historical transportation scheme.

Steps of hyperparameter initialization, route planning, goods allocation, and scheme evaluation that are included in the offline simulation are the same as steps of hyperparameter initialization, route planning, goods allocation, and scheme evaluation that are in the online simulation in FIG. 3. Details are not described herein again. The following describes a step of distinguishing the offline simulation from the online simulation.

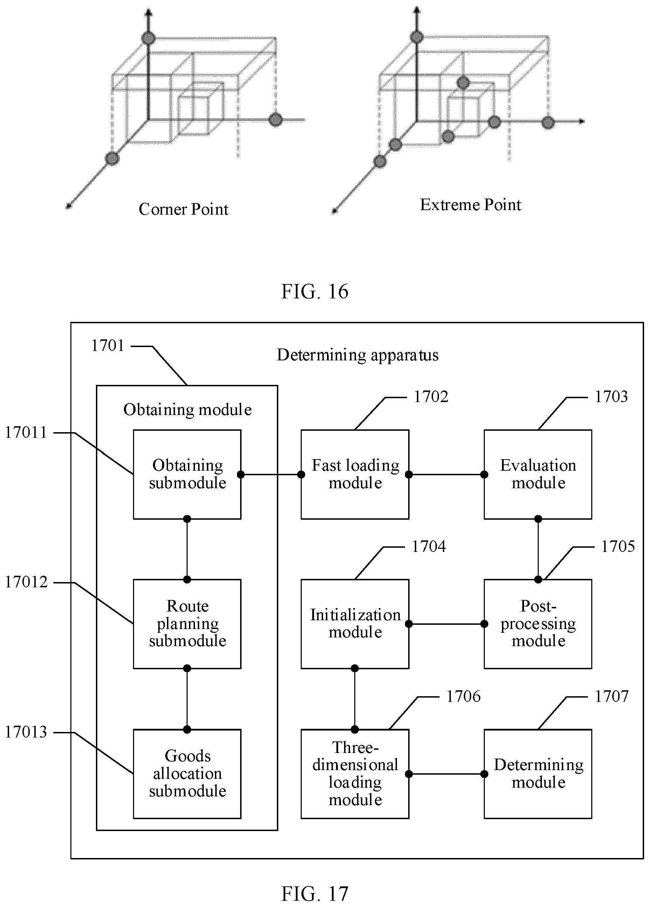

During the offline simulation, to obtain more accurate data, the three-dimensional loading algorithm may be used to calculate the actual loading rate, that is, to obtain a specific loading manner. When goods has been allocated, that is, after goods has been allocated to a container, a three-dimensional loading operation may be used to obtain a volume actual loading rate and a weight actual loading rate of the container, the volume actual loading rate and the weight actual loading rate may be used to evaluate a route scheme, and a step of evaluating the route scheme is similar to step 305 of scheme evaluation in FIG. 3. In this embodiment of this application, a heuristic algorithm based on Corner Point and Extreme Point may be used to complete loading simulation of goods. As shown in FIG. 16, before goods is loaded, a space status of a container is first determined, then, a series of candidate placement points are obtained, and then placement is tried one by one until a suitable placement point is found. Compared with the Corner Point algorithm, an aerial area of the goods is scanned by using the Extreme Point algorithm, and therefore more candidate points may be generated. In this way, a precise actual loading rate and loading scheme can be obtained, and container utilization can be improved.

However, three-dimensional loading is a sequential process, that is, the loading simulation of goods can only be performed in order, and a plurality of pieces of goods cannot be processed in parallel. Therefore, when there is a comparatively large amount of goods, more time needs to be consumed for loading simulation. Therefore, in this embodiment of this application, three-dimensional loading simulation is used during offline simulation and post-processing, so that efficiency of obtaining the goods loading scheme and outputting the actual loading rate can be improved. During the offline simulation, the three-dimensional loading algorithm is used to calculate the actual loading rate, so that a more accurate actual loading rate can be obtained. During the post-processing, the three-dimensional loading algorithm is used to obtain the loading scheme, so that a goods loading manner can be obtained during transportation, thereby improving transportation efficiency.

The foregoing describes in detail the method for determining a transportation route provided in the embodiments of this application, and the following describes apparatuses provided in the embodiments of this application. First, a determining apparatus is described. Referring to FIG. 17, the determining apparatus may include:

an obtaining module 1701, configured to obtain at least one route scheme and a first goods allocation scheme set corresponding to each of the at least one route scheme, where each of the at least one route scheme is a transportation route planned for transporting to-be-transported goods, the first goods allocation scheme set corresponding to each of the at least one route scheme includes at least one goods allocation scheme, and each goods allocation scheme in the first goods allocation scheme set corresponding to each of the at least one route scheme is a scheme for allocating the to-be-transported goods for the corresponding route scheme;

a fast loading module 1702, configured to determine, by using a fast loading model, an actual loading rate of each goods allocation scheme in the first goods allocation set corresponding to each of the at least one route scheme, where the fast loading model is obtained by training offline simulation data offline, the offline simulation data includes a historical loading scheme calculated by using a three-dimensional loading algorithm, and the actual loading rate is a proportion of goods loaded into a container in the container in a goods allocation scheme; and

an evaluation module 1703, configured to integrate and evaluate, based on the actual loading rate, each of the at least one route scheme and each goods allocation scheme in the first goods allocation scheme set corresponding to each of the at least one route scheme, to determine a target transportation scheme, where the target transportation scheme includes a target route scheme and a target goods allocation scheme corresponding to the target route scheme.

Optionally, in some possible implementations, the obtaining module 1701 may include:

an obtaining submodule 17011, configured to obtain a target freight bill, where the target freight bill includes transportation node information and to-be-transported goods information, the transportation node information includes a freight starting point, a freight ending point, and M pickup points, and the to-be-transported goods information includes information about to-be-transported goods distributed at the M pickup points, where M is a positive integer;

a route planning submodule 17012, configured to determine the at least one route scheme based on the transportation node information, where each of the at least one route scheme includes at least one transportation route, each of the at least one transportation route includes a freight starting point, a freight ending point, and N of the M pickup points, and each of the at least one route scheme covers the M pickup points, where N is a positive integer and N≤M; and a goods allocation submodule 17013, configured to allocate the to-be-transported goods for each transportation route in each of the at least one route scheme, to obtain each goods allocation scheme in the first goods allocation scheme set corresponding to each of the at least one route scheme.

Optionally, in some possible implementations, the route planning submodule 17012 is specifically configured to:

if an amount of historical route data is greater than a first threshold, initialize transfer hyperparameters of the M pickup points based on the historical route data, to obtain a hyperparameter matrix; determine a transfer probability distribution of the M pickup points based on the hyperparameter matrix, where the transfer probability distribution includes a transfer probability of a container in a transportation route between the freight starting point and the M pickup points, between the freight ending point and the M pickup points, or between the M pickup points; and determine each transportation route in each of the at least one route scheme based on the transfer probability distribution, to obtain the at least one route scheme.

Optionally, in some possible implementations, the determining apparatus may further include: an initialization module 1704, configured to: if the amount of historical route data is not greater than the first threshold, initialize the transfer hyperparameters of the M pickup points by using a heuristic algorithm, to obtain the hyperparameter matrix.

Optionally, in some possible implementations, the goods allocation submodule 17013 is specifically configured to:

cluster goods at each of the M pickup points based on a clustering condition, to obtain a clustering result, where the clustering condition includes a length, a width, a height, and a weight of the goods; perform sampling calculation on the clustering result by using a first goods allocation hyperparameter of each of the M pickup points, to obtain a first goods allocation manner set of each of the M pickup points, where the first goods allocation hyperparameter of each of the M pickup points is a hyperparameter for allocating the goods at each of the M pickup points, and each goods allocation manner in the first goods allocation manner set of each of the M pickup points is a manner of allocating goods distributed at a pickup point for a corresponding route scheme; and separately select a goods allocation manner from the first goods allocation manner set of each of the M pickup points, and combine the goods allocation manner with a route scheme, to obtain each goods allocation scheme in the first goods allocation scheme set corresponding to each of the at least one route scheme.

Optionally, in some possible implementations, the fast loading module 1702 is specifically configured to:

obtain a first feature vector of each goods allocation scheme in the first goods allocation scheme set corresponding to each of the at least one route scheme, where the first feature vector is used to indicate a feature value of to-be-transported goods in a goods allocation scheme; and input the first feature vector of each goods allocation scheme in the first goods allocation scheme corresponding to each of the at least one route scheme into the fast loading model, to obtain the actual loading rate of each goods allocation scheme in the first goods allocation scheme set corresponding to each of the at least one route scheme, where the actual loading rate includes a volume actual loading rate and a weight actual loading rate, the volume actual loading rate includes a proportion of a volume of goods allocated in each transportation route in a load volume of a container in each of the at least one route scheme, and the weight actual loading rate includes a proportion of a weight of goods allocated in each transportation route in a load weight of a container in each of the at least one route scheme.

Optionally, in some possible implementations, the fast loading module 1702 is specifically configured to:

obtain a second feature vector of each piece of the to-be-transported goods, where the second feature vector of each piece of the to-be-transported goods includes a length, a width, a height, and a weight of the corresponding goods; calculate, based on the second feature vector of each piece of the to-be-transported goods, a third feature vector of goods distributed at each of the M pickup points, for each goods allocation scheme in the first goods allocation scheme corresponding to each of the at least one route scheme, where the third feature vector of each goods allocation scheme in the first goods allocation scheme corresponding to each of the at least one route scheme includes an average value and a covariance of second feature vectors of all pieces of the to-be-transported goods; and

perform weighted combination on the third feature vector of each goods allocation scheme in the first goods allocation scheme corresponding to each of the at least one route scheme, to obtain the corresponding first feature vector in each goods allocation scheme in the first goods allocation scheme set corresponding to each of the at least one route scheme.

Optionally, in some possible implementations, where the evaluation module 1703 is specifically configured to:

calculate scores of all obtained goods allocation schemes by using a preset evaluation function and the actual loading rate;

if all the goods allocation schemes include one or more goods allocation schemes scored higher than a second threshold, determine the target goods allocation scheme in the one or more goods allocation schemes scored higher than the second threshold, and use a route scheme corresponding to the target goods allocation scheme as the target route scheme; and

determine the target transportation scheme based on the target goods allocation scheme and the target route scheme.

Optionally, in some possible implementations, the evaluation function includes:

$$f(\vec{R}, \vec{r_V}, \vec{r_W}) = \sum_{i=1}^{m} \alpha \, | \, r_{Vi} - \overline{r_V} - r_{Wi} + \overline{r_W} \, | - \beta(r_{Vi} + r_{Wi}) + \gamma Cost(R_i)$$

, where $R$ is a route scheme vector, $m$ is a quantity of containers, $\vec{r_V}$ is a volume actual loading rate vector of the $m$ containers, $\vec{r_W}$ is a weight actual loading rate vector of the $m$ containers; $\alpha$, $\beta$, and $\gamma$ are weight parameters, $r_{Vi}$ is a volume actual loading rate of an $i$th container, $r_{Wi}$ is a weight actual loading rate of an $i$th container, $\overline{r_V}$ is an average volume actual loading rate of the $m$ containers, and $\overline{r_W}$ is an average weight actual loading rate of the $m$ containers.

Optionally, in some possible implementations, the evaluation module 1703 is further configured to:

if all the goods allocation schemes do not include the goods allocation scheme scored higher than the second threshold, perform sampling calculation on the clustering result by using a second goods allocation hyperparameter of each of the M pickup points, to obtain a second goods allocation manner set of each of the M pickup points, where each goods allocation manner in the second goods allocation manner set of each of the M pickup points is a manner of allocating goods distributed at a pickup point for a corresponding route scheme, and the second goods allocation hyperparameter of each of the M pickup points is obtained by updating the first goods allocation hyperparameter of each of the M pickup points based on each goods allocation scheme in the first goods allocation scheme set corresponding to each of the at least one route scheme;

separately select a goods allocation manner from the second goods allocation manner set of each of the M pickup points, and combine the goods allocation manners, to obtain each goods allocation scheme in the second goods allocation scheme set corresponding to each of the at least one route scheme, where each goods allocation scheme in the second goods allocation scheme set corresponding to each of the at least one route scheme is a scheme of allocating the to-be-transported goods for a corresponding route scheme; and

calculate a score of each goods allocation scheme in the second goods allocation scheme set for each of the at least one route scheme by using the evaluation function and the actual loading rate of each goods allocation scheme in the second goods allocation scheme set for each of the at least one route scheme, where the actual loading rate of each goods allocation scheme in the second goods allocation scheme set for each of the at least one route scheme is obtained by using the fast loading model.

Optionally, in some possible implementations, the determining apparatus may further include:

a post-processing module 1705, configured to: after each of the at least one route scheme and the goods allocation scheme for each of the at least one route scheme are integrated and evaluated based on the actual loading rate to determine the target transportation scheme, determine a type of a container in each transportation route in the target route scheme based on the target goods allocation scheme and the target route scheme; and

a three-dimensional loading module 1706, configured to generate a loading scheme based on the type that is of the container in each transportation route in the target route scheme and that is determined by the post-processing module 1705, and the three-dimensional loading algorithm, where the loading scheme is a loading manner of the to-be-transported goods in the container in each transportation route in the target route scheme.

Optionally, in some possible implementations, the determining apparatus may further include:

a determining module 1707, configured to: before each of the at least one route scheme and each goods allocation scheme in the first goods allocation scheme set corresponding to each of the at least one route scheme are integrated and evaluated based on the actual loading rate to determine the target transportation scheme, if determining, based on the actual loading rate, that L of the M pickup points further include remaining goods not allocated to the container, determine a remaining goods route scheme and a remaining goods allocation scheme for the remaining goods, where L≤M, and L is a positive integer, where

the evaluation module 1703 is further configured to integrate and evaluate, based on the actual loading rate, each goods allocation scheme in the first goods allocation scheme set corresponding to each of the at least one route scheme, and the remaining goods route scheme and the remaining goods allocation scheme, to determine the target transportation scheme.

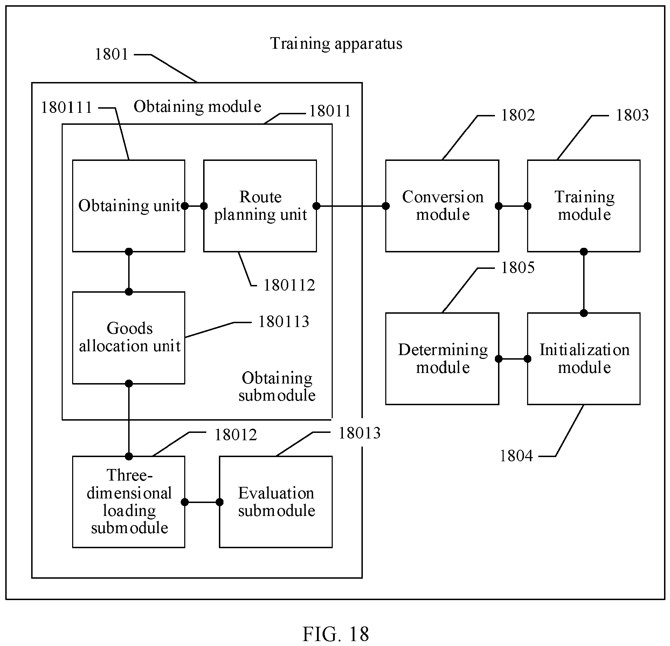

The following describes a training apparatus in the embodiments of this application. FIG. 18 is a schematic diagram of an embodiment of a training apparatus in the embodiments of this application, and the training apparatus may include:

an obtaining module 1801, configured to obtain offline simulation data, where the offline simulation data includes a historical loading scheme and a historical actual loading rate that are calculated through three-dimensional loading, where

the obtaining module 1801 is further configured to obtain a feature vector from the offline simulation data, where the feature vector includes a feature value of historical transportation goods corresponding to the historical loading scheme;

a conversion module 1802, configured to convert the feature vector into training data in a preset format; and

a training module 1803, configured to train a predictive model by using the training data, to obtain a fast loading model, where the fast loading model is used to output an actual loading rate of each goods allocation scheme in a goods allocation scheme set for each transportation route, and the actual loading rate is a proportion of goods loaded into a container in the container in each goods allocation scheme.

Optionally, in some possible implementations, the preset format is: (a feature vector, a historical actual loading rate).

Optionally, in some possible implementations, the predictive model includes: a linear regression model, a ridge regression model, an LASSO model, a support vector machine model, a random forest model, an XgBoost model, or an artificial neural network model.

Optionally, in some possible implementations, the obtaining module 1801 may include:

an obtaining submodule 18011, configured to obtain at least one historical route scheme and a first historical goods allocation scheme set corresponding to each of the at least one historical route scheme, where each of the at least one historical route scheme is a transportation route planned for transporting historical transportation goods, the first historical goods allocation scheme set corresponding to each of the at least one historical route scheme includes at least one goods allocation scheme, and each goods allocation scheme in the first historical goods allocation scheme set corresponding to each of the at least one historical route scheme is a scheme for allocating the historical transportation goods for the corresponding route scheme;

a three-dimensional loading submodule 18012, configured to determine, by using a three-dimensional loading algorithm, an actual loading rate of each goods allocation scheme in the first goods allocation set corresponding to each of the at least one historical route scheme, where the actual loading rate is a proportion of goods loaded into a container in the container in a goods allocation scheme; and

an evaluation submodule 18013, configured to integrate and evaluate, based on the actual loading rate, each of the at least one historical route scheme and each goods allocation scheme in the first historical goods allocation scheme set corresponding to each of the at least one historical route scheme, to determine a target transportation scheme, where the target transportation scheme includes a target route scheme and a target goods allocation scheme corresponding to the target route scheme.

In this embodiment of this application, the three-dimensional loading algorithm may be used for calculation during training of the fast loading model, to obtain a historical loading scheme corresponding to the historical route scheme, so that the actual loading rate of the goods allocation scheme corresponding to the historical route scheme can be accurately output.

Optionally, in some possible implementations, the obtaining submodule 18011 includes:

an obtaining unit 180111, configured to obtain a historical freight bill, where the historical freight bill includes transportation node information and information about the historical transportation goods, the transportation node information includes a freight starting point, a freight ending point, and M pickup points, and the information about the historical transportation goods includes information about the historical transportation goods distributed at the M pickup points, where M is a positive integer;

a route planning unit 180112, configured to determine the at least one historical route scheme based on the transportation node information, where each of the at least one historical route scheme includes at least one transportation route, each of the at least one transportation route includes a freight starting point, a freight ending point, and N of the M pickup points, and each of the at least one historical route scheme covers the M pickup points, where N is a positive integer and N≤M; and

a goods allocation unit 180113, configured to allocate the historical transportation goods for each transportation route in each of the at least one historical route scheme, to obtain each goods allocation scheme in the first historical goods allocation scheme set corresponding to each of the at least one historical route scheme.

Optionally, in some possible implementations, the route planning unit 180112 is specifically configured to:

if an amount of historical route data is greater than a first threshold, initialize transfer hyperparameters of the M pickup points based on the historical route data, to obtain a hyperparameter matrix;

determine a transfer probability distribution of the M pickup points based on the hyperparameter matrix, where the transfer probability distribution includes a transfer probability of a container in a transportation route between the freight starting point and the M pickup points, between the freight ending point and the M pickup points, or between the M pickup points; and

determine each transportation route in each of the at least one historical route scheme based on the transfer probability distribution, to obtain the at least one historical route scheme.

Optionally, in some possible implementations, the training apparatus further includes:

an initialization module 1804, configured to: if the amount of historical route data is not greater than the first threshold, initialize the transfer hyperparameters of the M pickup points by using a heuristic algorithm, to obtain the hyperparameter matrix.

Optionally, in some possible implementations, the goods allocation unit 180113 is specifically configured to:

cluster goods at each of the M pickup points based on a clustering condition, to obtain a clustering result, where the clustering condition includes a length, a width, a height, and a weight of the goods;

perform sampling calculation on the clustering result by using a first goods allocation hyperparameter of each of the M pickup points, to obtain a first goods allocation manner set of each of the M pickup points, where the first goods allocation hyperparameter of each of the M pickup points is a hyperparameter for allocating the goods at each of the M pickup points, and each goods allocation manner in the first goods allocation manner set of each of the M pickup points is a manner of allocating goods distributed at a pickup point for a corresponding route scheme; and

separately select a goods allocation manner from the first goods allocation manner set of each of the M pickup points, and combine the goods allocation manner with a route scheme, to obtain each goods allocation scheme in the first historical goods allocation scheme set corresponding to each of the at least one historical route scheme.

Optionally, in some possible implementations, the evaluation submodule 18013 is specifically configured to:

calculate scores of all obtained goods allocation schemes by using a preset evaluation function and the actual loading rate;

if all the goods allocation schemes include one or more goods allocation schemes scored higher than a second threshold, determine the target goods allocation scheme in the one or more goods allocation schemes scored higher than the second threshold, and use a route scheme corresponding to the target goods allocation scheme as the target route scheme; and

determine the target transportation scheme based on the target goods allocation scheme and the target route scheme.

Optionally, in some possible implementations, the evaluation function includes:

$$f(\vec{R},\vec{r_V},\vec{r_W}) = \sum_{i=1}^{m} \alpha \, | \, r_{Vi} - \overline{r_V} - r_{Wi} + \overline{r_W} \, | - \beta(r_{Vi} + r_{Wi}) + \gamma Cost(R_i)$$

, where $R$ is a route scheme vector, $m$ is a quantity of containers, $\vec{r_V}$ is a volume actual loading rate vector of the $m$ containers, $\vec{r_W}$ is a weight actual loading rate vector of the $m$ containers; $\alpha$, $\beta$, and $\gamma$ are weight parameters, $r_{Vi}$ is a volume actual loading rate of an $i^{th}$ container, $r_{Wi}$ is a weight actual loading rate of an $i^{th}$ container, $\overline{r_V}$ is an average volume actual loading rate of the $m$ containers, and $\overline{r_W}$ is an average weight actual loading rate of the $m$ containers.

Optionally, in some possible implementations, the evaluation submodule 18013 is further configured to:

if all the goods allocation schemes do not include the goods allocation scheme scored higher than the second threshold, perform sampling calculation on the clustering result by using a second goods allocation hyperparameter of each of the M pickup points, to obtain a second goods allocation manner set of each of the M pickup points, where each goods allocation manner in the second goods allocation manner set of each of the M pickup points is a manner of allocating goods distributed at a pickup point for a corresponding route scheme, and the second goods allocation hyperparameter of each of the M pickup points is obtained by updating the first goods allocation hyperparameter of each of the M pickup points based on each goods allocation scheme in the first historical goods allocation scheme set corresponding to each of the at least one historical route scheme;

separately select a goods allocation manner from the second goods allocation manner set of each of the M pickup points, and combine the goods allocation manners, to obtain each goods allocation scheme in the second historical goods allocation scheme set corresponding to each of the at least one historical route scheme, where each goods allocation scheme in the second historical goods allocation scheme set corresponding to each of the at least one historical route scheme is a scheme of allocating the historical transportation goods for a corresponding route scheme; and

calculate a score of each goods allocation scheme in the second historical goods allocation scheme set for each of the at least one historical route scheme by using the evaluation function and an actual loading rate of each goods allocation scheme in the second historical goods allocation scheme set for each of the at least one historical route scheme, where the actual loading rate of each goods allocation scheme in the second historical goods allocation scheme set for each of the at least one historical route scheme is obtained by using the three-dimensional loading submodel.

It should be understood that when allocation is repeatedly performed by using the goods allocation scheme, a route scheme may further be re-planned, or goods may be directly reallocated by using the at least one historical route scheme.

Optionally, in some possible implementations, the training apparatus further includes:

a determining module 1805, configured to: before each of the at least one historical route scheme and each goods allocation scheme in the first historical goods allocation scheme set corresponding to each of the at least one historical route scheme are integrated and evaluated based on the actual loading rate to determine the target transportation scheme, if determining, based on the actual loading rate, that L of the M pickup points further include remaining goods not allocated to the container, determine a remaining goods route scheme and a remaining goods allocation scheme for the remaining goods, where L≤M, and L is a positive integer, where

the evaluation submodule 18013 is further configured to integrate and evaluate, based on the actual loading rate, each goods allocation scheme in the first historical goods allocation scheme set corresponding to each of the at least one historical route scheme, and the remaining goods route scheme and the remaining goods allocation scheme, to determine the target transportation scheme.

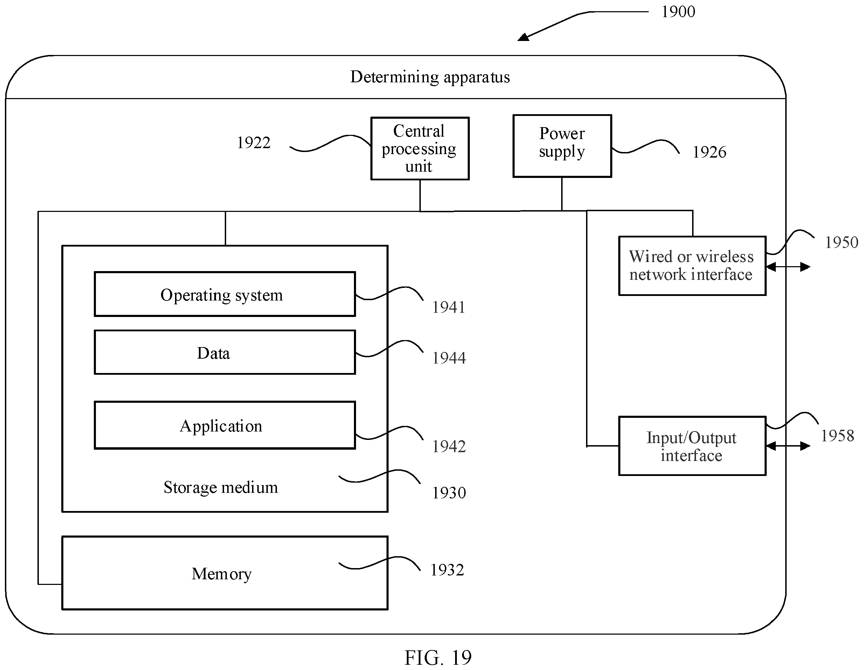

FIG. 19 is a schematic structural diagram of a determining apparatus according to an embodiment of this application. The determining apparatus 1900 may vary greatly due to different configurations or different performance, and may include one or more central processing units (CPU) 1922 (for example, one or more processors) and a memory 1932, one or more storage media 1930 (for example, one or more mass storage devices) storing applications 1942 or data 1944. The memory 1932 and the storage media 1930 may be used for temporary storage or persistent storage. The programs stored in the storage medium 1930 may include one or more modules (not shown), and each module may include a series of instruction operations in the determining apparatus. Further, the central processing unit 1922 may be set to communicate with the storage media 1930, and performs, on the determining apparatus 1900, the series of instruction operations in the storage medium 1930.

The determining apparatus 1900 may further include one or more power supplies 1926, one or more wired or wireless network interfaces 1950, one or more input/output interfaces 1958, and/or one or more operating systems 1941, for example, Windows Server™, Mac OS X™, Unix™, Linux™, and FreeBSD™.

The steps in the method for determining a transportation scheme in the embodiments of FIG. 2 to FIG. 16 may be performed based on the structure of the determining apparatus shown in FIG. 19.

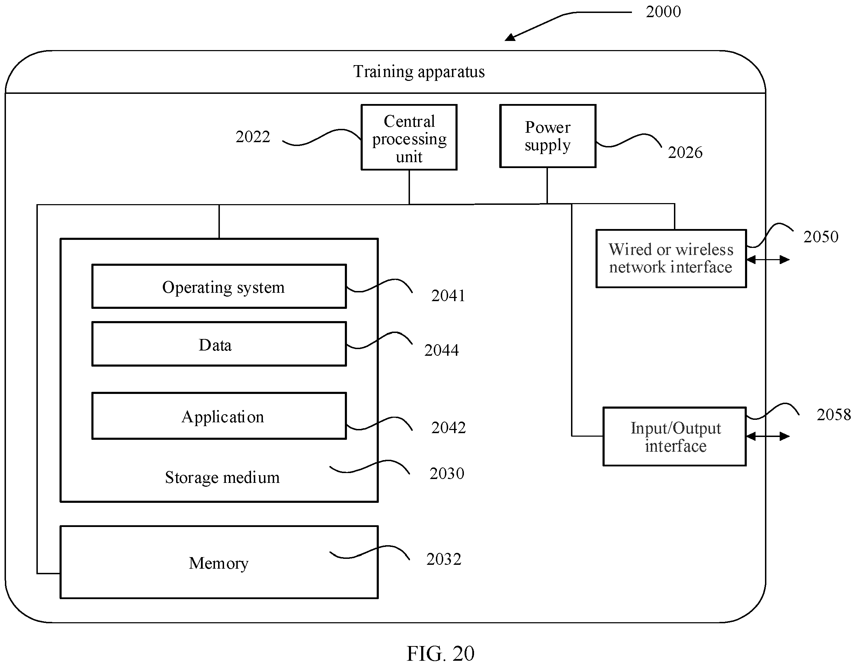

FIG. 20 is a schematic structural diagram of a training apparatus according to an embodiment of this application. The training apparatus 2000 may vary greatly due to different configurations or different performance, and may include one or more central processing units (CPU) 2022 (for example, one or more processors) and a memory 2032, one or more storage media 2030 (for example, one or more mass storage devices) storing applications 2042 or data 2044. The memory 2032 and the storage media 2030 may be used for temporary storage or persistent storage. The programs stored in the storage medium 2030 may include one or more modules (not shown), and each module may include a series of instruction operations in the training apparatus. Further, the central processing unit 2022 may be set to communicate with the storage media 2030, and performs, on the training apparatus 2000, the series of instruction operations in the storage medium 2030.

The training apparatus 2000 may further include one or more power supplies 2026, one or more wired or wireless network interfaces 2050, one or more input/output interfaces 2058, and/or one or more operating systems 2041, for example, Windows Server™, Mac OS X™, Unix™, Linux™, and FreeBSD™.

The offline training steps in the embodiments of FIG. 2 to FIG. 16 may be performed based on the structure of the training apparatus shown in FIG. 20.

It may be clearly understood by a person skilled in the art that for convenient and brief description, for a detailed working process of the described system, apparatus, and unit, refer to a corresponding process in the foregoing method embodiments, and details are not described herein again.

In the several embodiments provided in this application, it should be understood that the disclosed system, apparatus, and method may be implemented in another manner. For example, the described apparatus embodiments are merely examples. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electrical, mechanical, or another form.

The units described as separate components may or may not be physically separate, and components displayed as units may or may not be physical units. To be specific, the components may be located at one position, or may be distributed on a plurality of network units. Some or all of the units may be selected based on actual requirements to achieve the objectives of the solutions in the embodiments.

In addition, functional units in the embodiments of this application may be integrated into one processing unit, or each of the units may exist alone physically, or two or more units may be integrated into one unit. The integrated unit may be implemented in a form of hardware, or may be implemented in a form of a software function unit.

When the integrated unit is implemented in the form of a software function unit and sold or used as an independent product, the integrated unit may be stored in a computer-readable storage medium. Based on such an understanding, the technical solutions of this application essentially, or the part contributing to the prior art, or all or some of the technical solutions may be implemented in the form of a software product. The computer software product is stored in a storage medium and includes several instructions for instructing a computer device (which may be a personal computer, a server, a network device, or the like) to perform all or some of the steps of the methods of FIG. 2 to FIG. 16 described in the embodiments of this application. The foregoing storage medium includes: any medium that can store program code, such as a USB flash drive, a removable hard disk, a read-only memory (ROM), a random access memory (RAM), a magnetic disk, and an optical disc.

In conclusion, the foregoing embodiments are merely intended to describe the technical solutions of this application, but not to limit this application. Although this application is described in detail with reference to the foregoing embodiments, a person of ordinary skill in the art should understand that the person may still make modifications to the technical solutions described in the foregoing embodiments or make equivalent replacements to some technical features thereof, without causing the essence of the technical solutions to depart from the scope of the technical solutions of the embodiments of this application.

**Claims**

1. A computer-implemented method for determining a transportation scheme, comprising:

   obtaining (201, 202, 203) at least one route scheme and a first goods allocation scheme set corresponding to each of the at least one route scheme, wherein each of the at least one route scheme is a transportation route planned for transporting to-be-transported goods, the first goods allocation scheme set corresponding to each of the at least one route scheme comprises at least one goods allocation scheme, and each goods allocation scheme in the first goods allocation scheme set corresponding to each of the at least one route scheme is a scheme for allocating the to-be-transported goods for the corresponding route scheme;
   determining (204), by using a fast loading model, an actual loading rate of each goods allocation scheme in the first goods allocation scheme set corresponding to each of the at least one route scheme, wherein the fast loading model is obtained by training offline simulation data offline, the offline simulation data comprises a historical loading scheme calculated by using a three-dimensional loading algorithm, and the actual loading rate is a proportion of goods loaded into a container in the container in a goods allocation scheme; and integrating and evaluating (205), based on the actual loading rate, each of the at least one route scheme and each goods allocation scheme in the first goods allocation scheme set corresponding to each of the at least one route scheme, to determine a target transportation scheme, wherein the target transportation scheme comprises a target route scheme and a target goods allocation scheme corresponding to the target route scheme, wherein the obtaining at least one route scheme and a first goods allocation scheme set corresponding to each of the at least one route scheme comprises:

obtaining a target freight bill, wherein the target freight bill comprises transportation node information and to-be-transported goods information, the transportation node information comprises a freight starting point, a freight ending point, and M pickup points, and the to-be-transported goods information comprises information about to-be-transported goods distributed at the M pickup points, wherein M is a positive integer; determining the at least one route scheme based on the transportation node information, wherein each of the at least one route scheme comprises at least one transportation route, each of the at least one transportation route comprises a freight starting point, a freight ending point, and N of the M pickup points, and each of the at least one route scheme covers the M pickup points, wherein N is a positive integer and N≤M; and allocating the to-be-transported goods for each transportation route in each of the at least one route scheme, to obtain each goods allocation scheme in the first goods allocation scheme set corresponding to each of the at least one route scheme, wherein the determining the at least one route scheme based on the transportation node information comprises:

if an amount of historical route data is greater than a first threshold, initializing transfer hyperparameters of the M pickup points based on the historical route data, to obtain a hyperparameter matrix; determining a transfer probability distribution of the M pickup points based on the hyperparameter matrix, wherein the transfer probability distribution comprises a transfer probability of a container in a transportation route between the freight starting point and the M pickup points, between the freight ending point and the M pickup points, or between the M pickup points; and determining each transportation route in each of the at least one route scheme based on the transfer probability distribution, to obtain the at least one route scheme.

2. The computer-implemented method according to claim 1, wherein the method further comprises:
if the amount of historical route data is not greater than the first threshold, initializing the transfer hyperparameters of the M pickup points by using a heuristic algorithm, to obtain the hyperparameter matrix.

3. The computer-implemented method according to claim 1, wherein the allocating the to-be-transported goods for each transportation route in each of the at least one route scheme, to obtain each goods allocation scheme in the first goods allocation scheme set corresponding to each of the at least one route scheme comprises:

clustering goods at each of the M pickup points based on a clustering condition, to obtain a clustering result, wherein the clustering condition comprises a length, a width, a height, and a weight of the goods; performing sampling calculation on the clustering result by using a first goods allocation hyperparameter of each of the M pickup points, to obtain a first goods allocation manner set of each of the M pickup points, wherein the first goods allocation hyperparameter of each of the M pickup points is a hyperparameter for allocating the goods at each of the M pickup points, and each goods allocation manner in the first goods allocation manner set of each of the M pickup points is a manner of allocating goods distributed at a pickup point for a corresponding route scheme; and separately selecting a goods allocation manner from the first goods allocation manner set of each of the M pickup points, and combining the goods allocation manner with a route scheme, to obtain each goods allocation scheme in the first goods allocation scheme set corresponding to each of the at least one route scheme.

4. The computer-implemented method according to claim 1, wherein the determining, by using a fast loading model, an actual loading rate of each goods allocation scheme in the first goods allocation scheme set corresponding to each of the at least one route scheme comprises:

obtaining a first feature vector of each goods allocation scheme in the first goods allocation scheme set corresponding to each of the at least one route scheme, wherein the first feature vector is used to indicate a feature value of to-be-transported goods in a goods allocation scheme; and

inputting the first feature vector of each goods allocation scheme in the first goods allocation scheme set corresponding to each of the at least one route scheme into the fast loading model, to obtain the actual loading rate of each goods allocation scheme in the first goods allocation scheme set corresponding to each of the at least one route scheme, wherein the actual loading rate comprises a volume actual loading rate and a weight actual loading rate, the volume actual loading rate comprises a proportion of a volume of goods allocated in each transportation route in a load volume of a container in each of the at least one route scheme, and the weight actual loading rate comprises a proportion of a weight of goods allocated in each transportation route in a load weight of a container in each of the at least one route scheme.

5. The computer-implemented method according to claim 4, wherein the obtaining a first feature vector of each goods allocation scheme in the first goods allocation scheme set corresponding to each of the at least one route scheme comprises:

obtaining a second feature vector of each piece of the to-be-transported goods, wherein the second feature vector of each piece of the to-be-transported goods comprises a length, a width, a height, and a weight of the corresponding goods;

calculating, based on the second feature vector of each piece of the to-be-transported goods, a third feature vector of goods distributed at each of the M pickup points, for each goods allocation scheme in the first goods allocation scheme set corresponding to each of the at least one route scheme, wherein the third feature vector of each goods allocation scheme in the first goods allocation scheme set corresponding to each of the at least one route scheme comprises an average value and a covariance of second feature vectors of all pieces of the to-be-transported goods; and

performing weighted combination on the third feature vector of each goods allocation scheme in the first goods allocation scheme set corresponding to each of the at least one route scheme, to obtain the corresponding first feature vector in each goods allocation scheme in the first goods allocation scheme set corresponding to each of the at least one route scheme.

6. The computer-implemented method according to any one of claims 1 to 5, wherein the integrating and evaluating, based on the actual loading rate, each of the at least one route scheme and each goods allocation scheme in the first goods allocation scheme set corresponding to each of the at least one route scheme, to determine a target transportation scheme comprises:

calculating scores of all obtained goods allocation schemes by using a preset evaluation function and the actual loading rate;

if all the goods allocation schemes comprise one or more goods allocation schemes scored higher than a second threshold, determining the target goods allocation scheme in the one or more goods allocation schemes scored higher than the second threshold, and using a route scheme corresponding to the target goods allocation scheme as the target route scheme; and

determining the target transportation scheme based on the target goods allocation scheme and the target route scheme.

7. The computer-implemented method according to claim 6, wherein the method further comprises:

if all the goods allocation schemes do not comprise the goods allocation scheme scored higher than the second threshold, performing sampling calculation on the clustering result by using a second goods allocation hyperparameter of each of the M pickup points, to obtain a second goods allocation manner set of each of the M pickup points, wherein each goods allocation manner in the second goods allocation manner set of each of the M pickup points is a manner of allocating goods distributed at a pickup point for a corresponding route scheme, and the second goods allocation hyperparameter of each of the M pickup points is obtained by updating the first goods allocation hyperparameter of each of the M pickup points based on each goods allocation scheme in the first goods allocation scheme set corresponding to each of the at least one route scheme;

separately selecting a goods allocation manner from the second goods allocation manner set of each of the M pickup points, and combining the goods allocation manner with a route scheme, to obtain each goods allocation scheme in the second goods allocation scheme set corresponding to each of the at least one route scheme, wherein each goods allocation scheme in the second goods allocation scheme set corresponding to each of the at least one route scheme is a scheme of allocating the to-be-transported goods for a corresponding route scheme; and

calculating a score of each goods allocation scheme in the second goods allocation scheme set for each of the at least one route scheme by using the evaluation function and the actual loading rate of each goods allocation scheme in the second goods allocation scheme set for each of the at least one route scheme, wherein the actual loading rate of each goods allocation scheme in the second goods allocation scheme set for each of the at least one route scheme is obtained by using the fast loading model.

8. The computer-implemented method according to any one of claims 1 to 7, wherein before the integrating and evaluating, based on the actual loading rate, each of the at least one route scheme and each goods allocation scheme in the first goods allocation scheme set corresponding to each of the at least one route scheme, to determine a target transportation scheme, the method further comprises:

if determining, based on the actual loading rate, that L of the M pickup points further comprise remaining goods not allocated to the container, determining a remaining goods route scheme and a remaining goods allocation scheme for the remaining goods, wherein L≤M, and L is a positive integer; and
the integrating and evaluating, based on the actual loading rate, each of the at least one route scheme and each goods allocation scheme in the first goods allocation scheme set corresponding to each of the at least one route scheme, to determine a target transportation scheme comprises:
integrating and evaluating, based on the actual loading rate, each goods allocation scheme in the first goods allocation scheme set corresponding to each of the at least one route scheme, and the remaining goods route scheme and the remaining goods allocation scheme, to determine the target transportation scheme.

9. A transportation scheme determining apparatus, comprising:

an obtaining module (1701), configured to obtain at least one route scheme and a first goods allocation scheme set corresponding to each of the at least one route scheme, wherein each of the at least one route scheme is a transportation route planned for transporting to-be-transported goods, the first goods allocation scheme set corresponding to each of the at least one route scheme comprises at least one goods allocation scheme, and each goods allocation scheme in the first goods allocation scheme set corresponding to each of the at least one route scheme is a scheme for allocating the to-be-transported goods for the corresponding route scheme;
a fast loading module (1702), configured to determine, by using a fast loading model, an actual loading rate of each goods allocation scheme in the first goods allocation scheme set corresponding to each of the at least one route scheme, wherein the fast loading model is obtained by training offline simulation data offline, the offline simulation data comprises a historical loading scheme calculated by using a three-dimensional loading algorithm, and the actual loading rate is a proportion of goods loaded into a container in the container in a goods allocation scheme; and
an evaluation module (1703), configured to integrate and evaluate, based on the actual loading rate, each of the at least one route scheme and each goods allocation scheme in the first goods allocation scheme set corresponding to each of the at least one route scheme, to determine a target transportation scheme, wherein the target transportation scheme comprises a target route scheme and a target goods allocation scheme corresponding to the target route scheme,
wherein the obtaining module (1701) comprises:

an obtaining submodule (17011), configured to obtain a target freight bill, wherein the target freight bill comprises transportation node information and to-be-transported goods information, the transportation node information comprises a freight starting point, a freight ending point, and M pickup points, and the to-be-transported goods information comprises information about to-be-transported goods distributed at the M pickup points, wherein M is a positive integer;
a route planning submodule (17012), configured to determine the at least one route scheme based on the transportation node information, wherein each of the at least one route scheme comprises at least one transportation route, each of the at least one transportation route comprises a freight starting point, a freight ending point, and N of the M pickup points, and each of the at least one route scheme covers the M pickup points, wherein N is a positive integer and N≤M; and
a goods allocation submodule (17013), configured to allocate the to-be-transported goods for each transportation route in each of the at least one route scheme, to obtain each goods allocation scheme in the first goods allocation scheme set corresponding to each of the at least one route scheme,
wherein the route planning submodule (17012) is specifically configured to:

if an amount of historical route data is greater than a first threshold, initialize transfer hyperparameters of the M pickup points based on the historical route data, to obtain a hyperparameter matrix;

determine a transfer probability distribution of the M pickup points based on the hyperparameter matrix, wherein the transfer probability distribution comprises a transfer probability of a container in a transportation route between the freight starting point and the M pickup points, between the freight ending point and the M pickup points, or between the M pickup points; and

determine each transportation route in each of the at least one route scheme based on the transfer probability distribution, to obtain the at least one route scheme.

10. The transportation scheme determining apparatus according to claim 9, wherein the determining apparatus further comprises:

an initialization module (1704), configured to: if the amount of historical route data is not greater than the first threshold, initialize the transfer hyperparameters of the M pickup points by using a heuristic algorithm, to obtain the hyperparameter matrix.

11. The transportation scheme determining apparatus according to claim 9, wherein the goods allocation submodule (17013) is specifically configured to:

cluster goods at each of the M pickup points based on a clustering condition, to obtain a clustering result, wherein the clustering condition comprises a length, a width, a height, and a weight of the goods;

perform sampling calculation on the clustering result by using a first goods allocation hyperparameter of each of the M pickup points, to obtain a first goods allocation manner set of each of the M pickup points, wherein the first goods allocation hyperparameter of each of the M pickup points is a hyperparameter for allocating the goods at each of the M pickup points, and each goods allocation manner in the first goods allocation manner set of each of the M pickup points is a manner of allocating goods distributed at a pickup point for a corresponding route scheme; and

separately select a goods allocation manner from the first goods allocation manner set of each of the M pickup points, and combine the goods allocation manner with a route scheme, to obtain each goods allocation scheme in the first goods allocation scheme set corresponding to each of the at least one route scheme.

12. The transportation scheme determining apparatus according to claim 9, wherein the fast loading module (1702) is specifically configured to:

obtain a first feature vector of each goods allocation scheme in the first goods allocation scheme set corresponding to each of the at least one route scheme, wherein the first feature vector is used to indicate a feature value of to-be-transported goods in a goods allocation scheme; and

input the first feature vector of each goods allocation scheme in the first goods allocation scheme set corresponding to each of the at least one route scheme into the fast loading model, to obtain the actual loading rate of each goods allocation scheme in the first goods allocation scheme set corresponding to each of the at least one route scheme, wherein the actual loading rate comprises a volume actual loading rate and a weight actual loading rate, the volume actual loading rate comprises a proportion of a volume of goods allocated in each transportation route in a load volume of a container in each of the at least one route scheme, and the weight actual loading rate comprises a proportion of a weight of goods allocated in each transportation route in a load weight of a container in each of the at least one route scheme.

13. The transportation scheme determining apparatus according to claim 12, wherein the fast loading module (1702) is specifically configured to:

obtain a second feature vector of each piece of the to-be-transported goods, wherein the second feature vector of each piece of the to-be-transported goods comprises a length, a width, a height, and a weight of the corresponding goods;

calculate, based on the second feature vector of each piece of the to-be-transported goods, a third feature vector of goods distributed at each of the M pickup points, for each goods allocation scheme in the first goods allocation scheme set corresponding to each of the at least one route scheme, wherein the third feature vector of each goods allocation scheme in the first goods allocation scheme set corresponding to each of the at least one route scheme comprises an average value and a covariance of second feature vectors of all pieces of the to-be-transported goods; and

perform weighted combination on the third feature vector of each goods allocation scheme in the first goods allocation scheme set corresponding to each of the at least one route scheme, to obtain the corresponding first feature vector in each goods allocation scheme in the first goods allocation scheme set corresponding to each of the at least one route scheme.

**14.** The transportation scheme determining apparatus according to any one of claims 9 to 13, wherein the evaluation module (1703) is specifically configured to:

calculate scores of all obtained goods allocation schemes by using a preset evaluation function and the actual loading rate;

if all the goods allocation schemes comprise one or more goods allocation schemes scored higher than a second threshold, determine the target goods allocation scheme in the one or more goods allocation schemes scored higher than the second threshold, and use a route scheme corresponding to the target goods allocation scheme as the target route scheme; and

determine the target transportation scheme based on the target goods allocation scheme and the target route scheme.

**15.** The transportation scheme determining apparatus according to claim 14, wherein the evaluation module (1703) is further configured to:

if all the goods allocation schemes do not comprise the goods allocation scheme scored higher than the second threshold, perform sampling calculation on the clustering result by using a second goods allocation hyperparameter of each of the M pickup points, to obtain a second goods allocation manner set of each of the M pickup points, wherein each goods allocation manner in the second goods allocation manner set of each of the M pickup points is a manner of allocating goods distributed at a pickup point for a corresponding route scheme, and the second goods allocation hyperparameter of each of the M pickup points is obtained by updating the first goods allocation hyperparameter of each of the M pickup points based on each goods allocation scheme in the first goods allocation scheme set corresponding to each of the at least one route scheme;

separately select a goods allocation manner from the second goods allocation manner set of each of the M pickup points, and combine the goods allocation manners, to obtain each goods allocation scheme in the second goods allocation scheme set corresponding to each of the at least one route scheme, wherein each goods allocation scheme in the second goods allocation scheme set corresponding to each of the at least one route scheme is a scheme of allocating the to-be-transported goods for a corresponding route scheme; and

calculate a score of each goods allocation scheme in the second goods allocation scheme set for each of the at least one route scheme by using the evaluation function and the actual loading rate of each goods allocation scheme in the second goods allocation scheme set for each of the at least one route scheme, wherein the actual loading rate of each goods allocation scheme in the second goods allocation scheme set for each of the at least one route scheme is obtained by using the fast loading model.

**16.** The transportation scheme determining apparatus according to any one of claims 9 to 15, wherein the determining apparatus further comprises:

a determining module (1707), configured to: before each of the at least one route scheme and each goods allocation scheme in the first goods allocation scheme set corresponding to each of the at least one route scheme are integrated and evaluated based on the actual loading rate, to determine the target transportation scheme, if determining, based on the actual loading rate, that L of the M pickup points further comprise remaining goods not allocated to the container, determine a remaining goods route scheme and a remaining goods allocation scheme for the remaining goods, wherein L≤M, and L is a positive integer, wherein

the evaluation module (1703) is further configured to integrate and evaluate, based on the actual loading rate, each goods allocation scheme in the first goods allocation scheme set corresponding to each of the at least one route scheme, and the remaining goods route scheme and the remaining goods allocation scheme, to determine the target transportation scheme.

**Patentansprüche**

**1.** Computerimplementiertes Verfahren zum Bestimmen eines Transportschemas, umfassend:

Erlangen (201, 202, 203) von mindestens einem Routenschema und einem ersten Warenzuweisungsschemasatz, der jedem des mindestens einen Routenschemas entspricht, wobei jedes des mindestens einen Routenschemas eine Transportroute ist, die zum Transport von zu transportierenden Waren geplant ist, wobei der erste Warenzuweisungsschemasatz, der jedem des mindestens einen Routenschemas entspricht, mindestens ein Warenzuweisungsschema umfasst und jedes Warenzuweisungsschema in dem ersten Warenzuweisungsschemasatz, der jedem des mindestens einen Routenschemas entspricht, ein Schema zum Zuweisen der zu transportierenden Waren zu dem entsprechenden Routenschema ist;

Bestimmen (204), unter Verwendung eines Schnelllademodells, einer tatsächlichen Laderate jedes Warenzuweisungsschemas in dem ersten Warenzuweisungsschemasatz, der jedem des mindestens einen Routenschemas entspricht, wobei das Schnelllademodell durch ein Offline-Training von Offline-Simulationsdaten erlangt wird, wobei die Offline-Simulationsdaten ein historisches Ladeschema umfassen, das unter Verwendung eines dreidimensionalen Ladealgorithmus berechnet wurde, und die tatsächliche Laderate ein Anteil der in einen Container geladenen Waren ist, die in einem Warenzuweisungsschema in den Container geladen werden; und

Integrieren und Bewerten (205), basierend auf der tatsächlichen Laderate, jedes des mindestens einen Routenschemas und jedes Warenzuweisungsschemas in dem ersten Warenzuweisungsschemasatz, der jedem des mindestens einen Routenschemas entspricht, um ein Zieltransportschema zu bestimmen, wobei das Zieltransportschema ein Zielroutenschema und ein Zielwarenzuweisungsschema, das dem Zielroutenschema entspricht, umfasst,

wobei das Erlangen von mindestens einem Routenschema und einem ersten Warenzuweisungsschemasatz, der jedem des mindestens einen Routenschemas entspricht, Folgendes umfasst:

Erlangen eines Zielfrachtbriefs, wobei der Zielfrachtbrief Transportknoteninformationen und Informationen zu den zu transportierenden Waren umfasst, die Transportknoteninformationen einen Frachtausgangspunkt, einen Frachtendpunkt und M Abholpunkte umfassen und die Informationen zu den zu transportierenden Waren Informationen zu den zu transportierenden Waren umfassen, die an den M Abholpunkten verteilt werden, wobei M eine positive ganze Zahl ist;

Bestimmen des mindestens einen Routenschemas basierend auf den Transportknoteninformationen, wobei jedes des mindestens einen Routenschemas mindestens eine Transportroute umfasst, jede der mindestens einen Transportroute einen Frachtausgangspunkt, einen Frachtendpunkt und N der M Abholpunkte umfasst und jedes des mindestens einen Routenschemas die M Abholpunkte abdeckt, wobei N eine positive ganze Zahl ist und $N \leq M$ ist; und

Zuweisen der zu transportierenden Waren zu jeder Transportroute in jedem des mindestens einen Routenschemas, um jedes Warenzuweisungsschema in dem ersten Warenzuweisungsschemasatz, der jedem des mindestens einen Routenschemas entspricht, zu erlangen, wobei das Bestimmen des mindestens einen Routenschemas basierend auf den Transportknoteninformationen Folgendes umfasst:

wenn eine Menge historischer Routendaten größer als ein erster Schwellenwert ist, Initialisieren von Umladehyperparametern der M Abholpunkte basierend auf den historischen Routendaten, um eine Hyperparametermatrix zu erlangen;

Bestimmen einer Umladewahrscheinlichkeitsverteilung der M **Ab**holpunkte basierend auf der Hyperparametermatrix, wobei die Umladewahrscheinlichkeitsverteilung eine Umladewahrscheinlichkeit eines Containers auf einer Transportroute zwischen dem Frachtausgangspunkt und den M Abholpunkten, zwischen dem Frachtendpunkt und den M Abholpunkten oder zwischen den M Abholpunkten umfasst; und

Bestimmen jeder Transportroute in jedem des mindestens einen Routenschemas basierend auf der Umladewahrscheinlichkeitsverteilung, um das mindestens eine Routenschema zu erlangen.

2. Computerimplementiertes Verfahren nach Anspruch **1,** wobei das Verfahren ferner Folgendes umfasst:
wenn die Menge historischer Routendaten nicht größer als der erste Schwellenwert ist, Initialisieren der Umladehyperparameter der M Abholpunkte unter Verwendung eines heuristischen Algorithmus, um die Hyperparametermatrix zu erlangen.

3. Computerimplementiertes Verfahren nach Anspruch **1,** wobei das Zuweisen der zu transportierenden Waren zu jeder Transportroute in jedem des mindestens einen Routenschemas, um jedes Warenzuweisungsschema in dem ersten Warenzuweisungsschemasatz zu erlangen, der jedem des mindestens einen Routenschemas entspricht, Folgendes umfasst:

Gruppieren von Waren an jedem der M Abholpunkte basierend auf einer Gruppierungsbedingung, um ein Gruppierungsergebnis zu erlangen, wobei die Gruppierungsbedingung eine Länge, eine Breite, eine Höhe und ein Gewicht der Waren umfasst;

Durchführen einer Stichprobenberechnung für das Gruppierungsergebnis unter Verwendung eines ersten Warenzuweisungshyperparameters für jeden der M Abholpunkte, um einen ersten Satz Warenzuweisungsarten für jeden der M Abholpunkte zu erlangen, wobei der erste Warenzuweisungshyperparameter für jeden der M Abholpunkte ein Hyperparameter zum Zuweisen der Waren an jedem der M Abholpunkte ist und jede Warenzuweisungsart in dem ersten Satz Warenzuweisungsarten für jeden der M Abholpunkte eine Art zum Zuweisen von Waren ist, die an einem Abholpunkt für ein entsprechendes Routenschema verteilt werden; und

separates Auswählen einer Warenzuweisungsart aus dem ersten Satz Warenzuweisungsarten für jeden der M Abholpunkte und Kombinieren der Warenzuweisungsart mit einem Routenschema, um jedes Warenzuweisungsschema in dem ersten Warenzuweisungsschemasatz, der jedem des mindestens einen Routenschemas entspricht, zu erlangen.

4. Computerimplementiertes Verfahren nach Anspruch **1,** wobei das Bestimmen, unter Verwendung eines Schnelllademodells, einer tatsächlichen Laderate jedes Warenzuweisungsschemas in dem ersten Warenzuweisungsschemasatz, der jedem des mindestens einen Routenschemas entspricht, Folgendes umfasst:

Erlangen eines ersten Merkmalsvektors jedes Warenzuweisungsschemas in dem ersten Warenzuweisungsschemasatz, der jedem des mindestens einen Routenschemas entspricht, wobei der erste Merkmalsvektor verwendet wird, um einen Merkmalswert von zu transportierenden Waren in einem Warenzuweisungsschema anzuzeigen; und

Eingeben des ersten Merkmalsvektors jedes Warenzuweisungsschemas in dem ersten Warenzuweisungsschemasatz, der jedem des mindestens einen Routenschemas entspricht, in das Schnelllademodell, um die tatsächliche Laderate jedes Warenzuweisungsschemas in dem ersten Warenzuweisungsschemasatz, der jedem des mindestens einen Routenschemas entspricht, zu erlangen, wobei die tatsächliche Laderate eine tatsächliche Volumenladerate und eine tatsächliche Gewichtsladerate umfasst, die tatsächliche Volumenladerate einen Anteil eines Volumens von Waren umfasst, die jeder Transportroute in einem Ladevolumen eines Containers in jedem des mindestens einen Routenschemas zugewiesen werden, und die tatsächliche Gewichtsladerate einen Anteil eines Gewichts von Waren umfasst, die jeder Transportroute in einem Ladegewicht eines Containers in jedem des mindestens einen Routenschemas zugewiesen werden.

5. Computerimplementiertes Verfahren nach Anspruch **4,** wobei das Erlangen eines ersten Merkmalsvektors jedes Warenzuweisungsschemas in dem ersten Warenzuweisungsschemasatz, der jedem des mindestens einen Routenschemas entspricht, Folgendes umfasst:

Erlangen eines zweiten Merkmalsvektors jeder einzelnen zu transportierenden Ware, wobei der zweite Merkmalsvektor jeder einzelnen zu transportierenden Ware eine Länge, eine Breite, eine Höhe und ein Gewicht der entsprechenden Waren umfasst;

Berechnen, basierend auf dem zweiten Merkmalsvektor jeder einzelnen zu transportierenden Ware, eines dritten Merkmalsvektors von Waren, die an jedem der M Abholpunkte verteilt werden, für jedes Warenzuweisungsschema in dem ersten Warenzuweisungsschemasatz, der jedem des mindestens einen Routenschemas entspricht, wobei der dritte Merkmalsvektor jedes Warenzuweisungsschemas in dem ersten Warenzuweisungsschemasatz, der jedem des mindestens einen Routenschemas entspricht, einen Durchschnittswert und eine Kovarianz von zweiten Merkmalsvektoren aller einzelnen zu transportierenden Waren umfasst; und

Durchführen einer gewichteten Kombination für den dritten Merkmalsvektor jedes Warenzuweisungsschemas in dem ersten Warenzuweisungsschemasatz, der jedem des mindestens einen Routenschemas entspricht, um den entsprechenden ersten Merkmalsvektor in jedem Warenzuweisungsschema in dem ersten Warenzuweisungsschemasatz, der jedem des mindestens einen Routenschemas entspricht, zu erlangen.

6. Computerimplementiertes Verfahren nach einem der Ansprüche 1 bis 5, wobei das Integrieren und Bewerten, basierend auf der tatsächlichen Laderate, jedes des mindestens einen Routenschemas und jedes Warenzuweisungsschemas in dem ersten Warenzuweisungsschemasatz, der jedem des mindestens einen Routenschemas entspricht, um ein Zieltransportschema zu bestimmen, Folgendes umfasst:

Berechnen von Punktzahlen aller erlangten Warenzuweisungsschemata unter Verwendung einer voreingestellten Bewertungsfunktion und der tatsächlichen Laderate;

wenn alle Warenzuweisungsschemata ein oder mehrere Warenzuweisungsschemata umfassen, die eine Punktzahl haben, die höher als ein zweiter Schwellenwert ist, Bestimmen des Zielwarenzuweisungsschemas in dem einen oder den mehreren Warenzuweisungsschemata, die eine Punktzahl haben, die höher als ein zweiter Schwellenwert ist, und Verwenden eines Routenschemas, das dem Zielwarenzuweisungsschema entspricht, als Zielroutenschema; und

Bestimmen des Zieltransportschemas basierend auf dem Zielwarenzuweisungsschema und dem Zielroutenschema.

7. Computerimplementiertes Verfahren nach Anspruch **6,** wobei das Verfahren ferner Folgendes umfasst:

wenn alle Warenzuweisungsschemata kein Warenzuweisungsschema umfassen, das eine Punktzahl hat, die höher als der zweite Schwellenwert ist, Durchführen einer Stichprobenberechnung für das Gruppierungsergebnis unter Verwendung eines zweiten Warenzuweisungshyperparameters jedes der M Abholpunkte, um einen zweiten Satz Warenzuweisungsarten für jeden der M Abholpunkte zu erlangen, wobei jede Warenzuweisungsart in dem zweiten Satz Warenzuweisungsarten für jeden der M Abholpunkte eine Art zum Zuweisen von Waren, die an einem Abholpunkt für ein entsprechendes Routenschema verteilt werden, ist und der zweite Warenzuweisungshyperparameter für jeden der M Abholpunkte durch Aktualisieren des ersten Warenzuweisungshyperparameters für jeden der M Abholpunkte basierend auf jedem Warenzuweisungsschema in dem ersten Warenzuweisungsschemasatz, der jedem des mindestens einen Routenschemas entspricht, erlangt wird;

separates Auswählen einer Warenzuweisungsart aus dem zweiten Satz Warenzuweisungsarten jedes der M Abholpunkte und Kombinieren der Warenzuweisungsart mit einem Routenschema, um jedes Warenzuweisungsschema in dem zweiten Warenzuweisungsschemasatz, der jedem des mindestens einen Routenschemas entspricht, zu erlangen, wobei jedes Warenzuweisungsschema in dem zweiten Warenzuweisungsschemasatz, der jedem des mindestens einen Routenschemas entspricht, ein Schema zum Zuweisen der zu transportierenden Waren zu einem entsprechenden Routenschema ist; und

Berechnen einer Punktzahl jedes Warenzuweisungsschemas in dem zweiten Warenzuweisungsschemasatz für jedes des mindestens einen Routenschemas unter Verwendung der Bewertungsfunktion und der tatsächlichen Laderate jedes Warenzuweisungsschemas in dem zweiten Warenzuweisungsschemasatz für jedes des mindestens einen Routenschemas, wobei die tatsächliche Laderate jedes Warenzuweisungsschemas in dem zweiten Warenzuweisungsschemasatz für jedes des mindestens einen Routenschemas unter Verwendung des Schnelllademodells erlangt wird.

8. Computerimplementiertes Verfahren nach einem der Ansprüche 1 bis 7, wobei das Verfahren vor dem Integrieren und Bewerten, basierend auf der tatsächlichen Laderate, jedes des mindestens einen Routenschemas und jedes Warenzuweisungsschemas in dem ersten Warenzuweisungsschemasatz, der jedem des mindestens einen Routenschemas entspricht, um ein Zieltransportschema zu bestimmen, ferner Folgendes umfasst:

wenn bestimmt wird, basierend auf der tatsächlichen Laderate, dass L der M Abholpunkte ferner Restwaren umfassen, die nicht dem Container zugewiesen sind, Bestimmen eines Restwarenroutenschemas und eines Restwarenzuweisungsschemas für die Restwaren, wobei L≤M und L eine positive ganze Zahl ist; und

das Integrieren und Bewerten, basierend auf der tatsächlichen Laderate, jedes des mindestens einen Routenschemas und jedes Warenzuweisungsschemas in dem ersten Warenzuweisungsschemasatz, der jedem des mindestens einen Routenschemas entspricht, um ein Zieltransportschema zu bestimmen, Folgendes umfasst:
Integrieren und Bewerten, basierend auf der tatsächlichen Laderate, jedes Warenzuweisungsschemas in dem ersten Warenzuweisungsschemasatz, der jedem des mindestens einen Routenschemas entspricht, und des Restwarenroutenschemas und des Restwarenzuweisungsschemas, um das Zieltransportschema zu bestimmen.

9. Gerät zum Bestimmen eines Transportschemas, umfassend:

ein Erlangungsmodul (1701), das dazu konfiguriert ist, mindestens ein Routenschema und einen ersten Warenzuweisungsschemasatz, der jedem des mindestens einen Routenschemas entspricht, zu erlangen, wobei jedes des mindestens einen Routenschemas eine Transportroute ist, die zum Transport von zu transportierenden Waren geplant ist, wobei der erste Warenzuweisungsschemasatz, der jedem des mindestens einen Routenschemas entspricht, mindestens ein Warenzuweisungsschema umfasst und jedes Warenzuweisungsschema in dem ersten Warenzuweisungsschemasatz, der jedem des mindestens einen Routenschemas entspricht, ein Schema zum Zuweisen der zu transportierenden Waren zu dem entsprechenden Routenschema ist;

ein Schnelllademodul (1702), das dazu konfiguriert ist, unter Verwendung eines Schnelllademodells, eine tatsächliche Laderate jedes Warenzuweisungsschemas in dem ersten Warenzuweisungsschemasatz, der jedem des mindestens einen Routenschemas entspricht, zu bestimmen, wobei das Schnelllademodell durch ein Offline-Training von Offline-Simulationsdaten erlangt wird, wobei die Offline-Simulationsdaten ein historisches Ladeschema umfassen, das unter Verwendung eines dreidimensionalen Ladealgorithmus berechnet wurde, und die tatsächliche Laderate ein Anteil der in einen Container geladenen Waren ist, die in einem Warenzuweisungsschema in den Container geladen werden; und

ein Bewertungsmodul (1703), das dazu konfiguriert ist, basierend auf der tatsächlichen Laderate, jedes des mindestens einen Routenschemas und jedes Warenzuweisungsschema in dem ersten Warenzuweisungsschemasatz, der jedem des mindestens einen Routenschemas entspricht, zu integrieren und zu bewerten, um ein Zieltransportschema zu bestimmen, wobei das Zieltransportschema ein Zielroutenschema und ein Zielwarenzuweisungsschema, das dem Zielroutenschema entspricht, umfasst,

wobei das Erlangungsmodul (1701) Folgendes umfasst:

ein Erlangungsteilmodul (17011), das dazu konfiguriert ist, einen Zielfrachtbrief zu erlangen, wobei der Zielfrachtbrief Transportknoteninformationen und Informationen zu den zu transportierenden Waren umfasst, die Transportknoteninformationen einen Frachtausgangspunkt, einen Frachtendpunkt und M Abholpunkte umfassen und die Informationen zu den zu transportierenden Waren Informationen zu den zu transportierenden Waren umfassen, die an den M Abholpunkten verteilt werden, wobei M eine positive ganze Zahl ist;

ein Routenplanungsteilmodul (17012), das dazu konfiguriert ist, das mindestens eine Routenschema basierend auf den Transportknoteninformationen zu bestimmen, wobei jedes des mindestens einen Routenschemas mindestens eine Transportroute umfasst, jede der mindestens einen Transportroute einen Frachtausgangspunkt, einen Frachtendpunkt und N der M Abholpunkte umfasst und jedes des mindestens einen Routenschemas die M Abholpunkte abdeckt, wobei N eine positive ganze Zahl ist und $N \leq M$ ist; und

ein Warenzuweisungsteilmodul (17013), das dazu konfiguriert ist, die zu transportierenden Waren zu jeder Transportroute in jedem des mindestens einen Routenschemas zuzuweisen, um jedes Warenzuweisungsschema in dem ersten Warenzuweisungsschemasatz, der jedem des mindestens einen Routenschemas entspricht, zu erlangen,

wobei das Routenplanungsteilmodul (17012) insbesondere zu Folgendem konfiguriert ist:

wenn eine Menge historischer Routendaten größer als ein erster Schwellenwert ist, Initialisieren von Umladehyperparametern der M Abholpunkte basierend auf den historischen Routendaten, um eine Hyperparametermatrix zu erlangen;

Bestimmen einer Umladewahrscheinlichkeitsverteilung der M **Ab**holpunkte basierend auf der Hyperparametermatrix, wobei die Umladewahrscheinlichkeitsverteilung eine Umladewahrscheinlichkeit eines Containers auf einer Transportroute zwischen dem Frachtausgangspunkt und den M Abholpunkten, zwischen dem Frachtendpunkt und den M Abholpunkten oder zwischen den M Abholpunkten umfasst; und

Bestimmen jeder Transportroute in jedem des mindestens einen Routenschemas basierend auf der Umladewahrscheinlichkeitsverteilung, um das mindestens eine Routenschema zu erlangen.

10. Gerät zum Bestimmen eines Transportschemas nach Anspruch 9, wobei das Gerät zum Bestimmen ferner Folgendes umfasst:

ein Initialisierungsmodul (1704), das zu Folgendem konfiguriert ist: wenn die Menge historischer Routendaten nicht größer als der erste Schwellenwert ist, Initialisieren der Umladehyperparameter der M Abholpunkte unter Verwendung eines heuristischen Algorithmus, um die Hyperparametermatrix zu erlangen.

11. Gerät zum Bestimmen eines Transportschemas nach Anspruch 9, wobei das Warenzuweisungsteilmodul (17013) insbesondere zu Folgendem konfiguriert ist:

Gruppieren von Waren an jedem der M Abholpunkte basierend auf einer Gruppierungsbedingung, um ein Gruppierungsergebnis zu erlangen, wobei die Gruppierungsbedingung eine Länge, eine Breite, eine Höhe und ein Gewicht der Waren umfasst;

Durchführen einer Stichprobenberechnung für das Gruppierungsergebnis unter Verwendung eines ersten Warenzuweisungshyperparameters für jeden der M Abholpunkte, um einen ersten Satz Warenzuweisungsarten für jeden der M Abholpunkte zu erlangen, wobei der erste Warenzuweisungshyperparameter für jeden der M Abholpunkte ein Hyperparameter zum Zuweisen der Waren an jedem der M Abholpunkte ist und jede Warenzuweisungsart in dem ersten Satz Warenzuweisungsarten für jeden der M Abholpunkte eine Art zum Zuweisen von Waren ist, die an einem Abholpunkt für ein entsprechendes Routenschema verteilt werden; und

separates Auswählen einer Warenzuweisungsart aus dem ersten Satz Warenzuweisungsarten für jeden der M Abholpunkte und Kombinieren der Warenzuweisungsart mit einem Routenschema, um jedes Warenzuweisungsschema in dem ersten Warenzuweisungsschemasatz, der jedem des mindestens einen Routenschemas entspricht, zu erlangen.

12. Gerät zum Bestimmen eines Transportschemas nach Anspruch 9, wobei das Schnelllademodul (1702) insbesondere zu Folgendem konfiguriert ist:

Erlangen eines ersten Merkmalsvektors jedes Warenzuweisungsschemas in dem ersten Warenzuweisungsschemasatz, der jedem des mindestens einen Routenschemas entspricht, wobei der erste Merkmalsvektor verwendet wird, um einen Merkmalswert von zu transportierenden Waren in einem Warenzuweisungsschema anzuzeigen; und
Eingeben des ersten Merkmalsvektors jedes Warenzuweisungsschemas in dem ersten Warenzuweisungsschemasatz, der jedem des mindestens einen Routenschemas entspricht, in das Schnelllademodell, um die tatsächliche Laderate jedes Warenzuweisungsschemas in dem ersten Warenzuweisungsschemasatz, der jedem des mindestens einen Routenschemas entspricht, zu erlangen, wobei die tatsächliche Laderate eine tatsächliche Volumenladerate und eine tatsächliche Gewichtsladerate umfasst, die tatsächliche Volumenladerate einen Anteil eines Volumens von Waren umfasst, die jeder Transportroute in einem Ladevolumen eines Containers in jedem des mindestens einen Routenschemas zugewiesen werden, und die tatsächliche Gewichtsladerate einen Anteil eines Gewichts von Waren umfasst, die jeder Transportroute in einem Ladegewicht eines Containers in jedem des mindestens einen Routenschemas zugewiesen werden.

13. Gerät zum Bestimmen eines Transportschemas nach Anspruch 12, wobei das Schnelllademodul (1702) insbesondere zu Folgendem konfiguriert ist:

Erlangen eines zweiten Merkmalsvektors jeder einzelnen zu transportierenden Ware, wobei der zweite Merkmalsvektor jeder einzelnen zu transportierenden Ware eine Länge, eine Breite, eine Höhe und ein Gewicht der entsprechenden Waren umfasst;
Berechnen, basierend auf dem zweiten Merkmalsvektor jeder einzelnen zu transportierenden Ware, eines dritten Merkmalsvektors von Waren, die an jedem der M Abholpunkte verteilt werden, für jedes Warenzuweisungsschema in dem ersten Warenzuweisungsschemasatz, der jedem des mindestens einen Routenschemas entspricht, wobei der dritte Merkmalsvektor jedes Warenzuweisungsschemas in dem ersten Warenzuweisungsschemasatz, der jedem des mindestens einen Routenschemas entspricht, einen Durchschnittswert und eine Kovarianz von zweiten Merkmalsvektoren aller einzelnen zu transportierenden Waren umfasst; und
Durchführen einer gewichteten Kombination für den dritten Merkmalsvektor jedes Warenzuweisungsschemas in dem ersten Warenzuweisungsschemasatz, der jedem des mindestens einen Routenschemas entspricht, um den entsprechenden ersten Merkmalsvektor in jedem Warenzuweisungsschema in dem ersten Warenzuweisungsschemasatz, der jedem des mindestens einen Routenschemas entspricht, zu erlangen.

14. Gerät zum Bestimmen eines Transportschemas nach einem der Ansprüche 9 bis 13, wobei das Bewertungsmodul (1703) insbesondere zu Folgendem konfiguriert ist:

Berechnen von Punktzahlen aller erlangten Warenzuweisungsschemata unter Verwendung einer voreingestellten Bewertungsfunktion und der tatsächlichen Laderate;
wenn alle Warenzuweisungsschemata ein oder mehrere Warenzuweisungsschemata umfassen, die eine Punktzahl haben, die höher als ein zweiter Schwellenwert ist, Bestimmen des Zielwarenzuweisungsschemas in dem einen oder den mehreren Warenzuweisungsschemata, die eine Punktzahl haben, die höher als der zweite Schwellenwert ist, und Verwenden eines Routenschemas, das dem Zielwarenzuweisungsschema entspricht, als Zielroutenschema; und
Bestimmen des Zieltransportschemas basierend auf dem Zielwarenzuweisungsschema und dem Zielroutenschema.

15. Gerät zum Bestimmen eines Transportschemas nach Anspruch 14, wobei das Bewertungsmodul (1703) ferner zu Folgendem konfiguriert ist:

wenn alle Warenzuweisungsschemata kein Warenzuweisungsschema umfassen, das eine Punktzahl hat, die höher als der zweite Schwellenwert ist, Durchführen einer Stichprobenberechnung für das Gruppierungsergebnis unter Verwendung eines zweiten Warenzuweisungshyperparameters jedes der M Abholpunkte, um einen zweiten Satz Warenzuweisungsarten für jeden der M Abholpunkte zu erlangen, wobei jede Warenzuweisungsart in dem zweiten Satz Warenzuweisungsarten für jeden der M Abholpunkte eine Art zum Zuweisen von Waren, die an einem Abholpunkt für ein entsprechendes Routenschema verteilt werden, ist und der zweite Warenzuweisungshyperparameter für jeden der M Abholpunkte durch Aktualisieren des ersten Warenzuweisungshyperparameters für jeden der M Abholpunkte basierend auf jedem Warenzuweisungsschema in dem ersten Warenzuweisungsschemasatz, der jedem des mindestens einen Routenschemas entspricht, erlangt wird;

separates Auswählen einer Warenzuweisungsart aus dem zweiten Satz Warenzuweisungsarten jedes der M Abholpunkte und Kombinieren der Warenzuweisungsarten, um jedes Warenzuweisungsschema in dem zweiten Warenzuweisungsschemasatz, der jedem des mindestens einen Routenschemas entspricht, zu erlangen, wobei jedes Warenzuweisungsschema in dem zweiten Warenzuweisungsschemasatz, der jedem des mindestens einen Routenschemas entspricht, ein Schema zum Zuweisen der zu transportierenden Waren zu einem entsprechenden Routenschema ist; und

Berechnen einer Punktzahl jedes Warenzuweisungsschemas in dem zweiten Warenzuweisungsschemasatz für jedes des mindestens einen Routenschemas unter Verwendung der Bewertungsfunktion und der tatsächlichen Laderate jedes Warenzuweisungsschemas in dem zweiten Warenzuweisungsschemasatz für jedes des mindestens einen Routenschemas, wobei die tatsächliche Laderate jedes Warenzuweisungsschemas in dem zweiten Warenzuweisungsschemasatz für jedes des mindestens einen Routenschemas unter Verwendung des Schnelllademodells erlangt wird.

**16.** Gerät zum Bestimmen eines Transportschemas nach einem der Ansprüche 9 bis 15, wobei das Gerät zum Bestimmen ferner Folgendes umfasst:

ein Bestimmungsmodul (1707), das zu Folgendem konfiguriert ist: bevor jedes des mindestens einen Routenschemas und jedes Warenzuweisungsschema in dem ersten Warenzuweisungsschemasatz, der jedem des mindestens einen Routenschemas entspricht, basierend auf der tatsächlichen Laderate integriert und bewertet werden, um das Zieltransportschema zu bestimmen, wenn bestimmt wird, basierend auf der tatsächlichen Laderate, dass L der M Abholpunkte ferner Restwaren umfassen, die nicht dem Container zugewiesen sind, Bestimmen eines Restwarenroutenschemas und eines Restwarenzuweisungsschemas für die Restwaren, wobei L≤M und L eine positive ganze Zahl ist, wobei

das Bewertungsmodul (1703) ferner dazu konfiguriert ist, basierend auf der tatsächlichen Laderate jedes Warenzuweisungsschema in dem ersten Warenzuweisungsschemasatz, der jedem des mindestens einen Routenschemas entspricht, und das Restwarenroutenschema und das Restwarenzuweisungsschema zu integrieren und zu bewerten, um das Zieltransportschema zu bestimmen.

## Revendications

**1.** Procédé mis en œuvre par ordinateur de détermination d'un schéma de transport, comprenant :

l'obtention (201, 202, 203) d'au moins un schéma d'itinéraire et d'un premier ensemble de schémas d'attribution de marchandises correspondant à chacun de l'au moins un schéma d'itinéraire, dans lequel chacun de l'au moins un schéma d'itinéraire est un itinéraire de transport prévu pour transporter des marchandises à transporter, le premier ensemble de schémas d'attribution de marchandises correspondant à chacun de l'au moins un schéma d'itinéraire comprend au moins un schéma d'attribution de marchandises, et chaque schéma d'attribution de marchandises dans le premier ensemble de schémas d'attribution de marchandises correspondant à chacun de l'au moins un schéma d'itinéraire est un schéma d'attribution des marchandises à transporter pour le schéma d'itinéraire correspondant ;

la détermination (204), en utilisant un modèle de chargement rapide, d'un taux de chargement réel de chaque schéma d'attribution de marchandises dans le premier ensemble de schémas d'attribution de marchandises correspondant à chacun de l'au moins un schéma d'itinéraire, dans lequel le modèle de chargement rapide est obtenu en entraînant hors ligne des données de simulation hors ligne, les données de simulation hors ligne comprennent un schéma de chargement historique calculé en utilisant un algorithme de chargement tridimensionnel, et le taux de chargement réel est une proportion de marchandises chargées dans un conteneur dans le conteneur dans un schéma d'attribution de marchandises ; et

l'intégration et l'évaluation (205), sur la base du taux de chargement réel, de chacun de l'au moins un schéma d'itinéraire et de chaque schéma d'attribution de marchandises dans le premier ensemble de schémas d'attribution de marchandises correspondant à chacun de l'au moins un schéma d'itinéraire, pour déterminer un schéma de transport cible, dans lequel le schéma de transport cible comprend un schéma d'itinéraire cible et un schéma d'attribution de marchandises cible correspondant au schéma d'itinéraire cible,

dans lequel l'obtention d'au moins un schéma d'itinéraire et d'un premier ensemble de schémas d'attribution de marchandises correspondant à chacun de l'au moins un schéma d'itinéraire comprend :

l'obtention d'une facture de fret cible, dans lequel la facture de fret cible comprend des informations sur le nœud de transport et des informations sur les marchandises à transporter, les informations sur le nœud de transport comprennent un point de départ de fret, un point d'arrivée de fret et M points de ramassage, et les informations sur les marchandises à transporter comprennent des informations sur les marchandises à transporter distribuées aux M points de ramassage, dans lequel M est un entier positif ;

la détermination de l'au moins un schéma d'itinéraire sur la base des informations sur le nœud de transport, dans lequel chacun de l'au moins un schéma d'itinéraire comprend au moins un itinéraire de transport, chacun de l'au moins un schéma d'itinéraire comprend un point de départ de fret, un point d'arrivée de fret et N des M points de ramassage, et chacun de l'au moins un schéma d'itinéraire couvre les M points de ramassage, dans lequel N est un entier positif et N≤M ; et

l'attribution des marchandises à transporter à chaque itinéraire de transport dans chacun de l'au moins un schéma d'itinéraire, pour obtenir chaque schéma d'attribution de marchandises dans le premier ensemble de schémas d'attribution de marchandises correspondant à chacun de l'au moins un schéma d'itinéraire, dans lequel la détermination de l'au moins un schéma d'itinéraire sur la base des informations sur le nœud de transport comprend :

si une quantité de données d'itinéraire historiques est supérieure à un premier seuil, l'initialisation **d'hyperpara**mètres de transfert des M points de ramassage sur la base des données d'itinéraire historiques, pour obtenir une matrice **d'hy**perparamètres ;

la détermination d'une distribution de probabilité de transfert des M points de ramassage sur la base de la matrice d'hyperparamètres, dans lequel la distribution de probabilité de transfert comprend une probabilité de transfert d'un conteneur dans un itinéraire de transport entre le point de départ de fret et les M points de ramassage, entre le point d'arrivée de fret et les M points de ramassage, ou entre les M points de ramassage ; et

la détermination de chaque itinéraire de transport dans chacun de l'au moins un schéma d'itinéraire sur la base de la distribution de probabilité de transfert, pour obtenir l'au moins un schéma d'itinéraire.

2. Procédé mis en œuvre par ordinateur selon la revendication 1, dans lequel le procédé comprend également :
si la quantité de données d'itinéraire historiques n'est pas supérieure au premier seuil, l'initialisation des hyperparamètres de transfert des M points de ramassage en utilisant un algorithme heuristique, pour obtenir la matrice d'hyperparamètres.

3. Procédé mis en œuvre par ordinateur selon la revendication 1, dans lequel l'attribution des marchandises à transporter pour chaque itinéraire de transport dans chacun de l'au moins un schéma d'itinéraire, pour obtenir chaque schéma d'attribution de marchandises dans le premier ensemble de schémas d'attribution de marchandises correspondant à chacun de l'au moins un schéma d'itinéraire comprend :

le regroupement de marchandises à chacun des M points de ramassage sur la base d'une condition de regroupement, pour obtenir un résultat de regroupement, dans lequel la condition de regroupement comprend une longueur, une largeur, une hauteur et un poids des marchandises ;

la réalisation d'un calcul d'échantillonnage sur le résultat de regroupement en utilisant un premier hyperparamètre d'attribution de marchandises de chacun des M points de ramassage, pour obtenir un premier ensemble de modes d'attribution de marchandises de chacun des M points de ramassage, dans lequel le premier hyperparamètre d'attribution de marchandises de chacun des M points de ramassage est un hyperparamètre pour attribuer les marchandises à chacun des M points de ramassage, et chaque mode d'attribution de marchandises dans le premier ensemble de modes d'attribution de marchandises de chacun des M points de ramassage est un mode d'attribution de marchandises distribuées à un point de ramassage pour un schéma d'itinéraire correspondant ; et

la sélection séparément d'un mode d'attribution de marchandises à partir du premier ensemble de modes d'attribution de marchandises de chacun des M points de ramassage, et la combinaison du mode d'attribution de marchandises avec un schéma d'itinéraire, pour obtenir chaque schéma d'attribution de marchandises dans le premier ensemble de schémas d'attribution de marchandises correspondant à chacun de l'au moins un schéma d'itinéraire.

4. Procédé mis en œuvre par ordinateur selon la revendication 1, dans lequel la détermination, en utilisant un modèle de chargement rapide, d'un taux de chargement réel de chaque schéma d'attribution de marchandises dans le premier ensemble de schémas d'attribution de marchandises correspondant à chacun de l'au moins un schéma d'itinéraire comprend :

l'obtention d'un premier vecteur de caractéristiques de chaque schéma d'attribution de marchandises dans le premier ensemble de schémas d'attribution de marchandises correspondant à chacun de l'au moins un schéma d'itinéraire, dans lequel le premier vecteur de caractéristiques est utilisé pour indiquer une valeur de caractéristique des marchandises à transporter dans un schéma d'attribution de marchandises ; et

l'introduction du premier vecteur de caractéristiques de chaque schéma d'attribution de marchandises dans le premier ensemble de schémas d'attribution de marchandises correspondant à chacun de l'au moins un schéma d'itinéraire dans le modèle de chargement rapide, pour obtenir le taux de chargement réel de chaque schéma d'attribution de marchandises dans le premier ensemble de schémas d'attribution de marchandises correspondant à chacun de l'au moins un schéma d'itinéraire, dans lequel le taux de chargement réel comprend un taux de chargement réel en volume et un taux de chargement réel en poids, le taux de chargement réel en volume comprend une proportion d'un volume de marchandises allouées dans chaque itinéraire de transport dans un volume de chargement d'un conteneur dans chacun de l'au moins un schéma d'itinéraire, et le taux de chargement réel en poids comprend une proportion d'un poids de marchandises allouées dans chaque itinéraire de transport dans un poids de chargement d'un conteneur dans chacun de l'au moins un schéma d'itinéraire.

**5.** Procédé mis en œuvre par ordinateur selon la revendication 4, dans lequel l'obtention d'un premier vecteur de caractéristiques de chaque schéma d'attribution de marchandises dans le premier ensemble de schémas d'attribution de marchandises correspondant à chacun de l'au moins un schéma d'itinéraire comprend :

l'obtention d'un deuxième vecteur de caractéristiques de chaque élément des marchandises à transporter, dans lequel le deuxième vecteur de caractéristiques de chaque élément des marchandises à transporter comprend une longueur, une largeur, une hauteur et un poids des marchandises correspondantes ;

le calcul, sur la base du deuxième vecteur de caractéristiques de chaque élément des marchandises à transporter, d'un troisième vecteur de caractéristiques de marchandises distribuées à chacun des M points de ramassage, pour chaque schéma d'attribution de marchandises dans le premier ensemble de schémas d'attribution de marchandises correspondant à chacun de l'au moins un schéma d'itinéraire, dans lequel le troisième vecteur de caractéristiques de chaque schéma d'attribution de marchandises dans le premier ensemble de schémas d'attribution de marchandises correspondant à chacun de l'au moins un schéma d'itinéraire comprend une valeur moyenne et une covariance de deuxièmes vecteurs de caractéristiques de tous les éléments des marchandises à transporter ; et

la réalisation d'une combinaison pondérée sur le troisième vecteur de caractéristiques de chaque schéma d'attribution de marchandises dans le premier ensemble de schémas d'attribution de marchandises correspondant à chacun de l'au moins un schéma d'itinéraire, pour obtenir le premier vecteur de caractéristiques correspondant dans chaque schéma d'attribution de marchandises dans le premier ensemble de schémas d'attribution de marchandises correspondant à chacun de l'au moins un schéma d'itinéraire.

**6.** Procédé mis en œuvre par ordinateur selon l'une quelconque des revendications 1 à 5, dans lequel l'intégration et l'évaluation, sur la base du taux de chargement réel, de chacun de l'au moins un schéma d'itinéraire et de chaque schéma d'attribution de marchandises dans le premier ensemble de schémas d'attribution de marchandises correspondant à chacun de l'au moins un schéma d'itinéraire, pour déterminer un schéma de transport cible, comprend :

le calcul de scores de tous les schémas d'attribution de marchandises obtenus en utilisant une fonction d'évaluation prédé-finie et le taux de chargement réel ;

si tous les schémas d'attribution de marchandises comprennent un ou plusieurs schémas d'attribution de marchandises ayant obtenu un score supérieur à un second seuil, la détermination du schéma d'attribution de marchandises cible dans les un ou plusieurs schémas **d'attribution** de marchandises ayant obtenu un score supérieur au second seuil, et l'utilisation **d'un** schéma d'itinéraire correspondant au schéma d'attribution de marchandises cible comme schéma d'itinéraire cible ; et

la détermination du schéma de transport cible sur la base du schéma d'attribution de marchandises cible et du schéma d'itinéraire cible.

**7.** Procédé mis en œuvre par ordinateur selon la revendication **6,** dans lequel le procédé comprend également :

si tous les schémas d'attribution de marchandises ne comprennent pas le schéma d'attribution de marchandises ayant obtenu un score supérieur au second seuil, la réalisation d'un calcul d'échantillonnage sur le résultat de regroupement en utilisant un second hyperparamètre d'attribution de marchandises de chacun des M points de ramassage, pour obtenir un second ensemble de modes d'attribution de marchandises de chacun des M points de ramassage, dans lequel chaque mode d'attribution de marchandises dans le second ensemble de modes d'attribution de marchandises de chacun des M points de ramassage est un mode d'attribution de marchandises distribuées à un point de ramassage pour un schéma d'itinéraire correspondant, et le second hyperparamètre d'attribution de marchandises de chacun des M points de ramassage est obtenu en mettant à jour le premier hyperparamètre d'attribution de marchandises de chacun des M points de ramassage sur la base de chaque schéma d'attribution de marchandises dans le premier ensemble de schémas d'attribution de marchandises correspondant à chacun de l'au moins un schéma d'itinéraire ;

la sélection séparément d'un mode d'attribution de marchandises à partir du second ensemble de modes d'attribution de marchandises de chacun des M points de ramassage, et la combinaison du mode d'attribution de marchandises avec un schéma d'itinéraire, pour obtenir chaque schéma d'attribution de marchandises dans le second ensemble de schémas d'attribution de marchandises correspondant à chacun de l'au moins un schéma d'itinéraire, dans lequel chaque schéma d'attribution de marchandises dans le second ensemble de schémas d'attribution de marchandises correspondant à chacun de l'au moins un schéma d'itinéraire est un schéma d'attribution des marchandises à transporter pour un schéma d'itinéraire correspondant ; et

le calcul d'un score de chaque schéma d'attribution de marchandises dans le second ensemble de schémas d'attribution de marchandises pour chacun de l'au moins un schéma d'itinéraire en utilisant la fonction d'évaluation et le taux de chargement réel de chaque schéma d'attribution de marchandises dans le second ensemble de schémas d'attribution de marchandises pour chacun de l'au moins un schéma d'itinéraire, dans lequel le taux de chargement réel de chaque schéma d'attribution de marchandises dans le second ensemble de schémas d'attribution de marchandises pour chacun de l'au moins un schéma d'itinéraire est obtenu en utilisant le modèle de chargement rapide.

8. Procédé mis en œuvre par ordinateur selon l'une quelconque des revendications 1 à 7, dans lequel avant l'intégration et l'évaluation, sur la base du taux de chargement réel, de chacun de l'au moins un schéma d'itinéraire et de chaque schéma d'attribution de marchandises dans le premier ensemble de schémas d'attribution de marchandises correspondant à chacun de l'au moins un schéma d'itinéraire, pour déterminer un schéma de transport cible, le procédé comprend également :

s'il est déterminé, sur la base du taux de chargement réel, que L des M points de ramassage comprennent également des marchandises restantes non allouées au conteneur, la détermination d'un schéma d'itinéraire de marchandises restantes et d'un schéma d'attribution de marchandises restantes pour les marchandises restantes, dans lequel L≤M, et L est un entier positif ; et

l'intégration et l'évaluation, sur la base du taux de chargement réel, de chacun de l'au moins un schéma d'itinéraire et de chaque schéma d'attribution de marchandises dans le premier ensemble de schémas d'attribution de marchandises correspondant à chacun de l'au moins un schéma d'itinéraire, pour déterminer un schéma de transport cible comprend :

l'intégration et l'évaluation, sur la base du taux de chargement réel, de chaque schéma d'attribution de marchandises dans le premier ensemble de schémas d'attribution de marchandises correspondant à chacun de l'au moins un schéma d'itinéraire, et du schéma d'itinéraire de marchandises restantes et du schéma d'attribution de marchandises restantes, pour déterminer le schéma de transport cible.

9. Appareil de détermination d'un schéma de transport, comprenant :

un module d'obtention (1701), configuré pour obtenir au moins un schéma d'itinéraire et un premier ensemble de schémas d'attribution de marchandises correspondant à chacun de l'au moins un schéma d'itinéraire, dans lequel chacun de l'au moins un schéma d'itinéraire est un itinéraire de transport prévu pour transporter des marchandises à transporter, le premier ensemble de schémas d'attribution de marchandises correspondant à chacun de l'au moins un schéma d'itinéraire comprend au moins un schéma d'attribution de marchandises, et chaque schéma d'attribution de marchandises dans le premier ensemble de schémas d'attribution de marchandises correspondant à chacun de l'au moins un schéma d'itinéraire est un schéma d'attribution des marchandises à transporter pour le schéma d'itinéraire correspondant ;

un module de chargement rapide (1702), configuré pour déterminer, en utilisant un modèle de chargement rapide, un taux de chargement réel de chaque schéma d'attribution de marchandises dans le premier ensemble de schémas d'attribution de marchandises correspondant à chacun de l'au moins un schéma **d'itinéraire,** dans lequel le modèle de chargement rapide est obtenu en entraînant hors ligne des données de simulation hors ligne, les données de simulation hors ligne comprennent un schéma de chargement historique calculé en utilisant un algorithme de chargement tridimensionnel, et le taux de chargement réel est une proportion de marchandises chargées dans un conteneur dans le conteneur dans un schéma d'attribution de marchandises ; et

un module d'évaluation (1703), configuré pour intégrer et évaluer, sur la base du taux de chargement réel, chacun de l'au moins un schéma d'itinéraire et chaque schéma d'attribution de marchandises dans le premier ensemble de schémas d'attribution de marchandises correspondant à chacun de l'au moins un schéma d'itinéraire, pour déterminer un schéma de transport cible, dans lequel le schéma de transport cible comprend un schéma d'itinéraire cible et un schéma d'attribution de marchandises cible correspondant au schéma d'itinéraire cible, dans lequel le module d'obtention (1701) comprend :

un sous-module d'obtention (17011), configuré pour obtenir une facture de fret cible, dans lequel la facture de fret cible comprend des informations sur le nœud de transport et des informations sur les marchandises à transporter, les informations sur le nœud de transport comprennent un point de départ de fret, un point d'arrivée de fret et M points de ramassage, et les informations sur les marchandises à transporter comprennent des informations sur les marchandises à transporter distribuées aux M points de ramassage, dans lequel M est un entier positif ;

un sous-module de planification d'itinéraire (17012), configuré pour déterminer l'au moins un schéma d'itinéraire sur la base des informations sur le nœud de transport, dans lequel chacun de l'au moins un schéma d'itinéraire comprend au moins un itinéraire de transport, chacun de l'au moins un itinéraire de transport comprend un point de départ de fret, un point d'arrivée de fret et N des M points de ramassage, et chacun de l'au moins un schéma d'itinéraire couvre les M points de ramassage, dans lequel N est un entier positif et N≤M ; et

un sous-module d'attribution de marchandises (17013), configuré pour attribuer des marchandises à transporter pour chaque itinéraire de transport dans chacun de l'au moins un schéma d'itinéraire, pour obtenir chaque schéma d'attribution de marchandises dans le premier ensemble de schémas d'attribution de marchandises correspondant à chacun de l'au moins un schéma d'itinéraire,

dans lequel le sous-module de planification d'itinéraire (17012) est spécifiquement configuré pour :

si une quantité de données d'itinéraire historiques est supérieure à un premier seuil, initialiser des hyperparamètres de transfert des M points de ramassage sur la base des données d'itinéraire historiques, pour obtenir une matrice d'hyperparamètres ;

déterminer une distribution de probabilité de transfert des M points de ramassage sur la base de la matrice d'hyperparamètres, dans lequel la distribution de probabilité de transfert comprend une probabilité de transfert d'un conteneur dans un itinéraire de transport entre le point de départ de fret et les M points de ramassage, entre le point d'arrivée de fret et les M points de ramassage, ou entre les M points de ramassage ; et

déterminer chaque itinéraire de transport dans chacun de l'au moins un schéma d'itinéraire sur la base de la distribution de probabilité de transfert, pour obtenir l'au moins un schéma d'itinéraire.

10. Appareil de détermination de schéma de transport selon la revendication 9, dans lequel l'appareil de détermination comprend également :

un module d'initialisation (1704), configuré pour : si la quantité de données d'itinéraire historiques n'est pas supérieure au premier seuil, initialiser des hyperparamètres de transfert des M points de ramassage en utilisant un algorithme heuristique, pour obtenir la matrice d'hyperparamètres.

11. Appareil de détermination de schéma de transport selon la revendication 9, dans lequel le sous-module d'attribution de marchandises (17013) est spécifiquement configuré pour :

regrouper des marchandises à chacun des M points de ramassage sur la base d'une condition de regroupement, pour obtenir un résultat de regroupement, dans lequel la condition de regroupement comprend une longueur, une largeur, une hauteur et un poids des marchandises ;

réaliser un calcul d'échantillonnage sur le résultat de regroupement en utilisant un premier hyperparamètre d'attribution de marchandises de chacun des M points de ramassage, pour obtenir un premier ensemble de modes d'attribution de marchandises de chacun des M points de ramassage, dans lequel le premier hyperparamètre d'attribution de marchandises de chacun des M points de ramassage est un hyperparamètre pour attribuer les marchandises à chacun des M points de ramassage, et chaque mode d'attribution de marchandises dans le premier ensemble de modes d'attribution de marchandises de chacun des M points de ramassage est un mode d'attribution de marchandises distribuées à un point de ramassage pour un schéma d'itinéraire correspondant ; et

sélectionner séparément un mode d'attribution de marchandises à partir du premier ensemble de modes d'attribution de marchandises de chacun des M points de ramassage, et combiner le mode d'attribution de marchandises avec un schéma d'itinéraire, pour obtenir chaque schéma d'attribution de marchandises dans le premier ensemble de schémas d'attribution de marchandises correspondant à chacun de l'au moins un schéma d'itinéraire.

12. Appareil de détermination de schéma de transport selon la revendication **9,** dans lequel le module de chargement rapide (1702) est spécifiquement configuré pour :

obtenir un premier vecteur de caractéristiques de chaque schéma d'attribution de marchandises dans le premier ensemble de schémas d'attribution de marchandises correspondant à chacun de l'au moins un schéma d'itinéraire, dans lequel le premier vecteur de caractéristiques est utilisé pour indiquer une valeur de caractéristique des marchandises à transporter dans un schéma d'attribution de marchandises ; et

introduire le premier vecteur de caractéristiques de chaque schéma d'attribution de marchandises dans le premier ensemble de schémas d'attribution de marchandises correspondant à chacun de l'au moins un schéma d'itinéraire dans le modèle de chargement rapide, pour obtenir le taux de chargement réel de chaque schéma d'attribution de marchandises dans le premier ensemble de schémas d'attribution de marchandises correspondant à chacun de l'au moins un schéma d'itinéraire, dans lequel le taux de chargement réel comprend un taux de chargement réel en volume et un taux de chargement réel en poids, le taux de chargement réel en volume comprend une proportion d'un volume de marchandises allouées dans chaque itinéraire de transport dans un volume de chargement d'un conteneur dans chacun de l'au moins un schéma d'itinéraire, et le taux de chargement réel en poids comprend une proportion d'un poids de marchandises allouées dans chaque itinéraire de transport dans un poids de chargement d'un conteneur dans chacun de l'au moins un schéma d'itinéraire.

13. Appareil de détermination de schéma de transport selon la revendication 12, dans lequel le module de chargement rapide (1702) est spécifiquement configuré pour :

obtenir un deuxième vecteur de caractéristiques de chaque élément des marchandises à transporter, dans lequel le deuxième vecteur de caractéristiques de chaque élément des marchandises à transporter comprend une longueur, une largeur, une hauteur et un poids des marchandises correspondantes ;

calculer, sur la base du deuxième vecteur de caractéristiques de chaque élément des marchandises à transporter, un troisième vecteur de caractéristiques de marchandises distribuées à chacun des M points de ramassage, pour chaque schéma d'attribution de marchandises dans le premier ensemble de schémas d'attribution de marchandises correspondant à chacun de l'au moins un schéma d'itinéraire, dans lequel le troisième vecteur de caractéristiques de chaque schéma d'attribution de marchandises dans le premier ensemble de schémas d'attribution de marchandises correspondant à chacun de l'au moins un schéma d'itinéraire comprend une valeur moyenne et une covariance de deuxièmes vecteurs de caractéristiques de tous les éléments des marchandises à transporter ; et

réaliser une combinaison pondérée sur le troisième vecteur de caractéristiques de chaque schéma d'attribution de marchandises dans le premier ensemble de schémas d'attribution de marchandises correspondant à chacun de l'au moins un schéma d'itinéraire, pour obtenir le premier vecteur de caractéristiques correspondant dans chaque schéma d'attribution de marchandises dans le premier ensemble de schémas d'attribution de marchandises correspondant à chacun de l'au moins un schéma d'itinéraire.

14. Appareil de détermination de schéma de transport selon l'une quelconque des revendications 9 à 13, dans lequel le module d'évaluation (1703) est spécifiquement configuré pour :

calculer des scores de tous les schémas d'attribution de marchandises obtenus en utilisant une fonction d'évaluation prédéfinie et le taux de chargement réel ;

si tous les schémas d'attribution de marchandises comprennent un ou plusieurs schémas d'attribution de marchandises ayant obtenu un score supérieur à un second seuil, déterminer le schéma d'attribution de marchandises cible dans les un ou plusieurs schémas d'attribution de marchandises ayant obtenu un score supérieur au second seuil, et utiliser un schéma d'itinéraire correspondant au schéma d'attribution de marchandises cible comme schéma d'itinéraire cible ; et

déterminer le schéma de transport cible sur la base du schéma d'attribution de marchandises cible et du schéma d'itinéraire cible.

**15.** Appareil de détermination de schéma de transport selon la revendication 14, dans lequel le module d'évaluation (1703) est également configuré pour :

si tous les schémas d'attribution de marchandises ne comprennent pas le schéma d'attribution de marchandises ayant obtenu un score supérieur au second seuil, réaliser un calcul d'échantillonnage sur le résultat de regroupement en utilisant un second hyperparamètre d'attribution de marchandises de chacun des M points de ramassage, pour obtenir un second ensemble de modes d'attribution de marchandises de chacun des M points de ramassage, dans lequel chaque mode d'attribution de marchandises dans le second ensemble de modes d'attribution de marchandises de chacun des M points de ramassage est un mode d'attribution de marchandises distribuées à un point de ramassage pour un schéma d'itinéraire correspondant, et le second hyperparamètre d'attribution de marchandises de chacun des M points de ramassage est obtenu en mettant à jour le premier hyperparamètre d'attribution de marchandises de chacun des M points de ramassage sur la base de chaque schéma d'attribution de marchandises dans le premier ensemble de schémas d'attribution de marchandises correspondant à chacun de l'au moins un schéma d'itinéraire ;

sélectionner séparément un mode d'attribution de marchandises à partir du second ensemble de modes d'attribution de marchandises de chacun des M points de ramassage, et combiner les modes d'attribution de marchandises, pour obtenir chaque schéma d'attribution de marchandises dans le second ensemble de schémas d'attribution de marchandises correspondant à chacun de l'au moins un schéma d'itinéraire, dans lequel chaque schéma d'attribution de marchandises dans le second ensemble de schémas d'attribution de marchandises correspondant à chacun de l'au moins un schéma d'itinéraire est un schéma d'attribution des marchandises à transporter pour un schéma d'itinéraire correspondant ; et

calculer un score de chaque schéma d'attribution de marchandises dans le second ensemble de schémas d'attribution de marchandises pour chacun de l'au moins un schéma d'itinéraire en utilisant la fonction d'évaluation et le taux de chargement réel de chaque schéma d'attribution de marchandises dans le second ensemble de schémas d'attribution de marchandises pour chacun de l'au moins un schéma d'itinéraire, dans lequel le taux de chargement réel de chaque schéma d'attribution de marchandises dans le second ensemble de schémas d'attribution de marchandises pour chacun de l'au moins un schéma d'itinéraire est obtenu en utilisant le modèle de chargement rapide.

**16.** Appareil de détermination de schéma de transport selon l'une quelconque des revendications 9 à 15, dans lequel l'appareil de détermination comprend également :

un module de détermination (1707), configuré pour : avant que chacun de l'au moins un schéma d'itinéraire et chaque schéma d'attribution de marchandises dans le premier ensemble de schémas d'attribution de marchandises correspondant à chacun de l'au moins un schéma d'itinéraire soient intégrés et évalués sur la base du taux de chargement réel, pour déterminer le schéma de transport cible, s'il est déterminé, sur la base du taux de chargement réel, que L des M points de ramassage comprennent également des marchandises restantes non allouées au conteneur, déterminer un schéma d'itinéraire de marchandises restantes et un schéma d'attribution de marchandises restantes pour les marchandises restantes, dans lequel L≤M, et L est un entier positif, dans lequel

le module d'évaluation (1703) est également configuré pour intégrer et évaluer, sur la base du taux de chargement réel, chaque schéma d'attribution de marchandises dans le premier ensemble de schémas d'attribution de marchandises correspondant à chacun de l'au moins un schéma d'itinéraire, et le schéma d'itinéraire de marchandises restantes et le schéma d'attribution de marchandises restantes, pour déterminer le schéma de transport cible.

FIG. 1

Obtain a target freight bill — 201

Plan a transportation route based on a transportation node, to obtain a route scheme set — 202

Perform goods allocation based on the route scheme set, to obtain a goods allocation scheme set for each route scheme in the route scheme set — 203

Determine an actual loading rate of each goods allocation scheme by using a fast loading model — 204

Integrate and evaluate, based on the actual loading rate, each route scheme and the goods allocation scheme corresponding to each route scheme, to determine a target transportation scheme — 205

FIG. 2

Hyperparameter initialization — 302

Target freight bill — 301

Simulation result — 309

Route planning — 303

Exploration of a route scheme

Goods allocation — 304

Exploration of a goods allocation scheme

Scheme evaluation — 305

Fast loading — 306

Offline training

Offline simulation — 307

Offline simulation data — 308

FIG. 3

```
                          ┌──────────┐
                          │   Port   │
                          │   Port   │
                          └──────────┘
```

$\theta_1$        $\theta_2$

$\theta_{K-1}$

$\theta_K$

| Pickup point $D_1$ | Pickup point $D_2$ | ... | $D_{K-1}$ | Pickup point $D_k$ |

FIG. 4

Historical route data

Port→$D_1$→$D_2$→$D_6$→Port

Port→$D_3$→$D_4$→$D_9$→Port

Valid transfer mode in which the port is used as a current starting point
(Port→$D_1$)
(Port→$D_4$)

Port→$D_4$→$D_1$→$D_5$→Port

Port→$D_5$→$D_1$→$D_6$→Port

FIG. 5

| S=3 | | Sequenced historical route data |
|---|---|---|

| $r_1$ $r_2$ $r_3$ | $r_4$ $r_5$ $r_6$ | $r_7$ $r_8$ $r_9$ $r_{10}$ |
|---|---|---|

FIG. 6

FIG. 7

Hyperparameter matrix

| | A | B | C | Port |
|------|-----|-----|-----|------|
| A | | 0.6 | 1.8 | |
| B | 0.4 | | 1.6 | 2.0 |
| C | 1.2 | 2.4 | | 0.4 |
| Port | 0.9 | 0.6 | 1.5 | |

Bayesian estimation or heuristic algorithm

Take an expected value

Transfer probability matrix

| | A | B | C | Port |
|------|-----|-----|-----|------|
| A | | 0.2 | 0.6 | 0.2 |
| B | 0.1 | | 0.4 | 0.5 |
| C | 0.3 | 0.6 | | 0.1 |
| Port | 0.3 | 0.2 | 0.5 | |

Sampling

Group

Window 1

$r_1$: Port→A→B→Port

$r_2$: Port→A→C→Port

$r_3$: Port→A→B→Port

⋮   ⋮   ⋮

Scheme n

FIG. 8

EP 3 739 530 B1

Position transfer matrix

|      | A   | B   | C   | Port |
|------|-----|-----|-----|------|
| A    |     | 0.2 | 0.6 | 0.2  |
| B    | 0.1 |     | 0.4 | 0.5  |
| C    | 0.3 | 0.6 |     | 0.1  |
| Port | 0.3 | 0.2 | 0.5 |      |

Step 1:  Port — Select a next jump object ⇒ Sampling  $x$ → 0.23 — <0.3 → A

Step 2:  Port → A — Select a next jump object ⇒ Sampling  $x$ → 0.52 — 0.2<x<0.8 → C

Step 3:  Port → A → C — Select a next jump object ⇒ Sampling  $x$ → 0.94 — 0.9<x<1 → Port

Obtain a complete route

Port → A → C → Port

FIG. 9

EP 3 739 530 B1

Hyperparameter matrix

| | A | B | C | Port |
|---|---|---|---|---|
| A | | 0.6 | 1.8 | 0.6 |
| B | 0.4 | | 1.6 | 2.0 |
| C | 1.2 | 2.4 | | 0.4 |
| Port | 0.9 | 0.6 | 1.5 | |

New hyperparameter matrix

| | A | B | C | Port |
|---|---|---|---|---|
| A | | 1.6 | 2.8 | 0.6 |
| B | 0.4 | | 1.6 | 4.0 |
| C | 1.2 | 3.4 | | 1.4 |
| Port | 2.9 | 0.2 | 2.5 | |

Add a quantity of occurrence
times of a mode to

Scheme 1

$r_1$: Port→A→B→Port

$r_2$: Port→A→C→Port

$r_3$: Port→A→B→Port

FIG. 10

EP 3 739 530 B1

Scheme 1
$r_1$: Port→A→B→Port
$r_2$: Port→A→C→Port
$r_3$: Port→A→B→Port

Evaluation

Score

Pickup point A

Goods category 1 ~$\theta_{A1}$
Goods category 2 ~$\theta_{A1}$
Goods category $m_A$ ~$\theta_{AmA}$

Sampling

Learning

Goods allocation scheme 1
1    1    1    2    3
2    2    2    1    3

Goods allocation scheme n

Pickup point B

Goods category 1 ~$\theta_{B1}$
Goods category 2 ~$\theta_{B1}$
Goods category $m_B$ ~$\theta_{BmB}$

Sampling

Learning

Goods allocation scheme 1

Goods allocation scheme n

Pickup point C

Goods category 1 ~$\theta_{C1}$
Goods category 2 ~$\theta_{C1}$
Goods category $m_C$ ~$\theta_{CmC}$

Sampling

Learning

Goods allocation scheme 1

Goods allocation scheme n

Collaborative evaluation

Evaluation function

FIG. 11

Original pickup point hyperparameter matrix

|  | Car 1 | Car 2 |
|---|---|---|
| A (Category 1) | 1.0 | 1.0 |
| A (Category 2) | 1.0 | 1.0 |
| A (Category 3) | 1.0 | 1.0 |

Target pickup point hyperparameter matrix

|  | Car 1 | Car 2 |
|---|---|---|
| A (Category 1) | 3.0 | 2.0 |
| A (Category 2) | 2.0 | 3.0 |
| A (Category 3) | 2.0 | 2.0 |

Goods allocation scheme 1

FIG. 12

EP 3 739 530 B1

Volume actual loading
rate: 75%
Weight actual loading
rate: 85%

Volume actual loading
rate: 80%
Weight actual loading
rate: 75%

Volume actual loading
rate: 35%
Weight actual loading
rate: 95%

Volume actual loading
rate: 95%
Weight actual loading
rate: 35%

FIG. 13

FIG. 14

FIG. 15

EP 3 739 530 B1

Corner Point          Extreme Point

FIG. 16

FIG. 17

FIG. 18

EP 3 739 530 B1

1900

Determining apparatus

1922 — Central processing unit

Power supply — 1926

1950

Wired or wireless network interface

Operating system — 1941

Data — 1944

Application — 1942

Storage medium — 1930

Input/Output interface — 1958

Memory — 1932

FIG. 19

Training apparatus

2022     Central processing unit

Power supply     2026

Wired or wireless network interface     2050

Operating system     2041

Data     2044

Application     2042

Storage medium     2030

Input/Output interface     2058

Memory     2032

FIG. 20

EP 3 739 530 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2014180954 A1